# EUROPÄISCHE PATENTSCHRIFT

(11) **EP 4 222 155 B1**
(45) Veröffentlichungstag und Bekanntmachung des Hinweises auf die Patenterteilung: **11.06.2025**
(21) Anmeldenummer: 21782984.5
(22) Anmeldetag: 27.09.2021
(51) Int. Cl.: C07F 15/00, C09K 11/06, H10K 85/00, H10K 50/11

(54) **MONONUKLEARE TRIPODALE HEXADENTATE IRIDIUM KOMPLEXE ZUR VERWENDUNG IN OLEDS**
MONONUCLEAR TRIPODAL HEXADENTATE IRIDIUM COMPLEXES FOR USE IN OLEDS
COMPLEXES D'IRIDIUM HEXADENTÉS TRIPODES MONONUCLÉAIRES DESTINÉS À ÊTRE UTILISÉS DANS DES DELO

(30) Priorität: 29.09.2020 EP 20198952
(43) Veröffentlichungstag der Anmeldung: 09.08.2023
(73) Patentinhaber: UDC Ireland Limited, Ballycoolin, Dublin 15 (IE)
(72) Erfinder: STOESSEL, Philipp, 64293 DARMSTADT (DE); MAY, Falk, 64293 DARMSTADT (DE); AUCH, Armin, 64293 DARMSTADT (DE)
(74) Vertreter: Maiwald GmbH
(86) Internationale Anmeldenummer: PCT/EP2021/076429
(87) Internationale Veröffentlichungsnummer: WO 2022/069380

(56) Entgegenhaltungen:
- EP-A1- 3 341 385
- EP-A1- 3 752 512
- RYU H ET AL: "Photo- and electroluminescent properties of cyano-substituted styryl derivatives and synthesis of CN-PPV model compounds containing an alkoxy spacer for OLEDs", TETRAHEDRON, ELSEVIER SIENCE PUBLISHERS, AMSTERDAM, NL, vol. 62, no. 26, 26 June 2006 (2006-06-26), pages 6236 - 6247, XP025002139, ISSN: 0040-4020, [retrieved on 20060626], DOI: 10.1016/J.TET.2006.04.051

## Beschreibung

Die vorliegende Erfindung betrifft Iridiumkomplexe, welche sich für den Einsatz in organischen Elektrolumineszenzvorrichtungen, insbesondere als Emitter, eignen.

Gemäß dem Stand der Technik werden in phosphoreszierenden organischen Elektrolumineszenzvorrichtungen (OLEDs) als Triplettemitter vor allem bis- und tris-ortho-metallierte Irdiumkomplexe mit aromatischen Liganden eingesetzt, wobei die Liganden über ein negativ geladenes Kohlenstoffatom und ein neutrales Stickstoffatom. Beispiele für solche Komplexe sind Tris(phenylpyridyl)iridium(III) und Derivate davon. Derartige Komplexe sind auch mit polypodalen Liganden bekannt, wie beispielsweise in US 7,332,232, WO 2016/124304 und WO 2019/158453 beschrieben. Auch wenn diese Komplexe mit polypodalen Liganden Vorteile gegenüber den Komplexen zeigen, die ansonsten die gleiche Ligandenstruktur aufweisen, deren einzelne Liganden nicht polypodal verbrückt sind, gibt es auch noch Verbesserungsbedarf, beispielsweise im Hinblick auf Effizienz, Spannung und Lebensdauer.

Aufgabe der vorliegenden Erfindung ist daher die Bereitstellung verbesserter Iridiumkomplexe, welche sich als Emitter für die Verwendung in OLEDs eignen.

Überraschend wurde gefunden, dass Iridiumkomplexe mit einem hexadentaten tripodalen Liganden, der die nachfolgend beschriebene Struktur aufweist, diese Aufgabe lösen und sich sehr gut für die Verwendung in einer organischen Elektrolumineszenzvorrichtung eignen. Diese Iridiumkomplexe und organische Elektrolumineszenzvorrichtungen, welche diese Komplexe enthalten, sind daher der Gegenstand der vorliegenden Erfindung.

Gegenstand der Erfindung ist somit eine Verbindung der Formel (1),

Ir(L) Formel (1)
wobei der Ligand L eine Struktur der folgenden Formel (2) aufweist: 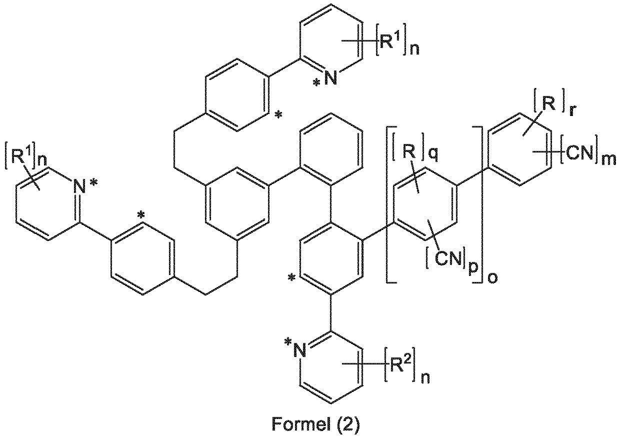
wobei der Ligand L über die mit * gekennzeichneten Positionen an das Iridiumatom koordiniert und wobei die nicht explizit eingezeichneten H-Atome auch durch D ersetzt sein können und wobei für die verwendeten Symbole und Indizes gilt:
   - R: ist gleich oder verschieden bei jedem Auftreten H, D, F, eine lineare Alkylgruppe mit 1 bis 10 C-Atomen oder eine verzweigte oder cyclische Alkylgruppe mit 3 bis 10 C-Atomen, wobei die Alkylgruppe jeweils auch deuteriert sein kann; dabei können zwei benachbarte Reste R miteinander ein Ringsystem bilden;
   - R¹: ist gleich oder verschieden bei jedem Auftreten H, D, eine lineare Alkylgruppe mit 1 bis 10 C-Atomen oder eine verzweigte oder cyclische Alkylgruppe mit 3 bis 10 C-Atomen, wobei die Alkylgruppe jeweils auch deuteriert sein kann; dabei können zwei benachbarte Reste R¹ miteinander ein Ringsystem bilden;
   - R²: ist gleich oder verschieden bei jedem Auftreten H, D, eine lineare Alkylgruppe mit 1 bis 10 C-Atomen, eine verzweigte oder cyclische Alkylgruppe mit 3 bis 10 C-Atomen, wobei die Alkylgruppe jeweils auch deuteriert sein kann, oder eine Phenyl- oder Biphenylgruppe, die jeweils durch ein oder mehrere Alkylgruppen mit 1 bis 10 C-Atomen substituiert sein kann, wobei die Phenyl- bzw. Biphenylgruppe bzw. die Alkylgruppen jeweils auch deuteriert sein können; dabei können zwei benachbarte Reste R² miteinander ein Ringsystem bilden;
   - m: ist 1, 2 oder 3;
   - n: ist bei jedem Auftreten gleich oder verschieden 0, 1, 2 oder 3;
   - o: ist 0 oder 1;
   - p: ist 0, 1 oder 2;
   - q: ist 0, 1 oder 2;
   - r: ist 0, 1 oder 2.

Bei dem Liganden L der Formel (2) handelt es sich somit um einen hexadentaten, tripodalen Liganden mit den drei bidentaten Phenylpyridin-Teilliganden. Der mit diesem Liganden gebildete Komplex Ir(L) der Formel (1) weist somit die folgende Struktur auf: 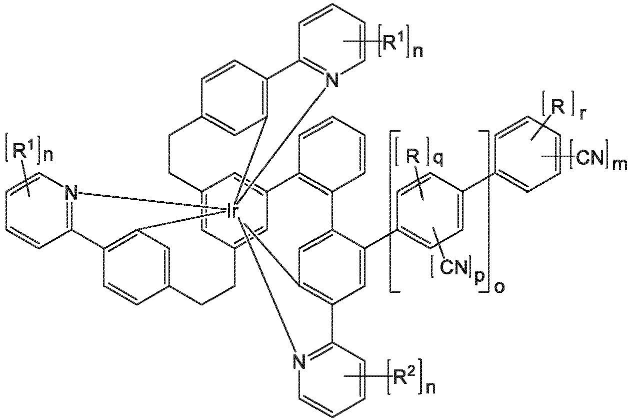 wobei die Symbole und Indizes die oben genannten Bedeutungen aufweisen.

Wenn zwei Reste R bzw. zwei Reste R¹ bzw. zwei Reste R² miteinander ein Ringsystem bilden, so kann dieses mono- oder polycyclisch sein. Dabei sind die Reste, die miteinander ein Ringsystem bilden, benachbart, d. h. dass diese Reste an Kohlenstoffatome binden, die direkt aneinander gebunden sind. Unter der Formulierung, dass zwei Reste R miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht:

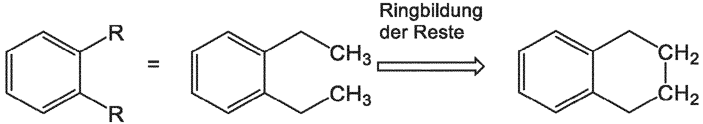

Unter einer cyclischen Alkylgruppe im Sinne dieser Erfindung wird eine monocyclische, eine bicyclische oder eine polycyclische Gruppe verstanden.

Im Rahmen der vorliegenden Erfindung werden unter einer C₁- bis C₁₀-Alkylgruppe beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Adamantyl, 1,1-Dimethyl-n-hex-1-yl-, 1,1-Dimethyl-n-hept-1-yl-, 1,1-Dimethyl-n-oct-1-yl-, 1,1-Diethyl-n-hex-1-yl-, 1-(n-Propyl)-cyclohex-1-yl- und 1-(n-Butyl)-cyclohex-1-yl- verstanden.

Wenn die Indizes n, p, q bzw. r = 0 sind, ist anstelle der entsprechenden Substiutenenten jeweils ein Wasserstoff- bzw. Deuteriumatom an die entsprechende Phenyl- bzw. Pyridingruppe gebunden.

Für m = 1 steht der Ligand L bevorzugt für eine Struktur der folgenden Formel (3a), für m = 2 steht der Ligand L bevorzugt für eine Struktur der folgenden Formel (3b) oder (3c) und für m = 3 steht der Ligand L bevorzugt für eine Struktur der folgenden Formel (3d) oder (3e), 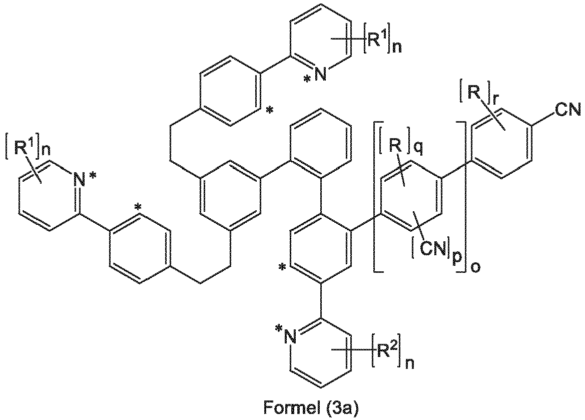 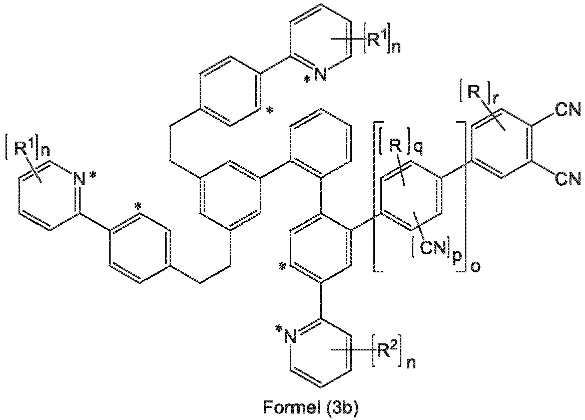 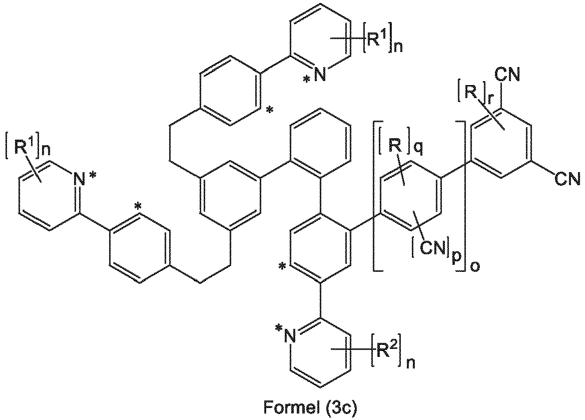 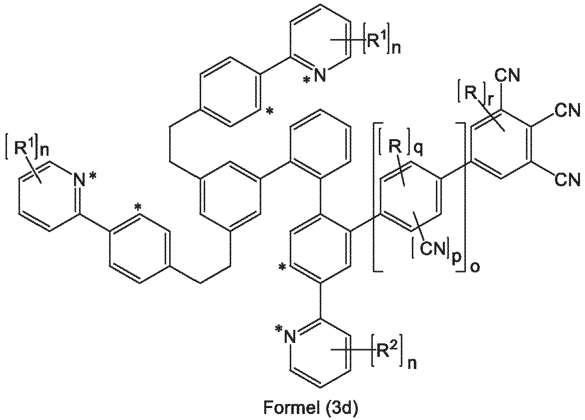 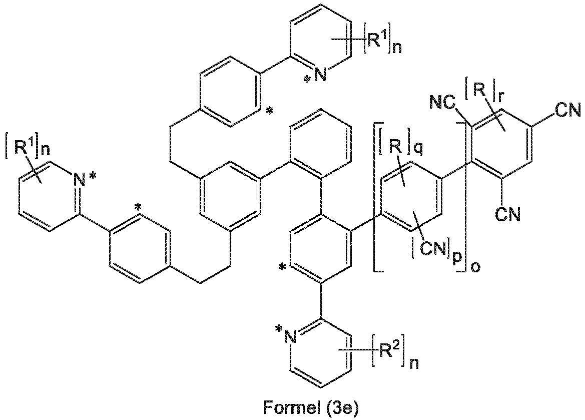 wobei die Symbole und Indizes die oben genannten Bedeutungen aufweisen und die nicht explizit eingezeichneten Wasserstoffatome auch durch Deuterium ersetzt sein können.

Bevorzugt ist die Struktur der Formel (3a).

Wenn o = 1 ist, sind bevorzugte Ausführungsformen q = 0 und p = 0, 1 oder 2 oder q = 0, 1 oder 2 und p = 0. Für o = 1 und p = 1 weist der Ligand bevorzugt eine Struktur der folgenden Formel (4a) auf, und für o = 1 und p = 2 weist der Ligand bevorzugt eine Struktur der folgenden Formel (4b) auf, 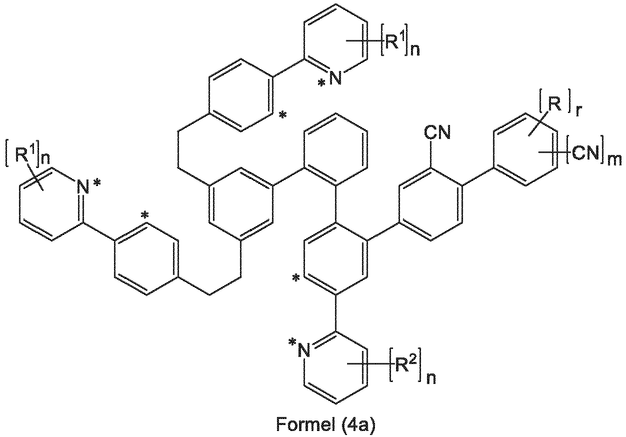 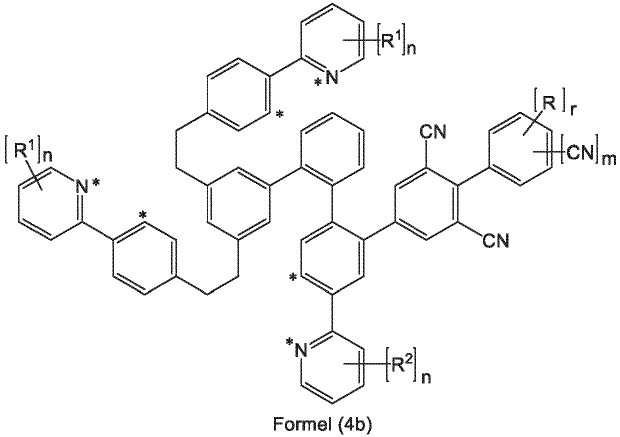 wobei die Symbole und Indizes die oben genannten Bedeutungen aufweisen und die nicht explizit eingezeichneten Wasserstoffatome auch durch Deuterium ersetzt sein können.

In einer bevorzugten Ausführungsform der Erfindung sind die Indizes n an den beiden Phenylpyridin-Teilliganden, die nicht mit der Cyanophenyl- bzw. Cyanobiphenylgruppe substituiert sind, = 0. In einer weiteren bevorzugten Ausführungsform der Erfindung sind diese Indizes n = 1 oder 2 und die entsprechenden Reste R¹ sind ungleich H oder D. Wenn diese Indizes n = 1 sind, weist der Ligand bevorzugt eine Struktur der folgenden Formel (5a) oder (5b) auf, und wenn diese Indizes n = 2 sind, weist der Ligand bevorzugt eine Struktur der folgenden Formel (5c) auf, 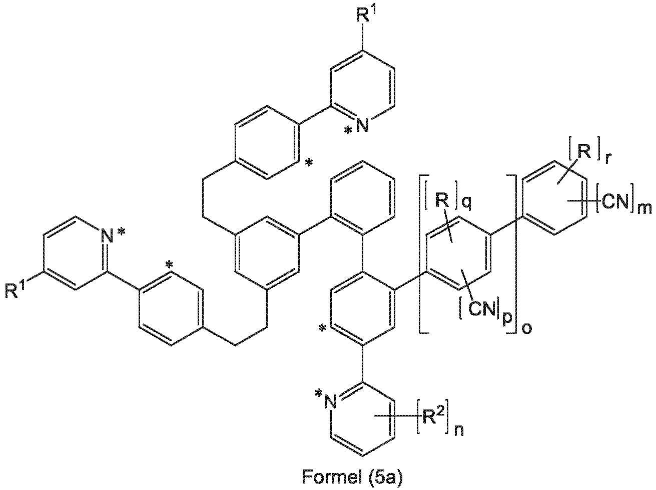 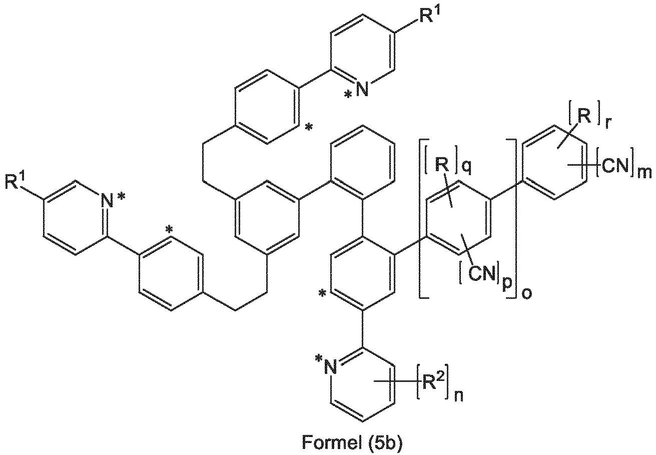 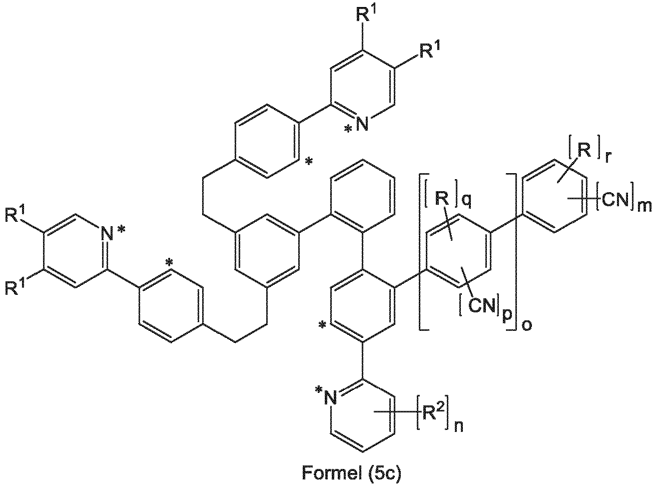 wobei die Symbole und Indizes die oben genannten Bedeutungen aufweisen und R¹ ungleich H oder D ist und die nicht explizit eingezeichneten Wasserstoffatome auch durch Deuterium ersetzt sein können.

In einer weiteren bevorzugten Ausführungsform der Erfindung ist der Index n an dem Phenylpyridin-Teilliganden, die mit der Cyanophenyl- bzw. Cyanobiphenylgruppe substituiert sind, = 0. In einer weiteren bevorzugten Ausführungsform der Erfindung ist dieser Index n = 1 oder 2 und die entsprechenden Reste R² sind ungleich H oder D. Wenn dieser Index n = 1 ist, weist der Ligand bevorzugt eine Struktur der folgenden Formel (6a) oder (6b) auf, und wenn dieser Index n = 2 ist, weist der Ligand bevorzugt eine Struktur der folgenden Formel (6c) auf, 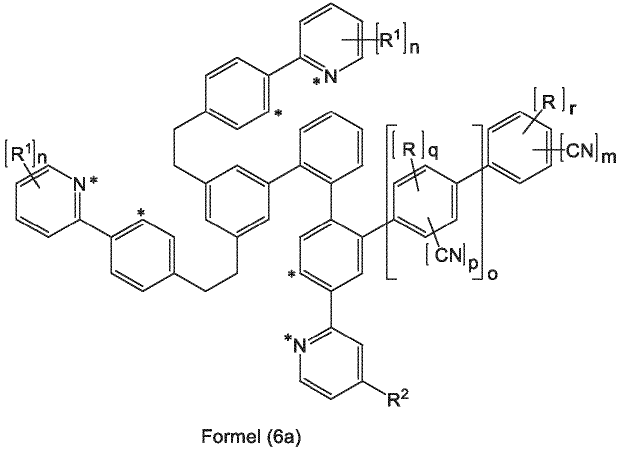 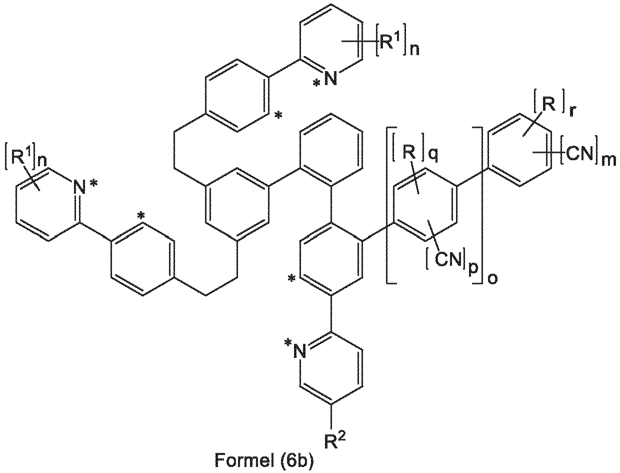 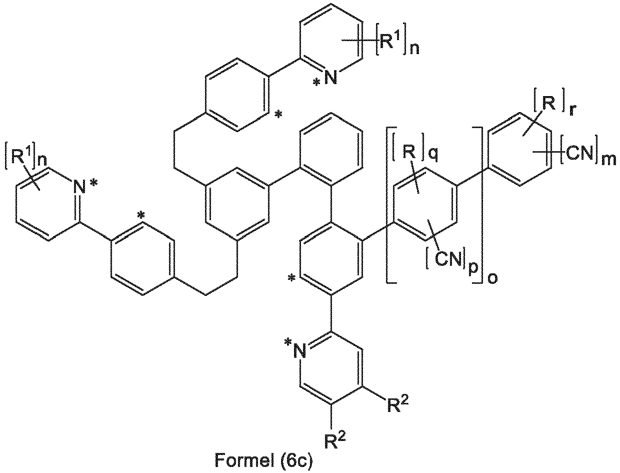 wobei die Symbole und Indizes die oben genannten Bedeutungen aufweisen und R² ungleich H oder D ist und die nicht explizit eingezeichneten Wasserstoffatome auch durch Deuterium ersetzt sein können.

Bevorzugt weist der Ligand L eine Struktur der folgenden Formel (7) auf, 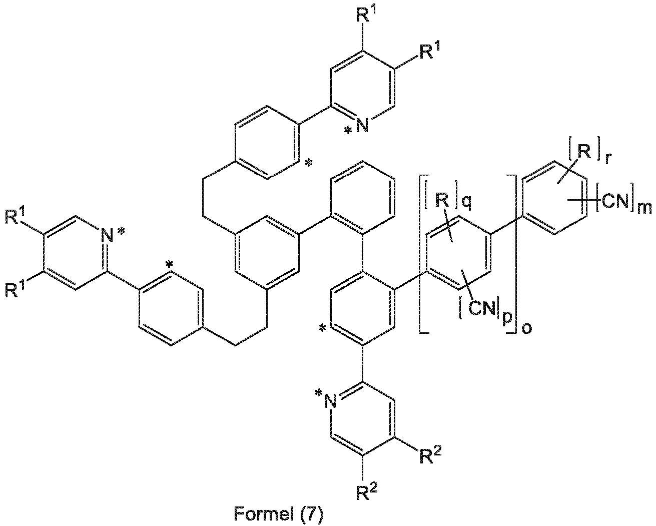 wobei die Symbole und Indizes die oben genannten Bedeutungen aufweisen und die nicht explizit eingezeichneten Wasserstoffatome auch durch Deuterium ersetzt sein können.

In einer bevorzugten Ausführungsform der Erfindung sind die Substituenten R gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können. Besonders bevorzugt sind die Substituenten R gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können. Insbesondere bevorzugt ist R eine Methylgruppe oder eine CD₃-Gruppe.

In einer weiteren bevorzugten Ausführungsform der Erfindung sind die Substituenten R¹ gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können; dabei können zwei benachbarte Reste R¹ miteinander ein Ringsystem bilden. Besonders bevorzugt sind die Substituenten R¹ gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können; dabei können zwei benachbarte Reste R¹ miteinander ein Ringsystem bilden. Insbesondere bevorzugt ist R¹ eine Methylgruppe oder eine CD₃-Gruppe.

In einer weiteren bevorzugten Ausführungsform der Erfindung sind die Substituenten R² gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können, oder eine optional deuterierte Phenylgruppe, die durch ein oder mehrere optional deuterierte Alkylgruppen mit 1 bis 4 C-Atomen substituiert sein kann; dabei können zwei benachbarte Reste R² miteinander ein Ringsystem bilden. Besonders bevorzugt sind die Substituenten R² gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können; dabei können zwei benachbarte Reste R², wenn diese für Alkylgruppen stehen, miteinander ein Ringsystem bilden. Insbesondere bevorzugt ist R² eine Methylgruppe oder eine CD₃-Gruppe. Wenn R² für eine optional deuterierte Phenylgruppe steht, ist diese bevorzugt unsubstituiert oder mit ein oder zwei optional deuterierten Alkylgruppen, bevorzugt Methylgruppen oder CD₃-Gruppen substituiert, wobei diese Alkylgruppen dann bevorzugt in der ortho-Position zur Verknüpfung der Phenylgruppe gebunden sind.

In einer weiteren bevorzugten Ausführungsform der Erfindung ist m = 1 oder 2, besonders bevorzugt 1.

In einer weiteren bevorzugten Ausführungsform der Erfindung ist n bei jedem Auftreten gleich oder verschieden 0, 1 oder 2.

In einer weiteren bevorzugten Ausführungsform der Erfindung ist o = 1. Wenn n am gleichen Liganden = 1 ist und R² für eine Phenylgruppe steht, ist auch o = 1 bevorzugt.

In einer weiteren bevorzugten Ausführungsform der Erfindung ist p = 0 oder 1, besonders bevorzugt = 0.

In einer weiteren bevorzugten Ausführungsform der Erfindung ist q = 0 oder 1.

In einer weiteren bevorzugten Ausführungsform der Erfindung ist r = 0 oder 1.

Bevorzugt treten mehrere der oben genannten Bevorzugungen gleichzeitig auf. Bevorzugt gilt daher für die Symbole und Indizes:
- R: ist gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können;
- R¹: ist gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können; dabei können zwei benachbarte Reste R¹ miteinander ein Ringsystem bilden;
- R²: ist gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können, oder eine optional deuterierte Phenylgruppe, die durch ein oder mehrere optional deuterierte Alkylgruppen mit 1 bis 4 C-Atomen substituiert sein kann; dabei können zwei benachbarte Reste R² miteinander ein Ringsystem bilden;
- m: ist 1 oder 2;
- n: ist bei jedem Auftreten gleich oder verschieden 0, 1 oder 2;
- o: ist 1; oder o ist 0 oder 1, wenn n am gleichen Liganden = 1 ist und R² für eine Phenylgruppe steht;
- p: ist 0 oder 1;
- q: ist 0 oder 1;
- r: ist 0 oder 1.

Besonders bevorzugt gilt für die Symbole und Indizes:
- R: ist gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können;
- R¹: ist gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können; dabei können zwei benachbarte Reste R¹ miteinander ein Ringsystem bilden;
- R²: ist gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können, oder eine optional deuterierte Phenylgruppe, die durch ein oder mehrere optional deuterierte Alkylgruppen mit 1 bis 4 C-Atomen substituiert sein kann; dabei können zwei benachbarte Alkylgruppen R² miteinander ein Ringsystem bilden;
- m: ist 1;
- n: ist bei jedem Auftreten gleich oder verschieden 0, 1 oder 2;
- o: ist 1; oder o ist 0 oder 1, wenn n am gleichen Liganden = 1 ist und R² für eine Phenylgruppe steht;
- p: ist 0;
- q: ist 0 oder 1;
- r: ist 0 oder 1.

Wenn zwei Reste R bzw. R¹ bzw. R² für Alkylgruppen stehen, die miteinander ein Ringsystem bilden, so ist dieses Ringsystem bevorzugt ausgewählt aus den Strukturen der folgenden Formeln (Ring-1) bis (Ring-7) 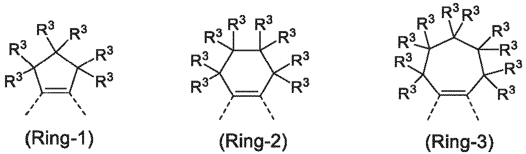 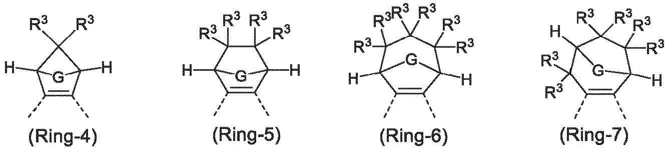 wobei die gestrichelten Bindungen die Verknüpfung der beiden Kohlenstoffatome im Liganden andeuten und weiterhin gilt:
- R³: ist gleich oder verschieden bei jedem Auftreten H, D oder eine Alkylgruppe mit 1, 2 oder 3 C-Atomen;
- G: ist eine Alkylengruppe mit 1 oder 2 C-Atomen.

In den oben abgebildeten Strukturen (Ring-1) bis (Ring-7) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, da diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (Ring-1) bis (Ring-3) dadurch erreicht, dass R³ in den benzylischen Positionen für eine Alkylgruppe steht. Dies kann weiterhin auch dadurch erreicht werden, dass die Kohlenstoffatome des aliphatischen Ringsystems, die direkt an eine Pyridin- oder Phenylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen.

Beispiele für geeignete Gruppen der Struktur (Ring-1) sind die im Folgenden aufgeführten Strukturen:

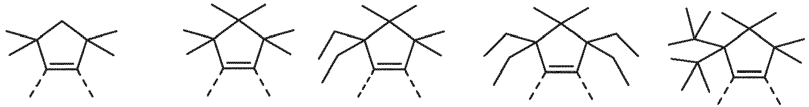

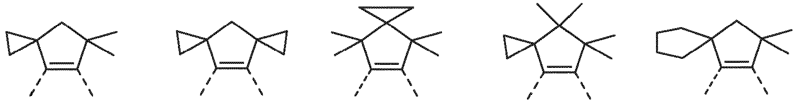

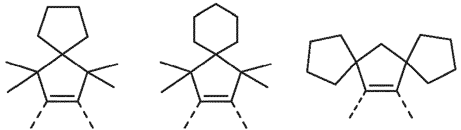

Beispiele für geeignete Gruppen der Formel (Ring-2) sind die im Folgenden aufgeführten Strukturen:

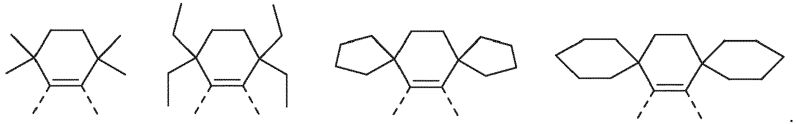

Beispiele für geeignete Gruppen der Formeln (Ring-3), (Ring-6) und (Ring-7) sind die im Folgenden aufgeführten Strukturen:

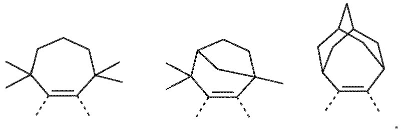

Beispiele für geeignete Gruppen der Formel (Ring-4) sind die im Folgenden aufgeführten Strukturen:

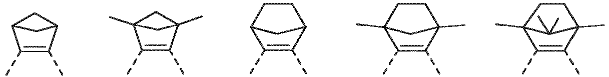

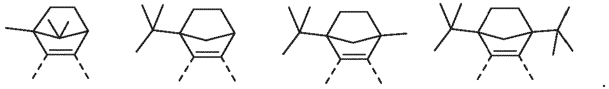

Beispiele für geeignete Gruppen der Formel (Ring-5) sind die im Folgenden aufgeführten Strukturen:

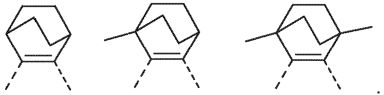

In einer besonders bevorzugten Ausführungsform der Erfindung weist der Ligand L eine Struktur der folgenden Formel (8) auf, 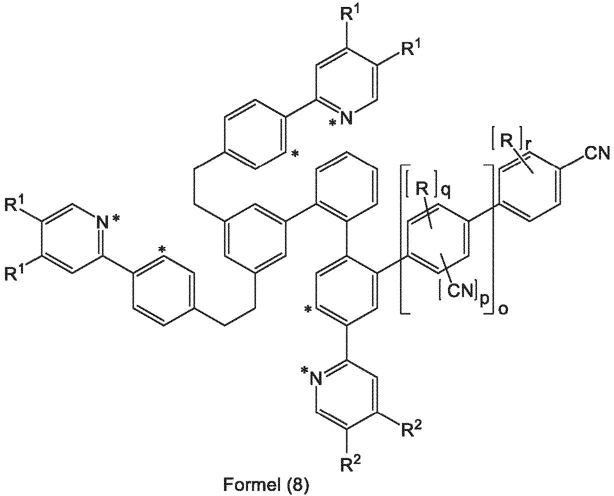 wobei R, R¹, R² und o die oben genannten Bedeutungen aufweisen, insbesondere die oben genannten bevorzugten Bedeutungen bzw. die oben genannten besonders bevorzugten Bedeutungen, p = 0 oder 1 ist, q = 0 oder 1 ist und r = 0 oder 1 ist und die nicht explizit eingezeichneten Wasserstoffatome auch durch Deuterium ersetzt sein können.

Ganz besonders bevorzugt weist der Ligand L eine Struktur der folgenden Formel (9) auf, 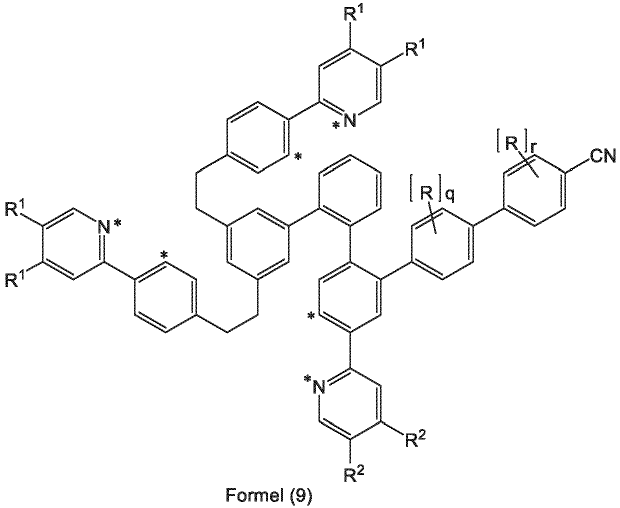 wobei R, R¹ und R² die oben genannten Bedeutungen aufweisen, insbesondere die oben genannten bevorzugten Bedeutungen bzw. die oben genannten besonders bevorzugten Bedeutungen, q = 0 oder 1 ist und r = 0 oder 1 ist und die nicht explizit eingezeichneten Wasserstoffatome auch durch Deuterium ersetzt sein können.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für geeignete erfindungsgemäße Strukturen sind die nachfolgend abgebildeten Verbindungen.

| | |
|---|---|
| 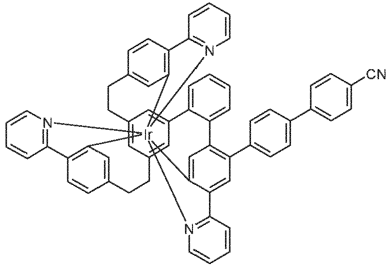 | 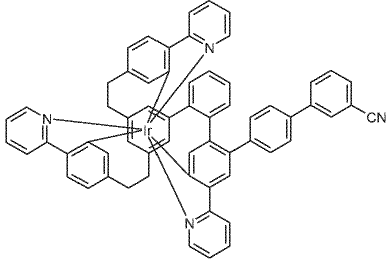 |
| 1 | 2 |
| 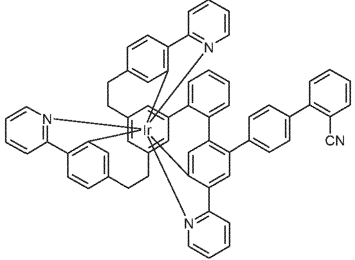 | 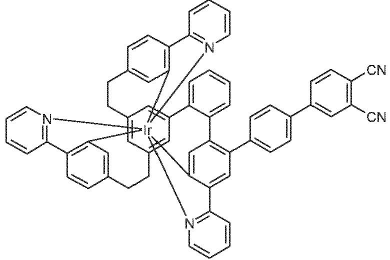 |
| 3 | 4 |
| 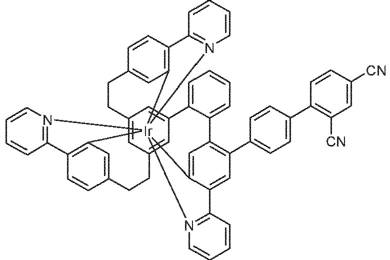 | 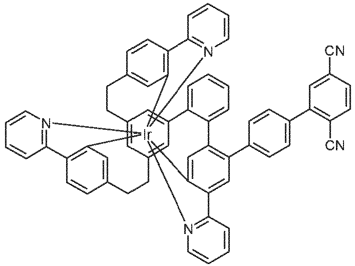 |
| 5 | 6 |
| 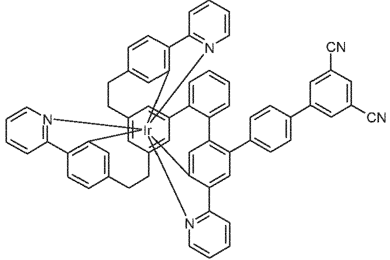 | 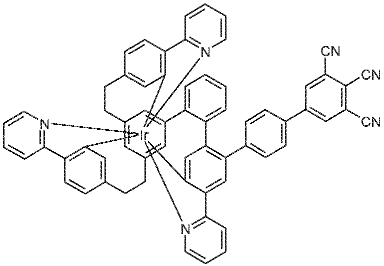 |
| 7 | 8 |
| 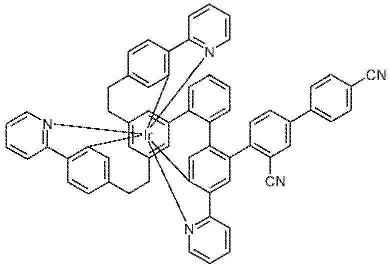 | 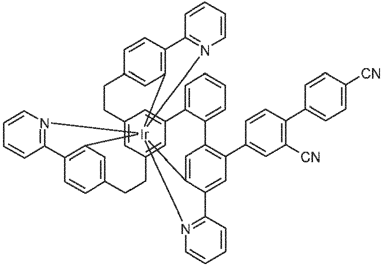 |
| 9 | 10 |
| 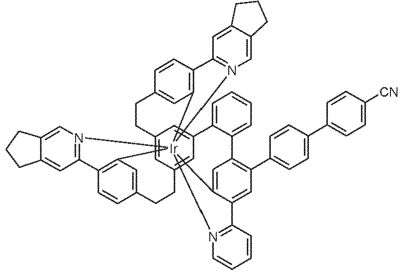 | 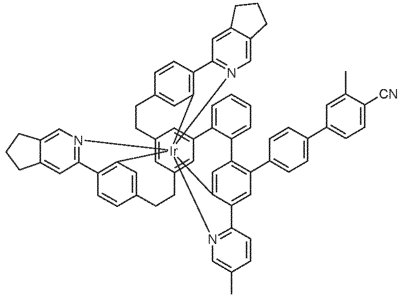 |
| 11 | 12 |
| 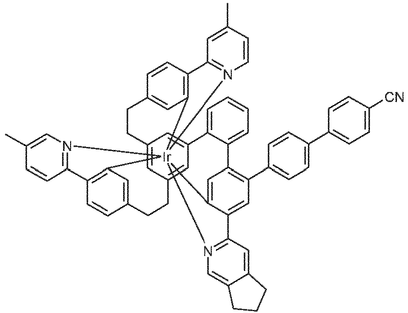 | 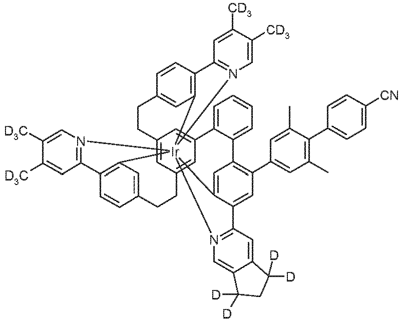 |
| 13 | 14 |
| 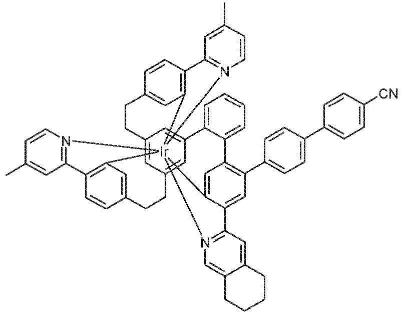 | 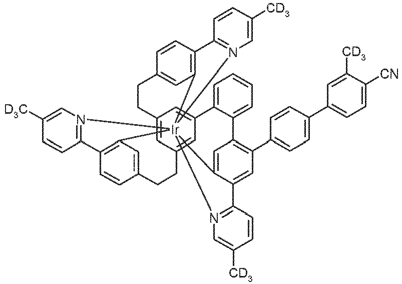 |
| 15 | 16 |
| 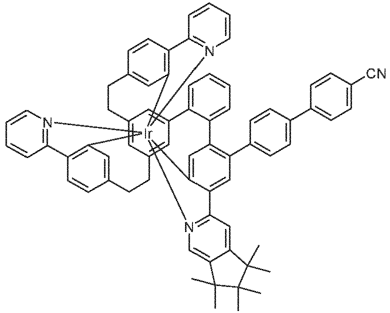 | 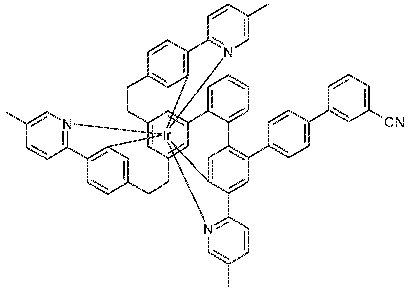 |
| 17 | 18 |
| 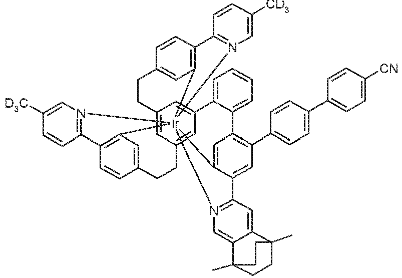 | 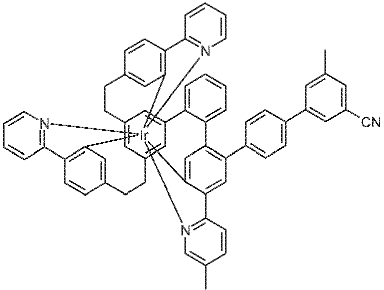 |
| 19 | 20 |
| 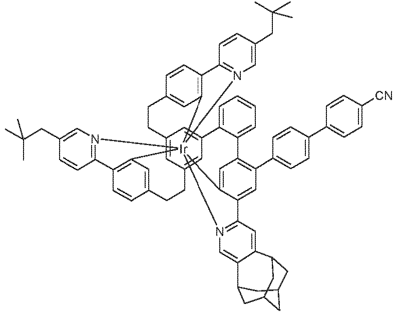 | 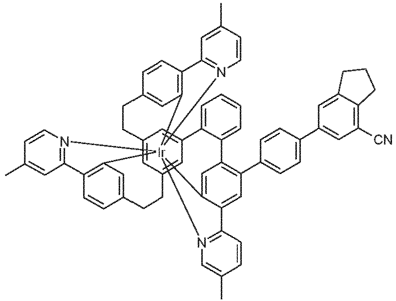 |
| 21 | 22 |
| 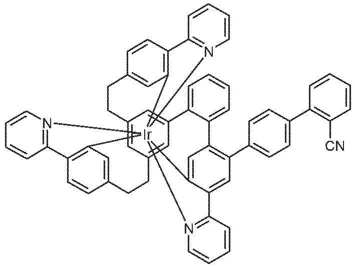 | 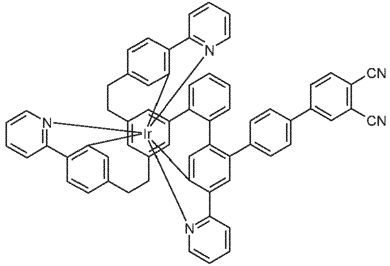 |
| 23 | 24 |
| 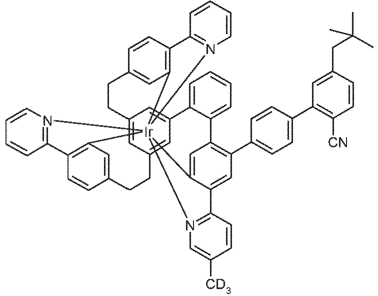 | 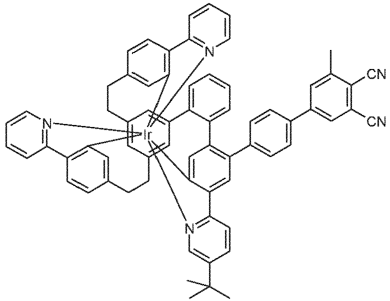 |
| 25 | 26 |
| 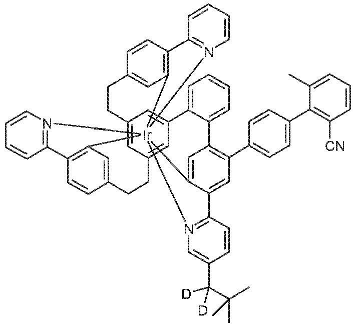 | 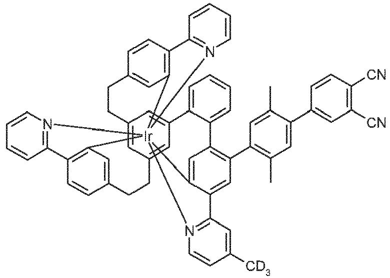 |
| 27 | 28 |
| 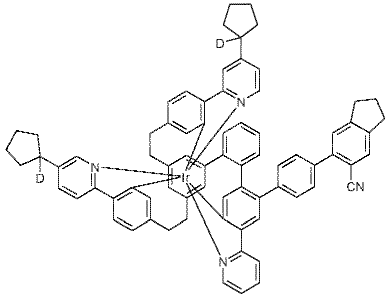 | 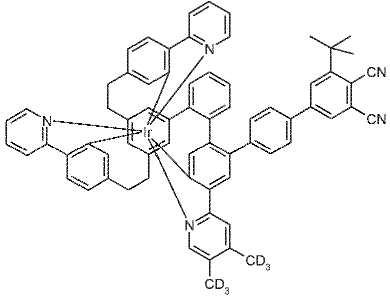 |
| 29 | 30 |
| 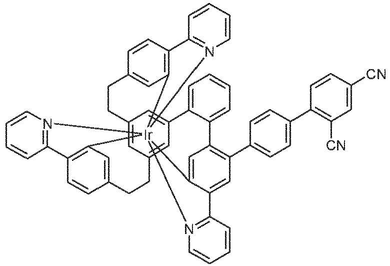 | 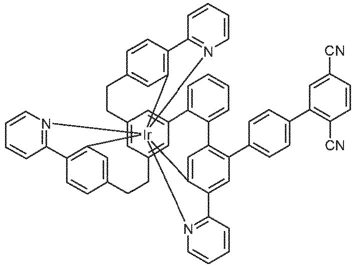 |
| 31 | 32 |
| 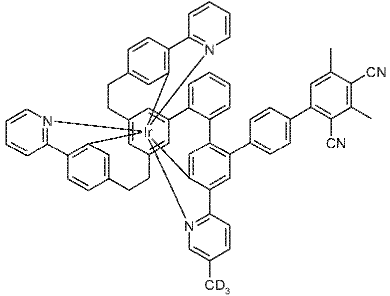 | 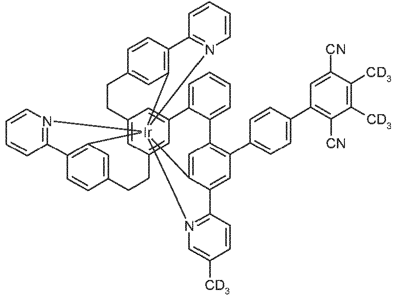 |
| 33 | 34 |
| 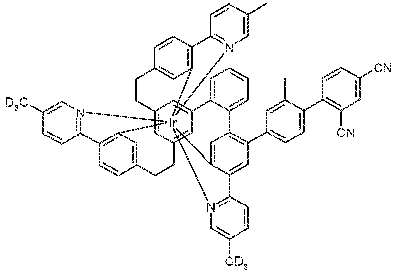 | 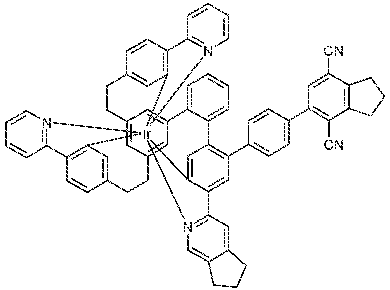 |
| 35 | 36 |
| 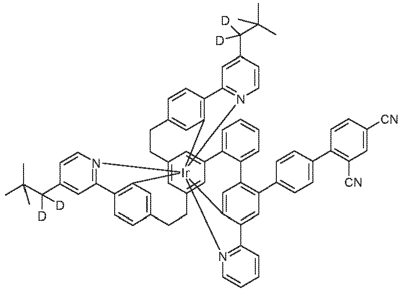 | 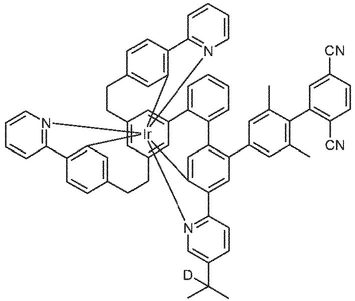 |
| 37 | 38 |
| 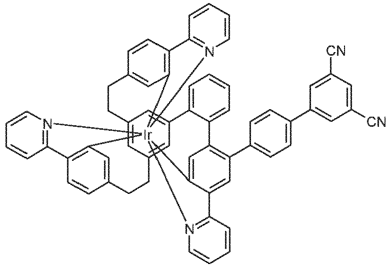 | 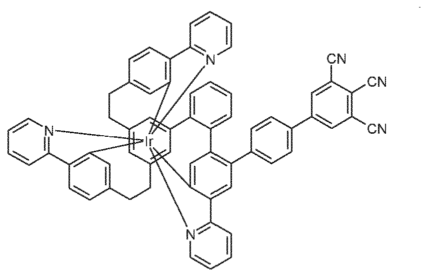 |
| 39 | 40 |
| 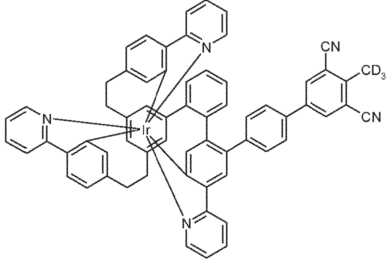 | 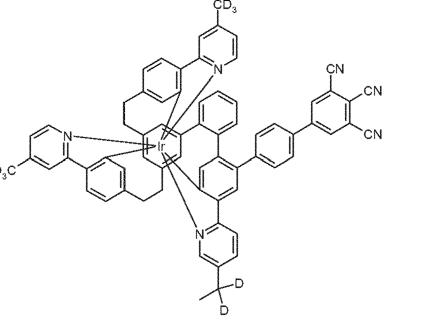 |
| 41 | 42 |
| 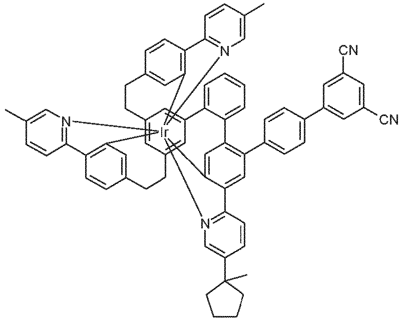 | 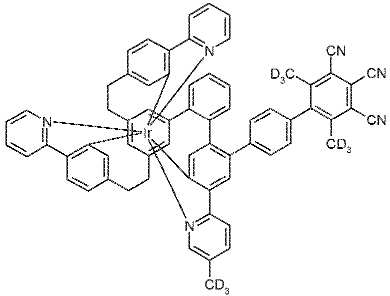 |
| 43 | 44 |
| 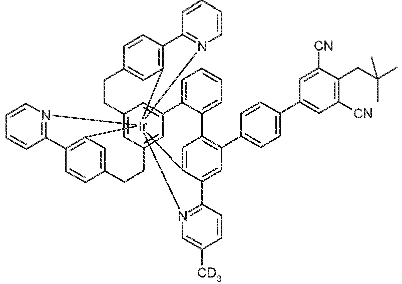 | 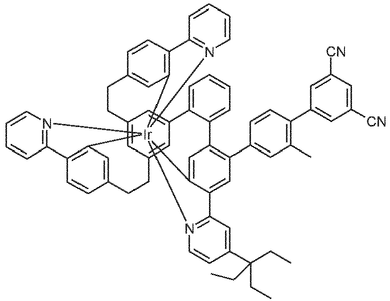 |
| 45 | 46 |
| 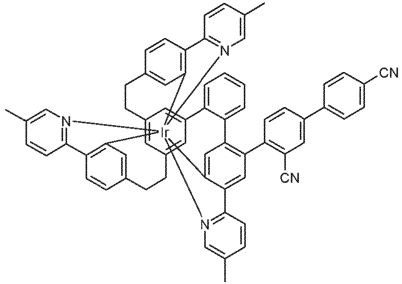 | 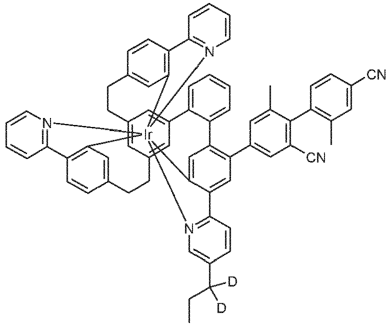 |
| 47 | 48 |
| 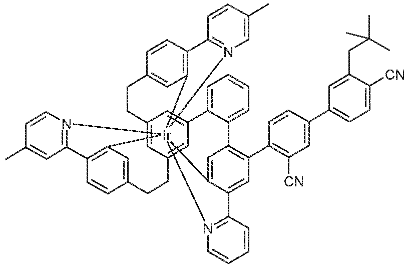 | 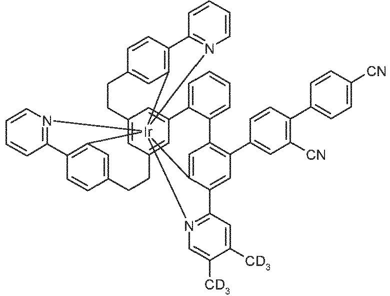 |
| 49 | 50 |
| 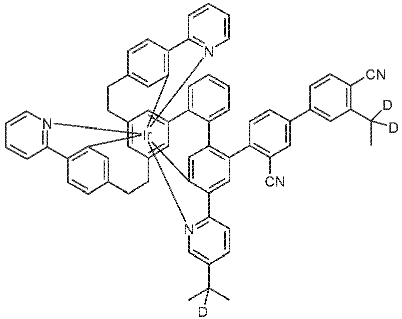 | 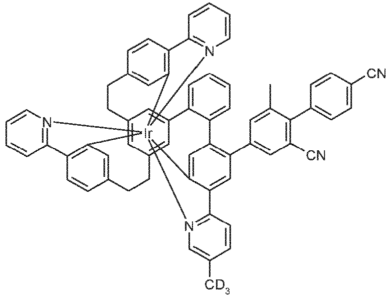 |
| 51 | 52 |
| 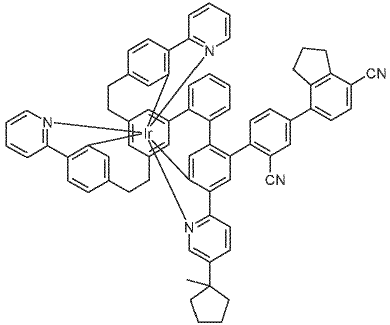 | 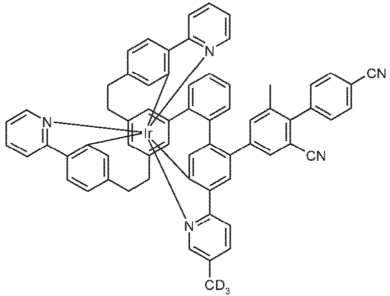 |
| 53 | 54 |
| 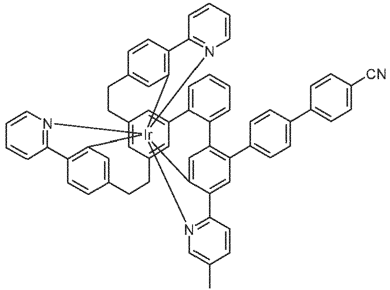 | 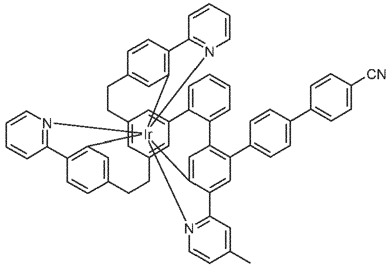 |
| 55 | 56 |
| 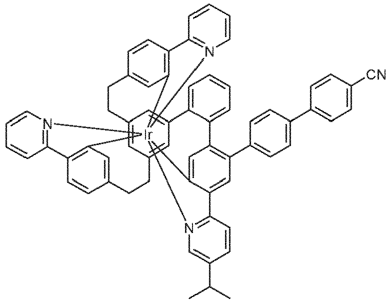 | 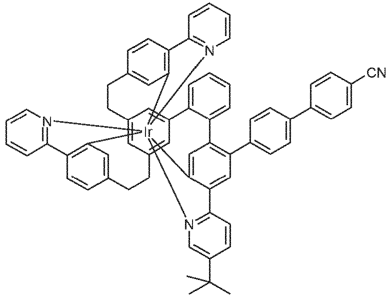 |
| 57 | 58 |
| 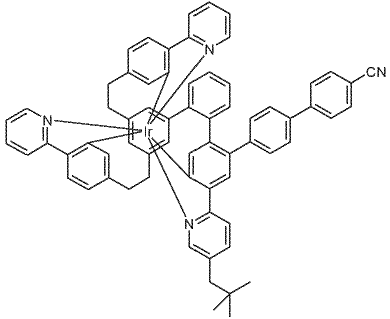 | 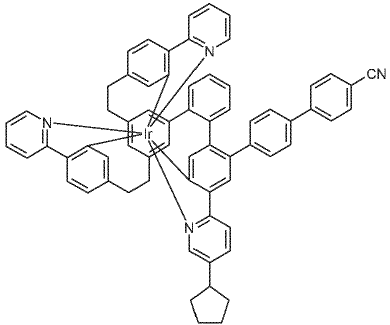 |
| 59 | 60 |
| 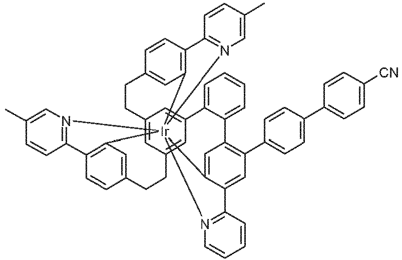 | 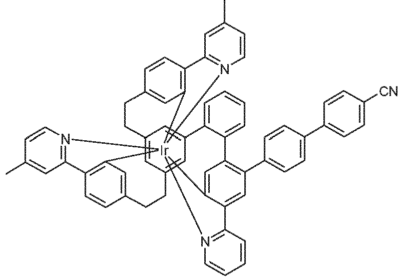 |
| 61 | 62 |
| 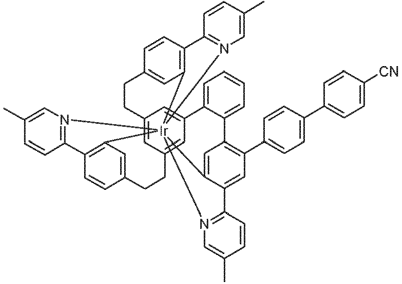 | 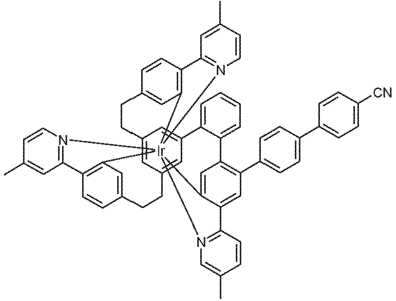 |
| 63 | 64 |
| 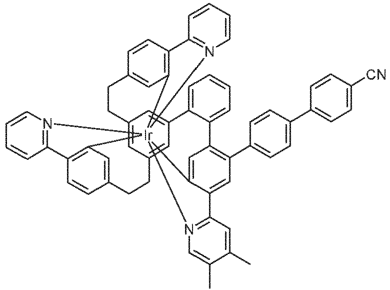 | 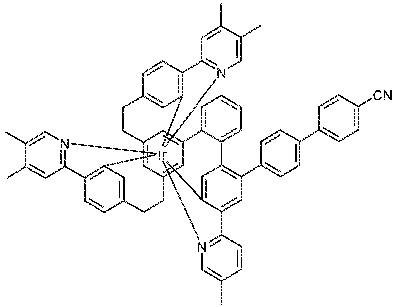 |
| 65 | 66 |
| 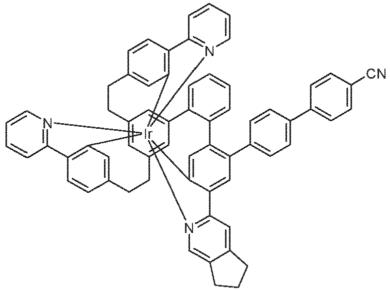 | 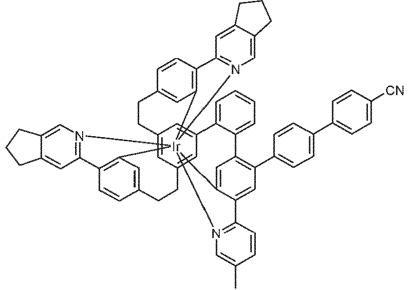 |
| 67 | 68 |
| 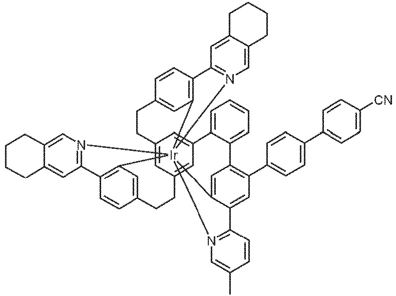 | 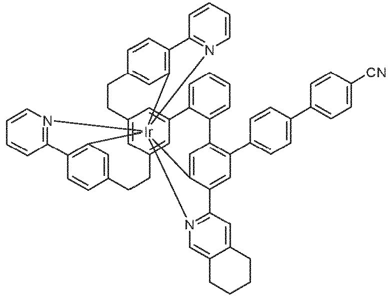 |
| 69 | 70 |
| 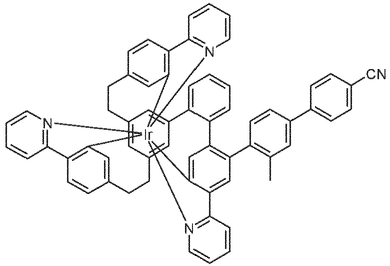 | 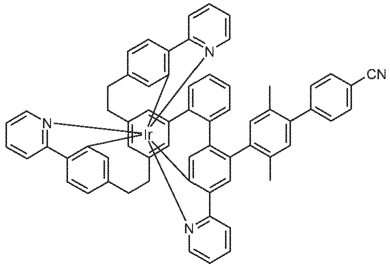 |
| 71 | 72 |
| 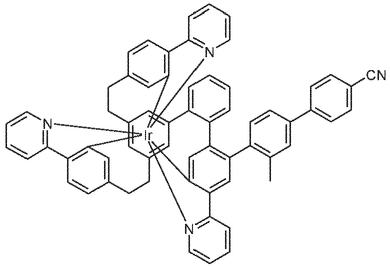 | 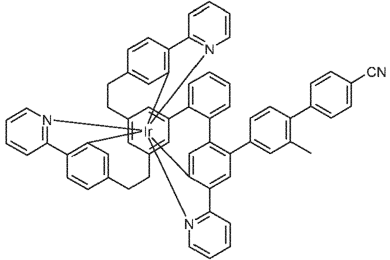 |
| 73 | 74 |
| 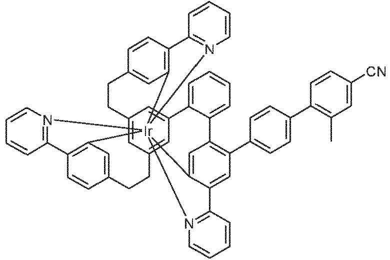 | 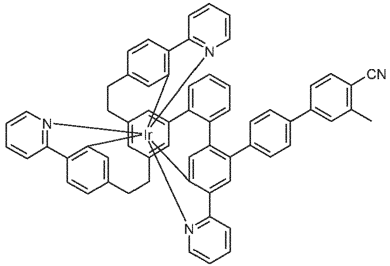 |
| 75 | 76 |
| 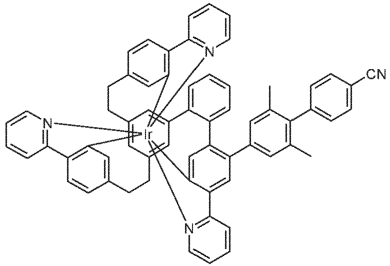 | 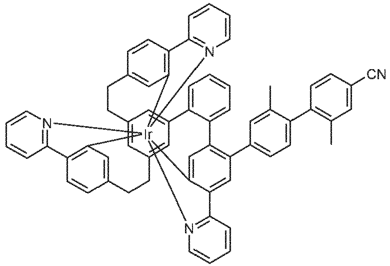 |
| 77 | 78 |
| 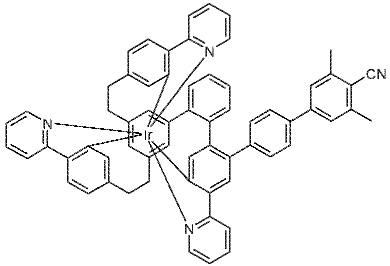 | 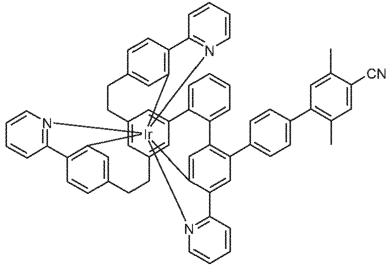 |
| 79 | 80 |
| 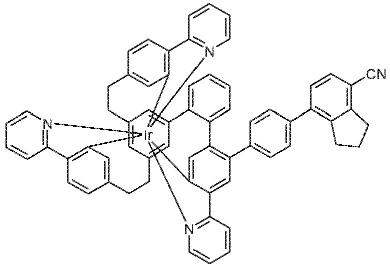 | 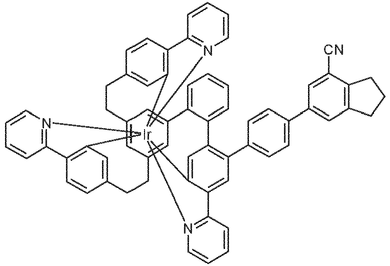 |
| 81 | 82 |
| 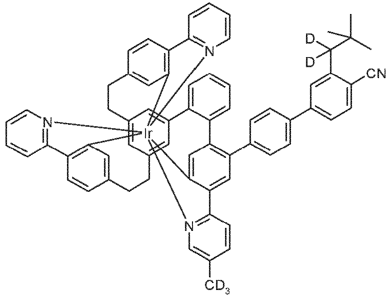 | 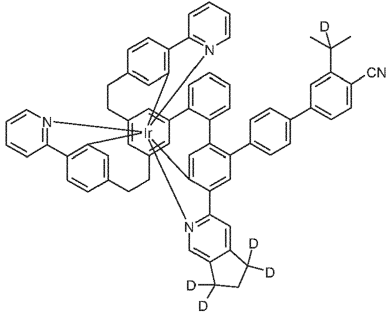 |
| 83 | 84 |
| 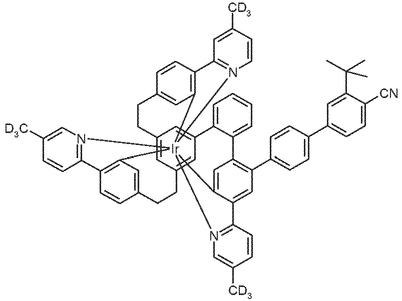 | 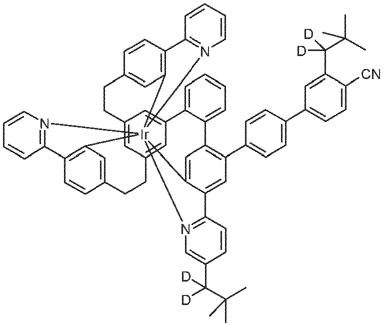 |
| 85 | 86 |
| 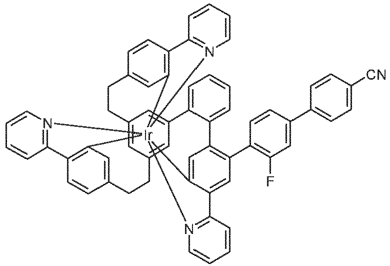 | 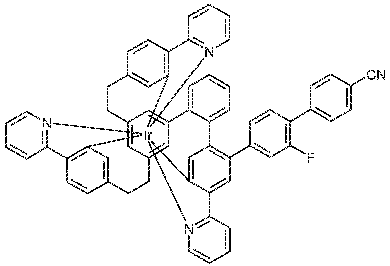 |
| 87 | 88 |
| 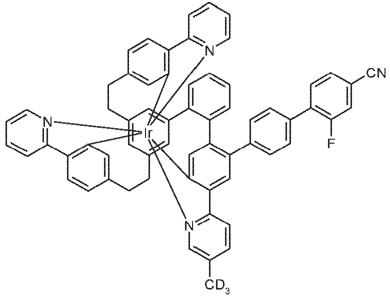 | 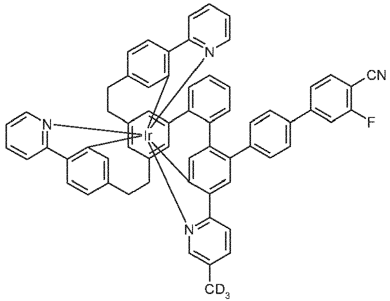 |
| 89 | 90 |
| 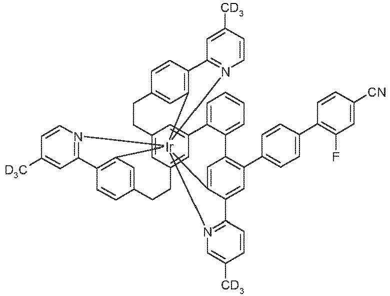 | 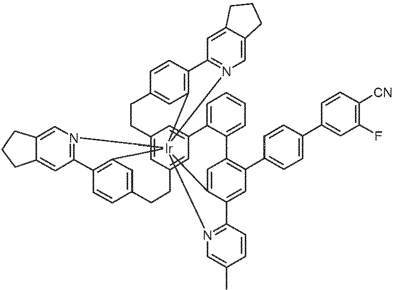 |
| 91 | 92 |
| 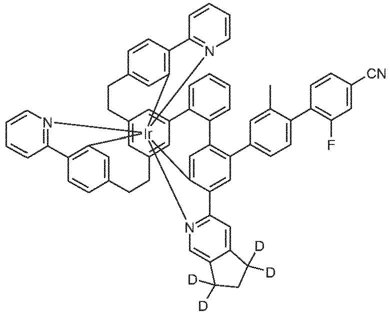 | 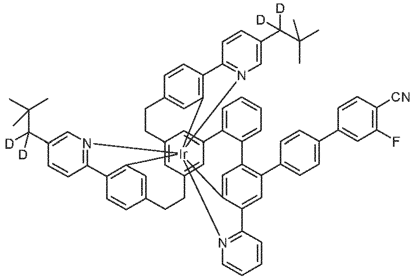 |
| 93 | 94 |
| 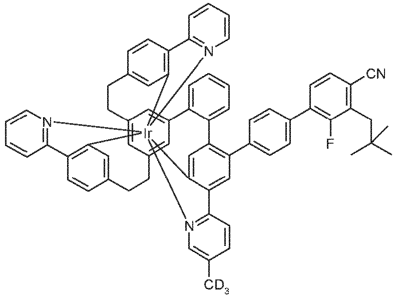 | 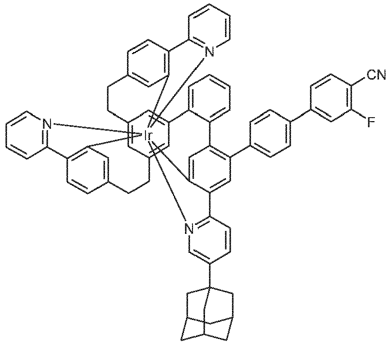 |
| 95 | 96 |
| 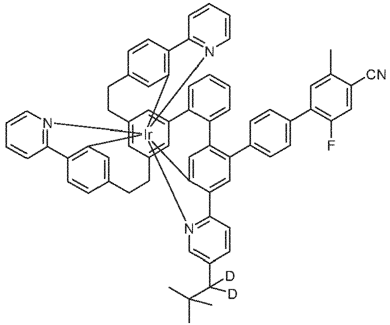 | 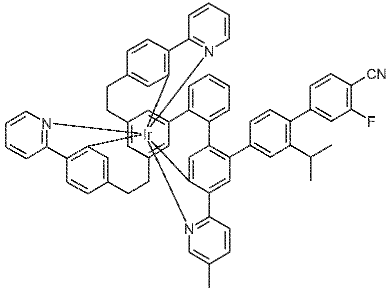 |
| 97 | 98 |
| 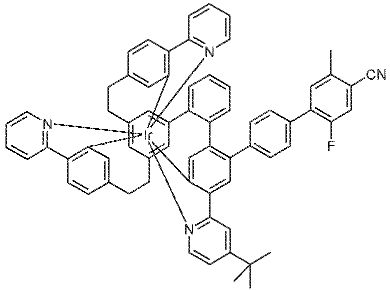 | 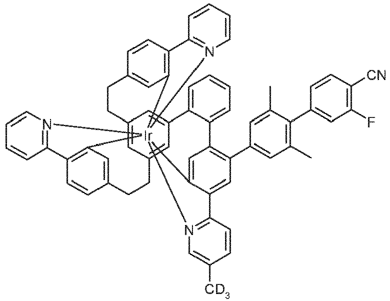 |
| 99 | 100 |
| 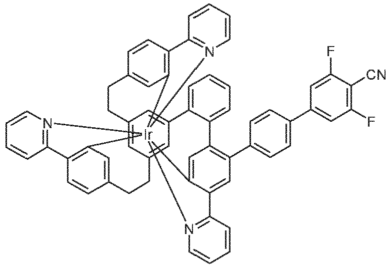 | 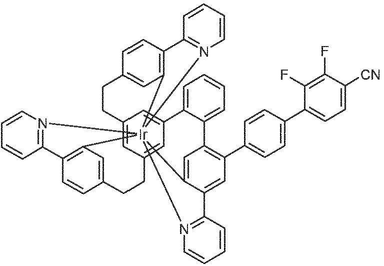 |
| 101 | 102 |
| 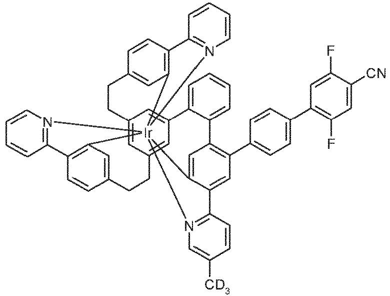 | 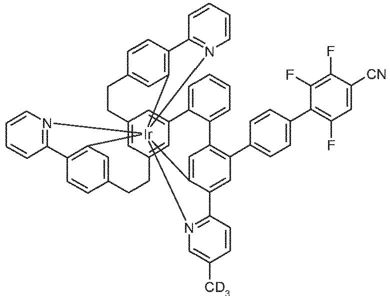 |
| 103 | 104 |
| 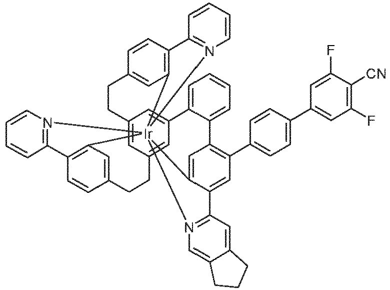 | 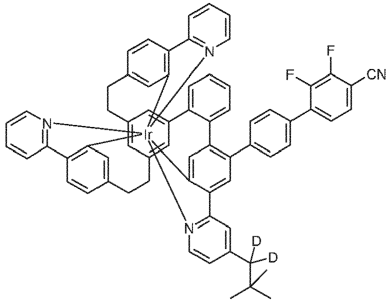 |
| 105 | 106 |
| 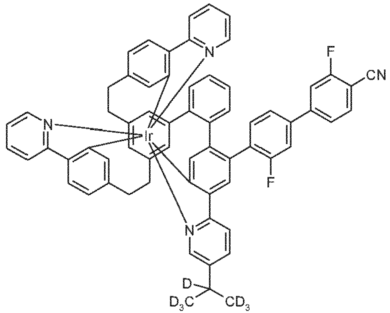 | 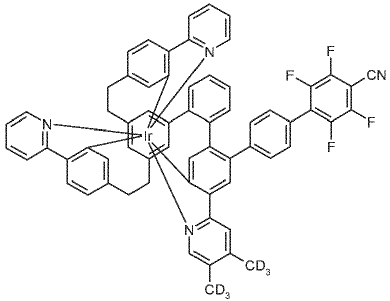 |
| 107 | 108 |
| 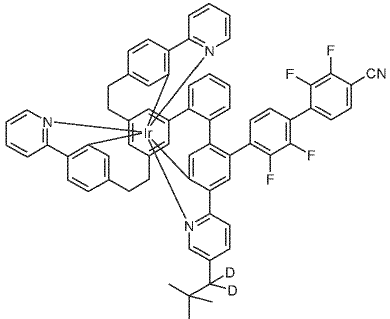 | 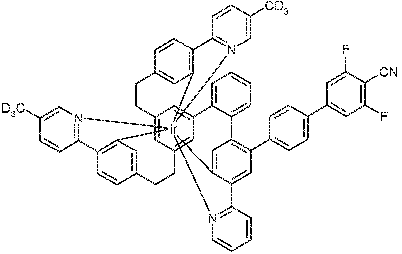 |
| 109 | 110 |
| 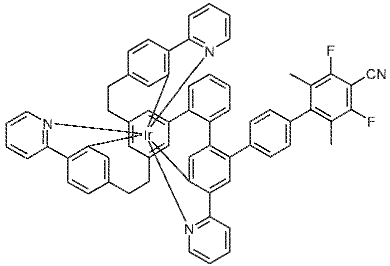 | 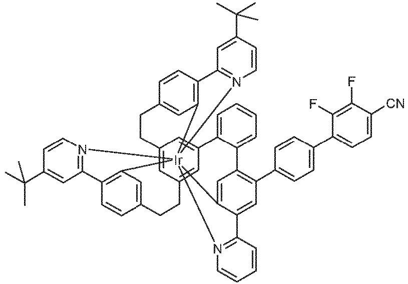 |
| 111 | 112 |
| 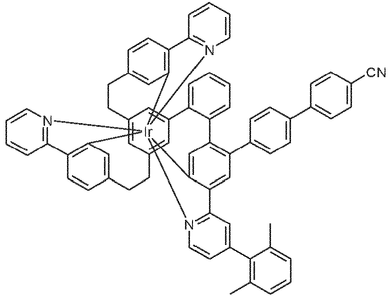 | 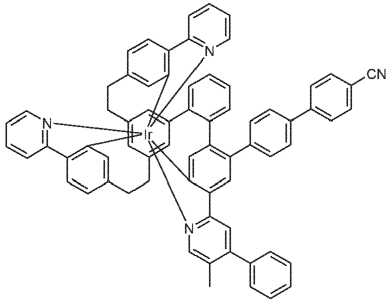 |
| 113 | 114 |
| 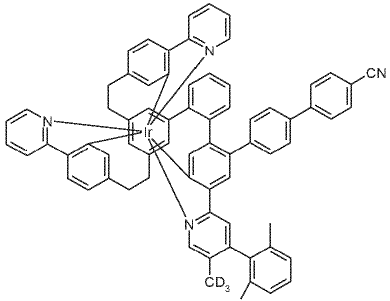 | 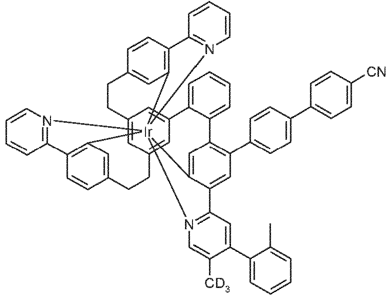 |
| 115 | 116 |
| 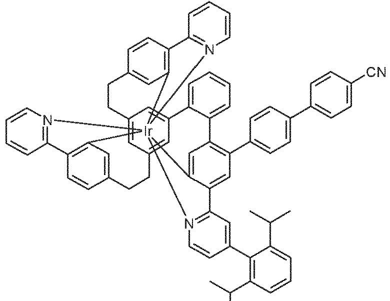 | 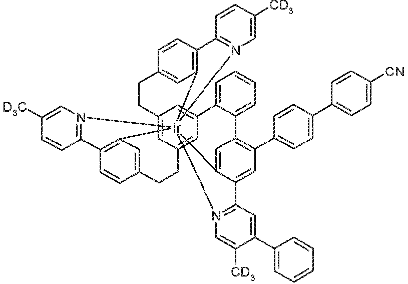 |
| 117 | 118 |
| 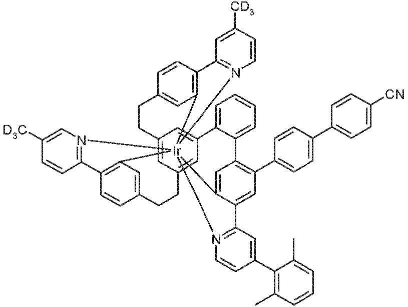 | 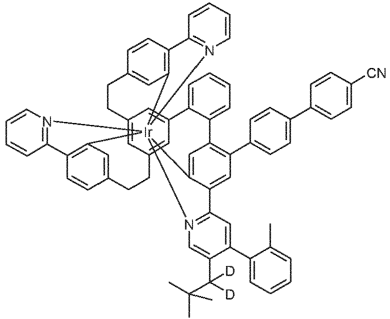 |
| 119 | 120 |
| 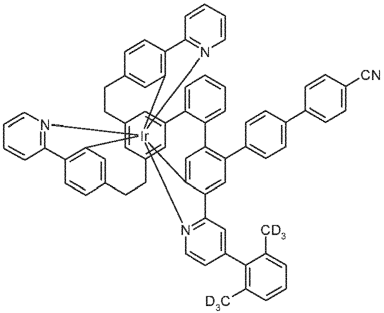 | 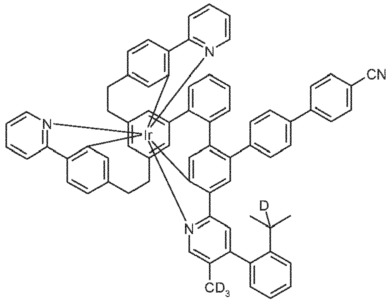 |
| 121 | 122 |
| 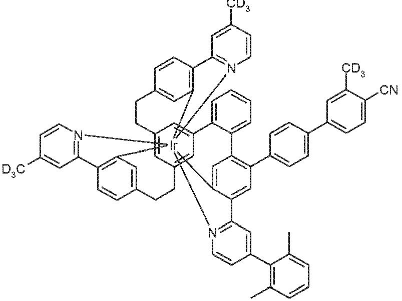 | 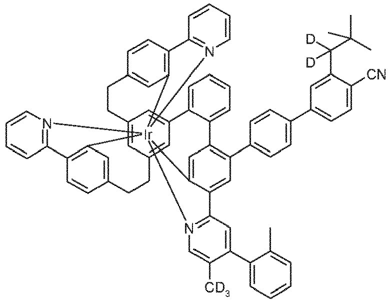 |
| 123 | 124 |
| 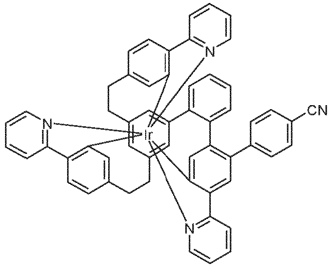 | 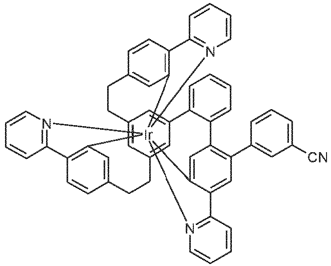 |
| 125 | 126 |
| 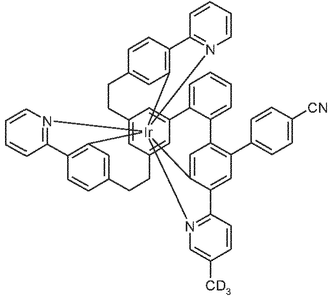 | 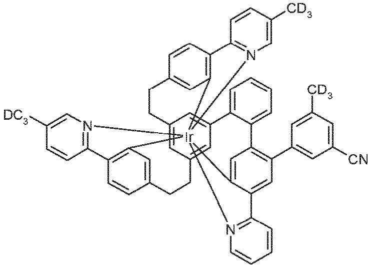 |
| 127 | 128 |
| 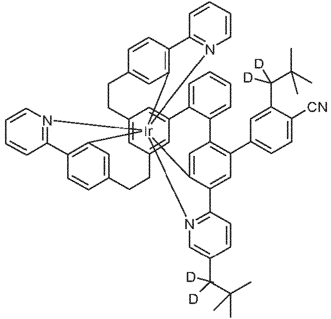 | 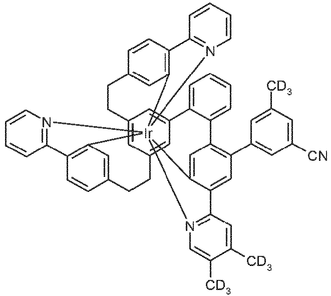 |
| 129 | 130 |
| 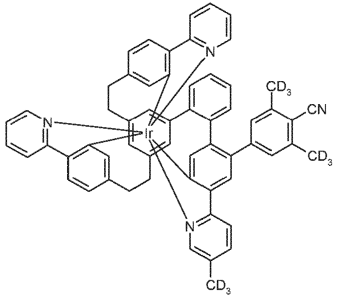 | 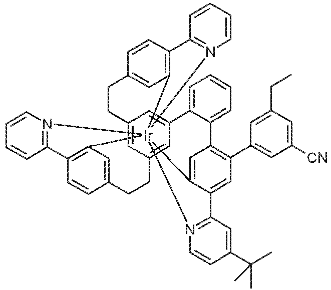 |
| 131 | 132 |
| 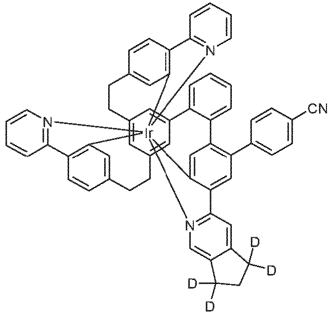 | 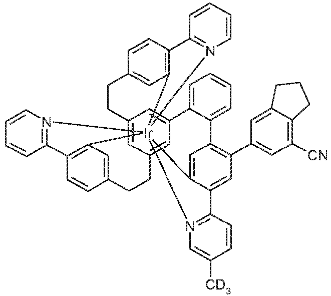 |
| 133 | 134 |
| 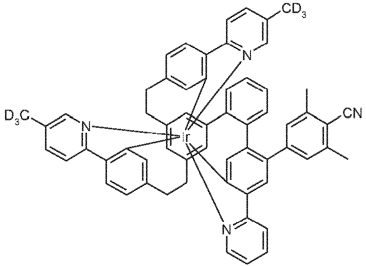 | 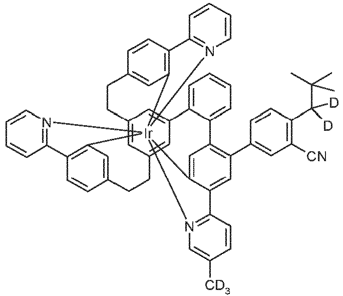 |
| 135 | 136 |
| 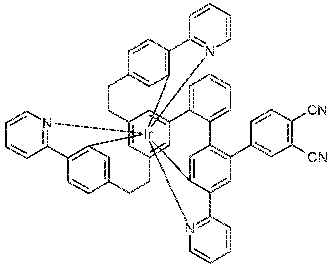 | 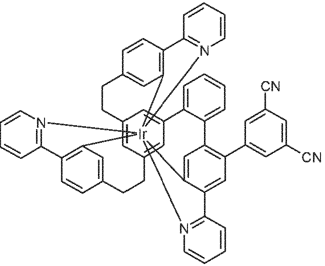 |
| 137 | 138 |
| 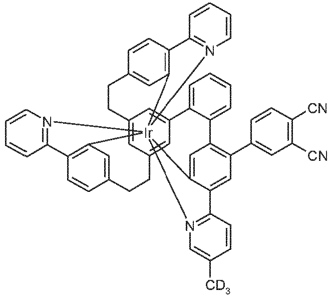 | 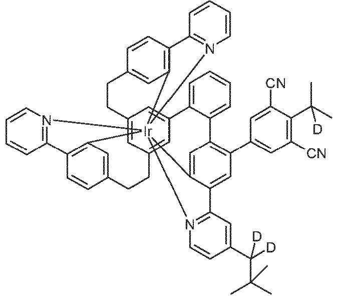 |
| 139 | 140 |
| 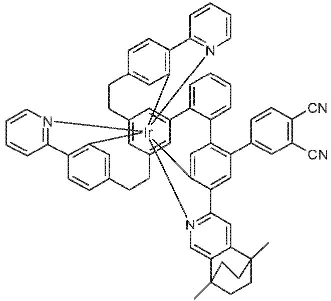 | 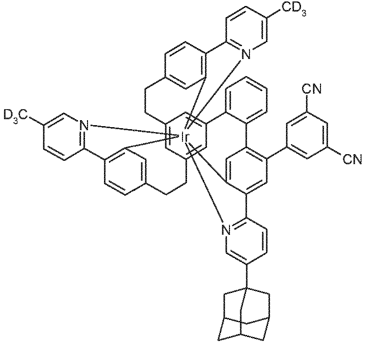 |
| 141 | 142 |
| 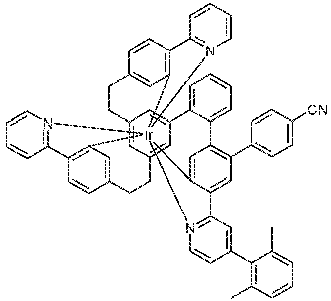 | 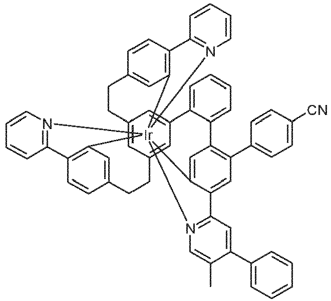 |
| 143 | 144 |
| 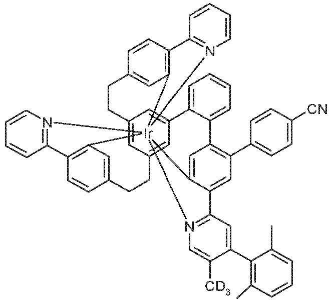 | 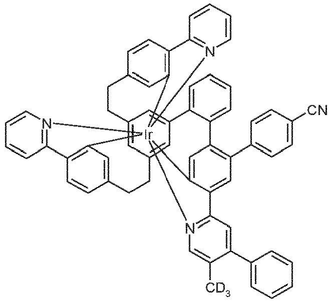 |
| 145 | 146 |
| 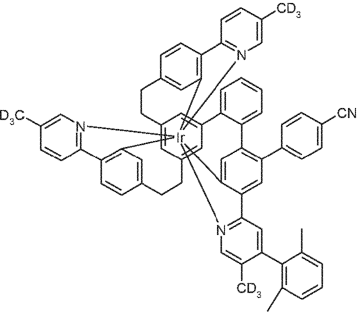 | 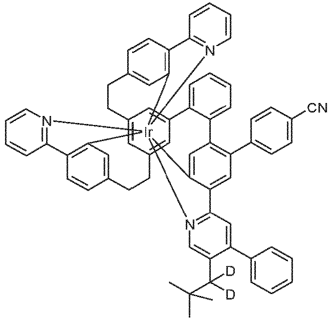 |
| 147 | 148 |
| 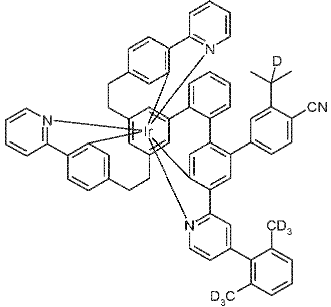 | 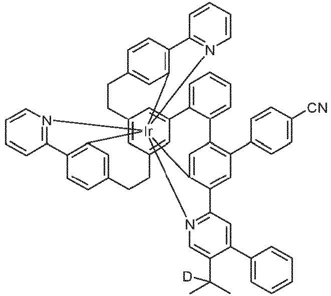 |
| 149 | 150 |
| 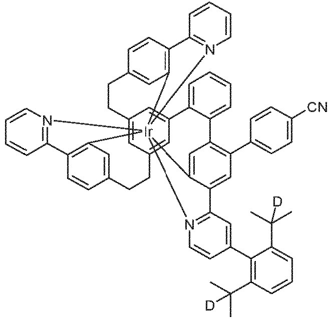 | 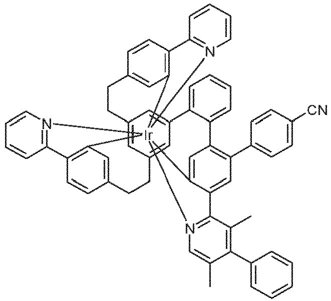 |
| 151 | 152 |
| 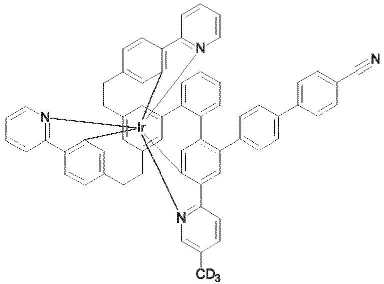 | 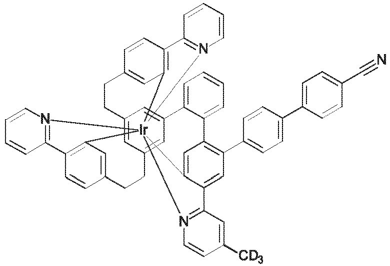 |
| 153 | 154 |
| 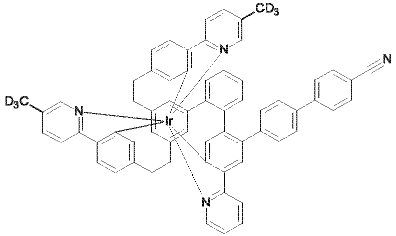 | 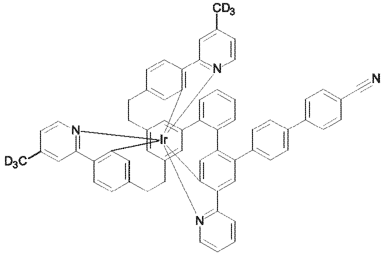 |
| 155 | 156 |
| 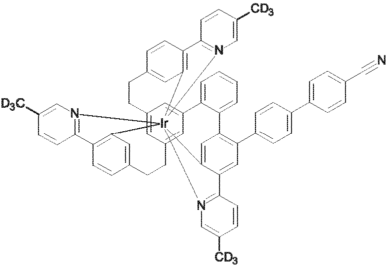 | 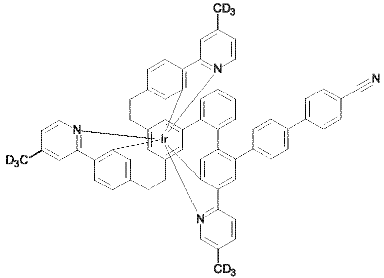 |
| 157 | 158 |
| 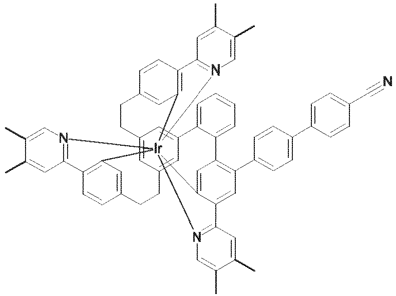 | 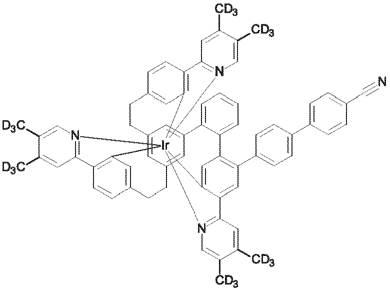 |
| 159 | 160 |
| 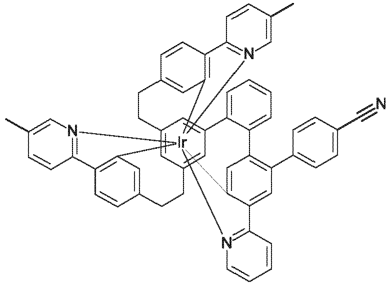 | 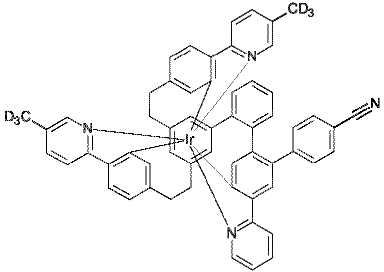 |
| 161 | 162 |
| 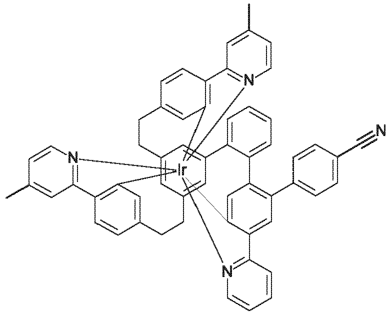 | 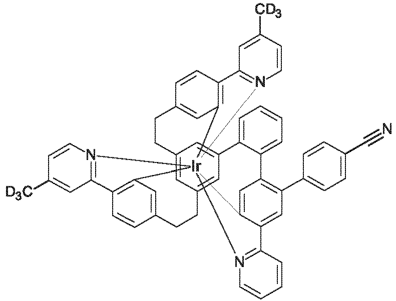 |
| 163 | 164 |
| 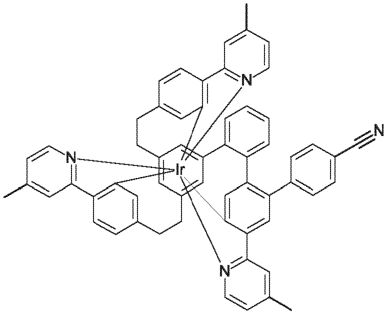 | 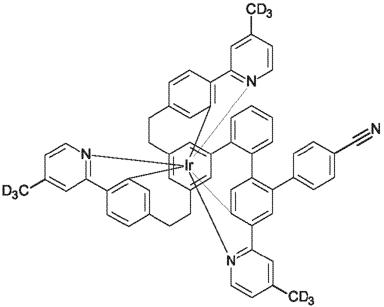 |
| 165 | 166 |
| 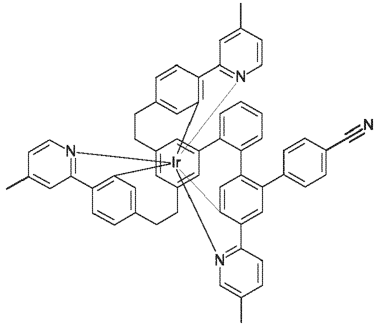 | 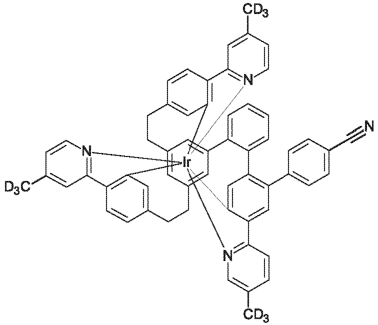 |
| 167 | 167 |

Bei den erfindungsgemäßen Metallkomplexen handelt es sich um chirale Strukturen. Wenn zusätzlich auch der Ligand L chiral ist, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate, wie auch die einzelnen isolierten Diastereomere bzw. Enantiomere.

Werden in der ortho-Metallierung Liganden mit zwei identischen Teilliganden eingesetzt, fällt üblicherweise ein racemisches Gemisch der C₁-symmetrischen Komplexe, also des Δ- und des A-Enantiomers, an. Diese können durch gängige Methoden (Chromatographie an chiralen Materialien / Säulen oder Racemattrennung durch Kristallisation) getrennt werden, wie im Folgenden Schema dargestellt:

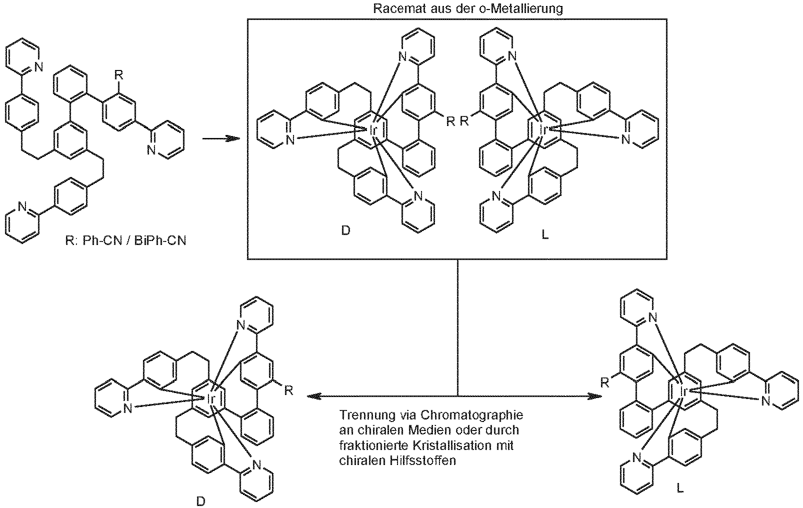

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie im Folgenden schematisch dargestellt:

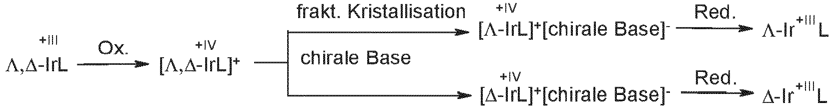

Daneben ist eine enantiomerenreine bzw. enantiomerenanreichernde Synthese durch Komplexierung in einem chiralen Medium (z. B. R- oder S-1,1-Binaphthol) möglich.

Werden in der Komplexierung Liganden mit drei unterschiedlichen Teilliganden eingesetzt, fällt üblicherweise ein Diastereomerengemisch der Komplexe an, das durch gängige Methoden (Chromatographie, Kristallisation, etc.) getrennt werden kann.

Enantiomerenreine C₁-symmetrische Komplexe können auch gezielt synthetisiert werden, wie im folgenden Schema dargestellt. Dazu wird ein enantiomerenreiner, C₁-symmetrischer Ligand dargestellt, komplexiert, das erhaltene Diasteroemerengemisch wird getrennt und anschließend wird die chirale Gruppe abgespalten.

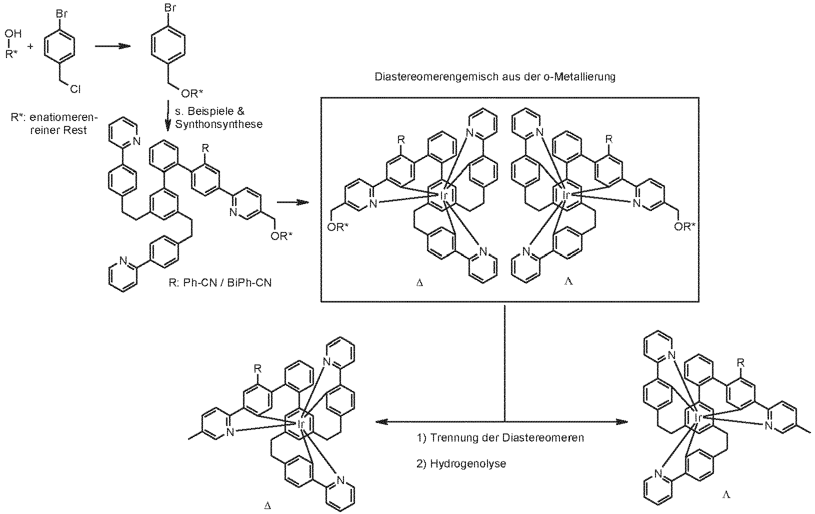

Die erfindungsgemäßen Verbindungen sind prinzipiell durch verschiedene Verfahren darstellbar. Generell wird hierzu ein Iridiumsalz mit dem entsprechenden freien Liganden umgesetzt.

Daher ist ein weiterer Gegenstand der vorliegenden Erfindung ein Verfahren zur Herstellung der erfindungsgemäßen Verbindungen durch Umsetzung der entsprechenden freien Liganden mit Iridiumalkoholaten der Formel (Ir-1), mit Iridiumketoketonaten der Formel (Ir-2), mit Iridiumhalogeniden der Formel (Ir-3) oder mit Iridiumcarboxylaten der Formel (Ir-4),

Ir(OR)₃ (Ir-1)

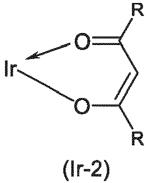

IrHaI₃ (Ir-3)

Ir(OOCR)₃ (Ir-4)

wobei R die oben angegebenen Bedeutungen hat, Hal = F, Cl, Br oder I ist und die Iridiumedukte auch als die entsprechenden Hydrate vorliegen können. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Besonders geeignet ist auch die Synthese in einer organischen Säure oder einer Mischung aus einer organischen Säure und einem organischen Lösemittel, wie in der noch nicht offen gelegten Anmeldung EP19187468.4 beschrieben, wobei besonders geeignete Reaktionsmedien beispielsweise Essigsäure oder eine Mischung aus Salicylsäure und einem organischen Lösemittel, beispielsweise Mesitylen, sind. Dabei kann die Synthese auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können auch Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, Isochinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bisphenoxybenzol, Triphenylphosphinoxid, 18-Krone-6, Phenol, 1-Naphthol, Hydrochinon, etc.. Dabei ist die Verwendung von Hydrochinon besonders bevorzugt.

Alternativ ist es auch möglich, zunächst den Komplex zu synthetisieren, der statt der Cyanophenyl- bzw. Cyanobiphenylgruppe eine reaktive Abgangsgruppe, beispielsweise Cl, Br, I oder ein Boronsäurederivat, enthält, zu synthetisieren und in einem nächsten Schritt die Cyanophenyl- bzw. Cyanobiphenylgruppe durch eine Kupplungsreaktion, beispielsweise eine Suzuki-Kupplung, einzuführen.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Für die Verarbeitung der erfindungsgemäßen Iridiumkomplexe aus flüssiger Phase, beispielsweise durch Spin-Coating oder durch Druckverfahren, sind Formulierungen der erfindungsgemäßen Iridiumkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäßen Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in einer elektronischen Vorrichtung als aktive Komponente, bevorzugt als Emitter in der emissiven Schicht einer organischen Elektrolumineszenzvorrichtung verwendet werden. Ein weiterer Gegenstand der vorliegenden Erfindung ist somit die Verwendung der erfindungsgemäßen Verbindungen in einer elektronischen Vorrichtung, insbesondere in einer organischen Elektrolumineszenzvorrichtung.

Nochmals ein weiterer Gegenstand der vorliegenden Erfindung ist eine elektronische Vorrichtung enthaltend mindestens eine erfindungsgemäße Verbindung, insbesondere eine organische Elektrolumineszenzvorrichtung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Iridiumkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Verbindungen, die im Infraroten emittieren, eignen sich für den Einsatz in organischen Infrarot-Elektrolumineszenzvorrichtungen und Infrorot-Sensoren. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit LewisSäuren, oder mit Boranen (z. B. gemäß US 2003/0006411, WO 2002/051850, WO 2015/049030) oder mit Carboxylaten der Elemente der 3. , 4. oder 5. Hauptgruppe (WO 2015/018539) und/oder dass eine oder mehrere Elektronentransportschichten n-dotiert sind.

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine bevorzugte Ausführungsform sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung die erfindungsgemäßen Verbindung als emittierende Verbindung in einer oder mehreren emittierenden Schichten.

Wenn die erfindungsgemäße Verbindung als emittierende Verbindung in einer emittierenden Schicht eingesetzt wird, wird er bevorzugt in Kombination mit einem oder mehreren Matrixmaterialien eingesetzt. Die Mischung aus der erfindungsgemäßen Verbindung und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der erfindungsgemäßen Verbindung bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877. Für lösungsprozessierte OLEDs eignen sich als Matrixmaterialien auch Polymere, z. B. gemäß WO 2012/008550 oder WO 2012/048778, Oligomere oder Dendrimere, z. B. gemäß Journal of Luminescence 183 (2017), 150-158.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats, eines Pyrimidin-Derivats, eines Phosphinoxid-Derivats oder eines aromatischen Lactams mit einem Triarylamin-Derivat oder einem Carbazol-Derivat als gemischte Matrix für die erfindungsgemäße Verbindung. Ebenso bevorzugt ist die Verwendung einer Mischung aus einem ladungstransportierenden Matrixmaterial und einem elektrisch inerten Matrixmaterial (so genannter "wide bandgap host"), welches nicht bzw. nicht in wesentlichem Maße am Ladungstransport beteiligt ist, wie z. B. in WO 2010/108579 oder WO 2016/184540 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben. Nachfolgend sind Beispiele für Verbindungen abgebildet, die sich als Matrixmaterialien für die erfindungsgemäßen Verbindungen eignen.

Bevorzugte Biscarbazole, die als Matrixmaterialien für die erfindungsgemäßen Verbindungen eingesetzt werden können, sind die Strukturen der folgenden Formeln (10) und (11), 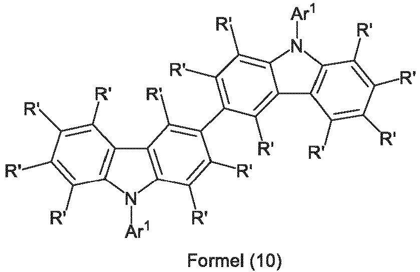 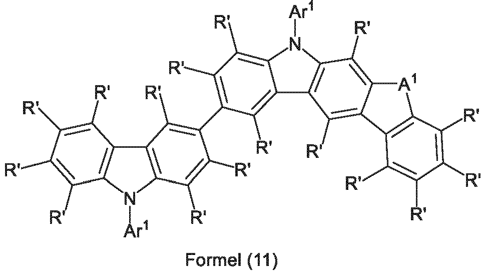 wobei für die verwendeten Symbole gilt:
- Ar¹: ist gleich oder verschieden bei jedem Auftreten ein aromatisches oder heteroaromatisches Ringsystem mit 5 bis 40 aromatischen Ring-atomen, bevorzugt mit 6 bis 30 aromatischen Ringatomen, besonders bevorzugt mit 6 bis 24 aromatischen Ringatomen, welches jeweils mit einem oder mehreren Resten R', bevorzugt nicht-aromatischen Resten R', substituiert sein kann;
- A¹: ist NAr¹, C(R')₂, O oder S, bevorzugt C(R')₂;
- R': ist gleich oder verschieden bei jedem Auftreten H, D, F, CN, eine Alkylgruppe mit 1 bis 10 C-Atomen, bevorzugt mit 1 bis 4 C-Atomen, oder ein aromatisches oder heteroaromatisches Ringsystem mit 5 bis 40 aromatischen Ringatomen, bevorzugt mit 6 bis 30 aromatischen Ringatomen, besonders bevorzugt mit 6 bis 24 aromatischen Ring-atomen, welches mit einem oder mehreren Substituenten, ausgewählt aus der Gruppe bestehend aus D, F, CN oder einer Alkylgruppe mit 1 bis 10 C-Atomen, bevorzugt mit 1 bis 4 C-Atomen, substituiert sein kann.

Bevorzugte Ausführungsformen der Verbindungen der Formeln (10) bzw. (11) sind die Verbindungen der folgenden Formeln (10a) bzw. (11a), 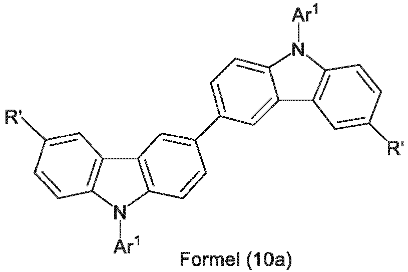 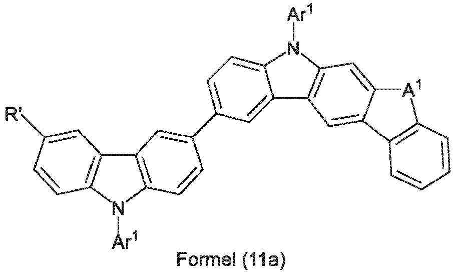 wobei die verwendeten Symbole die oben genannten Bedeutungen aufweisen.

Bevorzugte Dibenzofuran-Derivate sind die Verbindungen der folgenden Formel (12), 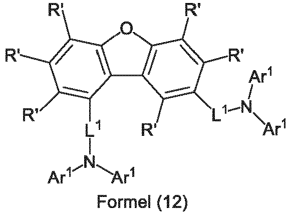 wobei der Sauerstoff auch durch Schwefel ersetzt sein kann, so dass ein Dibenzothiophen entsteht, L¹ für eine Einfachbindung oder ein aromatisches oder heteroaromatisches Ringsystem mit 5 bis 30 aromatischen Ringatomen, bevorzugt mit 6 bis 24 aromatischen Ringatomen steht, welches auch durch einen oder mehrere Reste R' substituiert sein kann, bevorzugt aber unsubstituiert ist, und R' und Ar¹ die oben genannten Bedeutungen aufweisen. Dabei können die beiden Gruppen Ar¹, die an dasselbe Stickstoffatom binden, oder eine Gruppe Ar¹ und eine Gruppe L, die an dasselbe Stickstoffatom binden, auch miteinander verbunden sein, beispielsweise zu einem Carbazol.

Bevorzugte Carbazolamine sind die Strukturen der folgenden Formeln (13), (14) und (15), 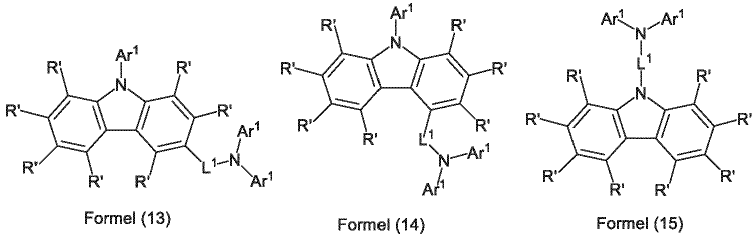 wobei L¹, R' und Ar¹ die oben genannten Bedeutungen aufweisen.

Beispiele für geeignete lochleitende Matrixmaterialien sind die in der folgenden Tabelle abgebildeten Verbindungen.

| | | |
|---|---|---|
| 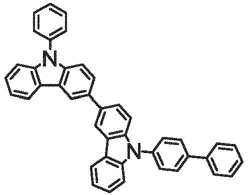 | 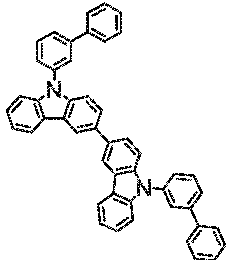 | 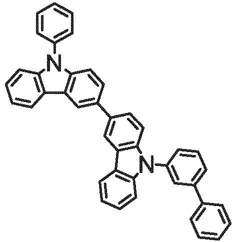 |
| H1 | H2 | H3 |
| 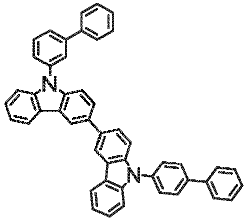 | 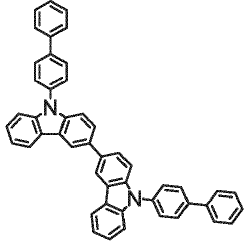 | 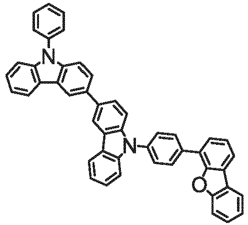 |
| H4 | H5 | H6 |
| 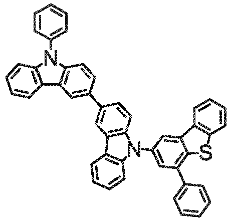 | 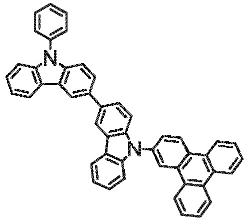 | 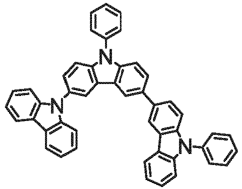 |
| H7 | H8 | H9 |
| 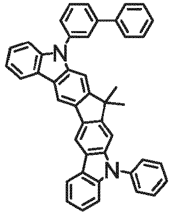 | 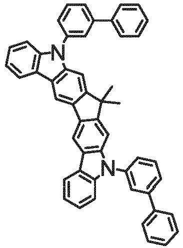 | 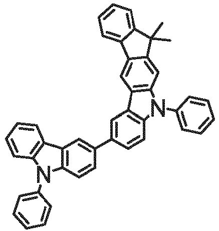 |
| H10 | H11 | H12 |
| 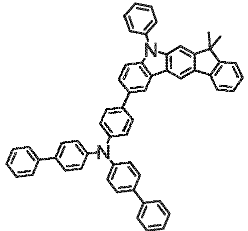 | 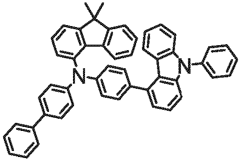 | 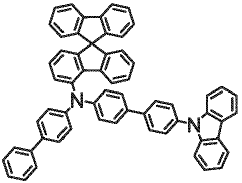 |
| H13 | H14 | H15 |
| 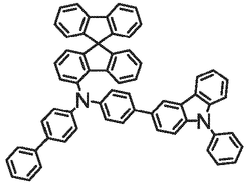 | 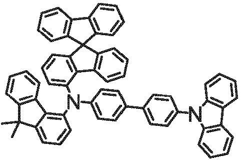 | 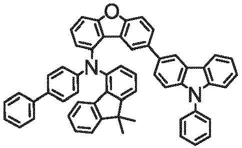 |
| H16 | H17 | H18 |
| 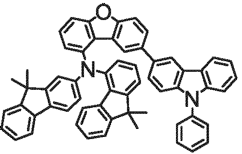 | 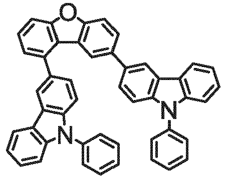 | 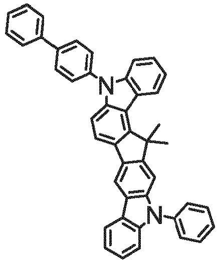 |
| H19 | H20 | H21 |
| 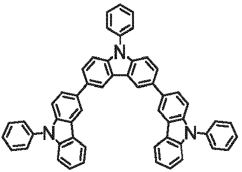 | 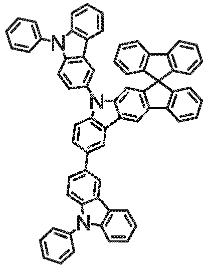 | 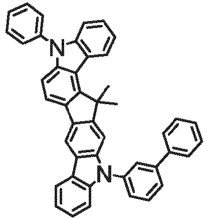 |
| H22 | H23 | H24 |
| 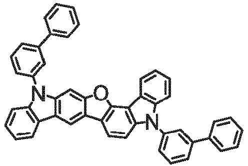 | 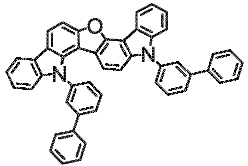 | 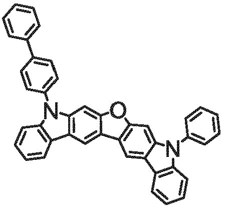 |
| H25 | H26 | H27 |
| 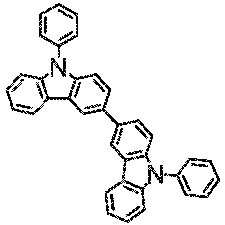 | 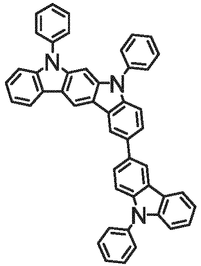 | 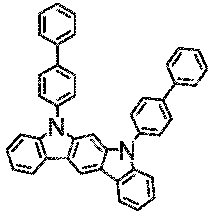 |
| H28 | H29 | H30 |
| 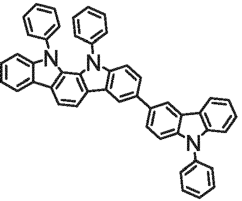 | 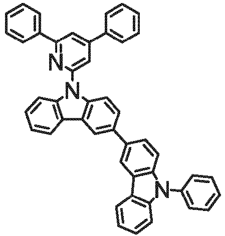 | 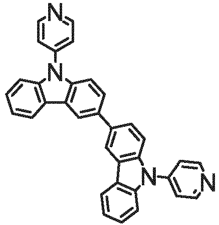 |
| H31 | H32 | H33 |
| 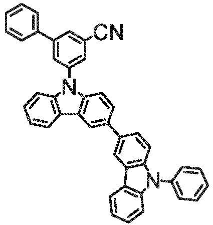 | 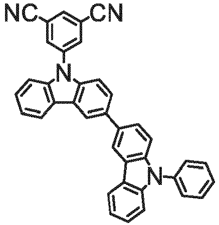 | 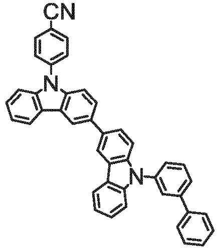 |
| H34 | H35 | H36 |
| 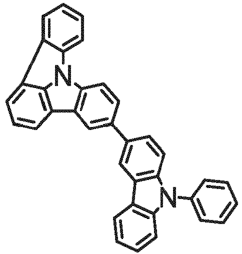 | 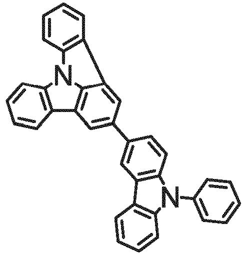 | 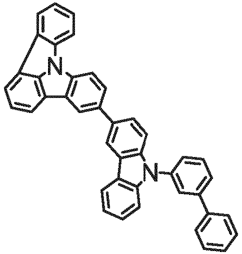 |
| H37 | H38 | H39 |
| 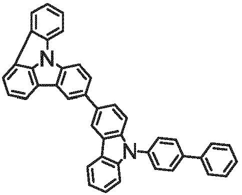 | 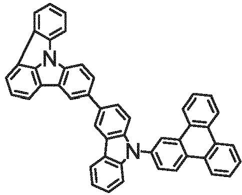 | 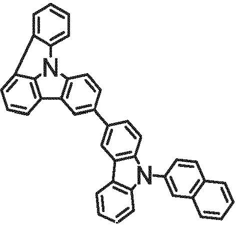 |
| H40 | H41 | H42 |
| 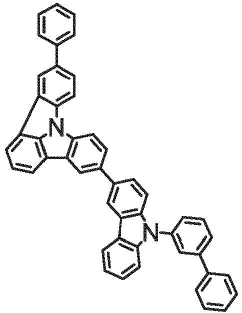 | 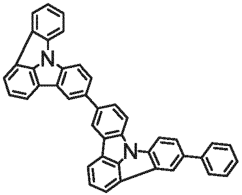 | 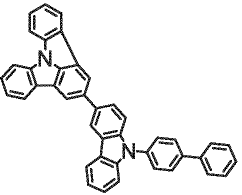 |
| H43 | H44 | H45 |
| 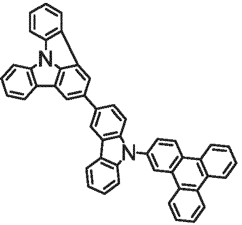 | 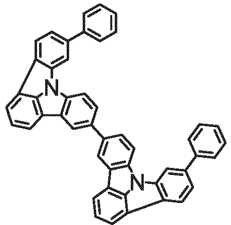 | 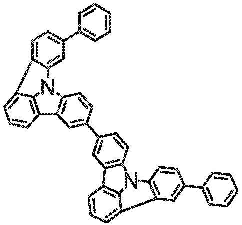 |
| H46 | H47 | H48 |
| 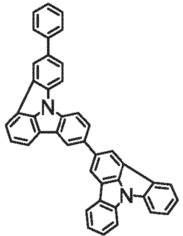 | 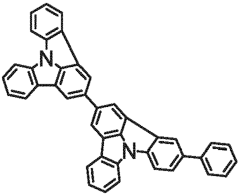 | 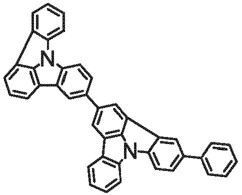 |
| H49 | H50 | H51 |
| 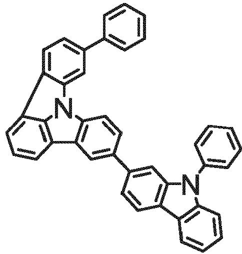 | 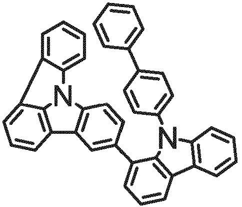 | 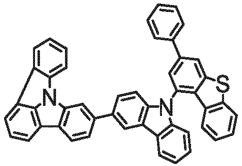 |
| H52 | H53 | H54 |
| 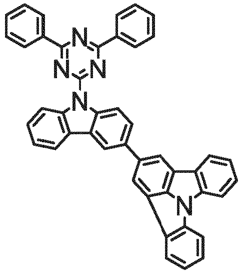 | 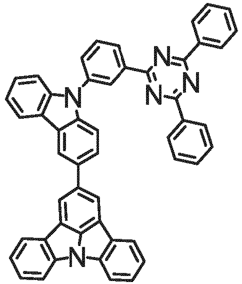 | 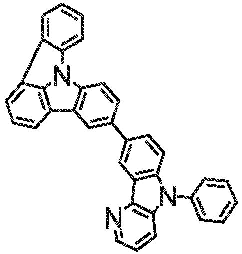 |
| H55 | H56 | H57 |

Bevorzugte Triazin- bzw. Pyrimidinderivate, welche als Mischung zusammen mit den erfindungsgemäßen Verbindungen eingesetzt werden können, sind die Verbindungen der folgenden Formeln (16) und (17), 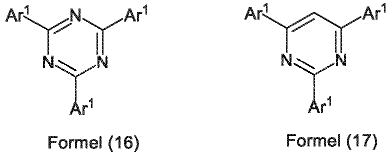 wobei Ar¹ die oben genannten Bedeutungen aufweist.

Besonders bevorzugt sind die Triazinderivate der Formel (16).

In einer bevorzugten Ausführungsform der Erfindung ist Ar¹ in den Formeln (16) und (17) bei jedem Auftreten gleich oder verschieden ein aromatisches oder heteroaromatisches Ringsystem mit 6 bis 30 aromatischen Ringatomen, insbesondere mit 6 bis 24 aromatischen Ringatomen, das durch einen oder mehrere Reste R' substituiert sein kann.

Beispiele für geeignete elektronentransportierende Verbindungen, welche als Matrixmaterialien zusammen mit den erfindungsgemäßen Verbindungen eingesetzt werden können, sind die in der folgenden Tabelle abgebildeten Verbindungen.

| | | |
|---|---|---|
| 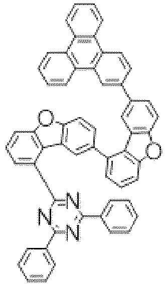 | 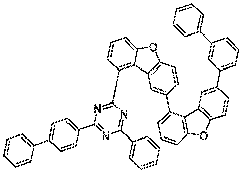 | 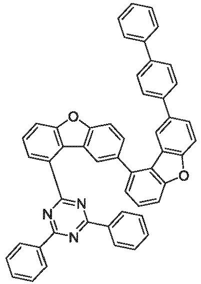 |
| E1 | E2 | E3 |
| 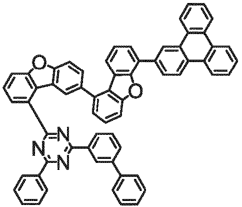 | 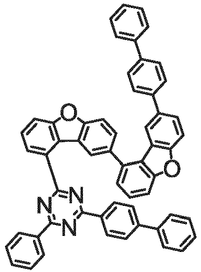 | 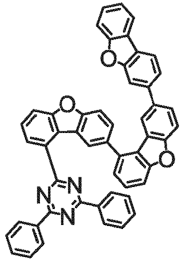 |
| E4 | E5 | E6 |
| 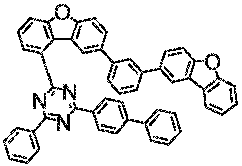 | 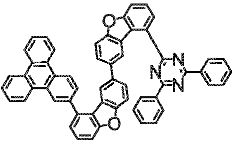 | 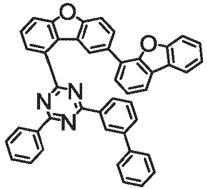 |
| E7 | E8 | E9 |
| 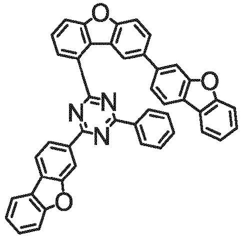 | 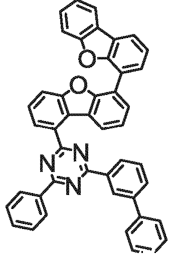 | 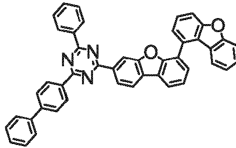 |
| E10 | E11 | E12 |
| 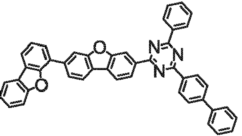 | 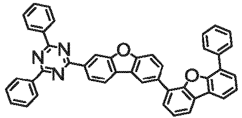 | 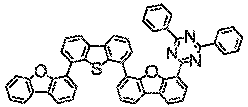 |
| E13 | E14 | E15 |
| 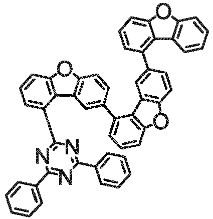 | 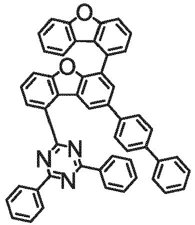 | 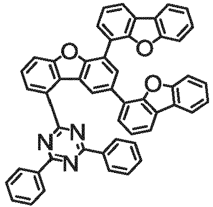 |
| E16 | E17 | E18 |
| 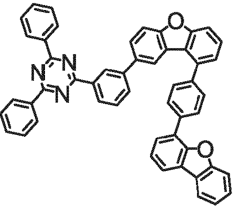 | 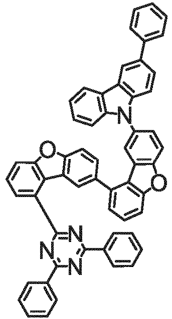 | 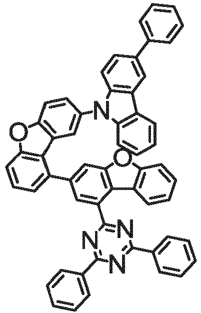 |
| E19 | E20 | E21 |
| 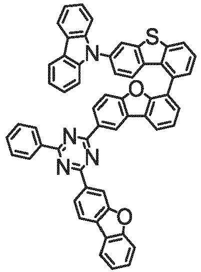 | 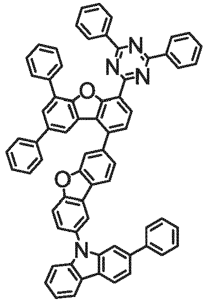 | 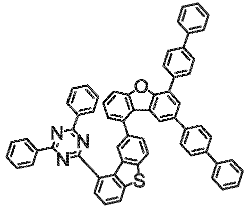 |
| E22 | E23 | E24 |
| 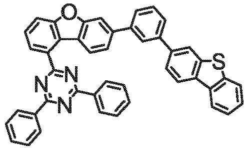 | 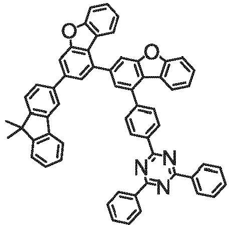 | 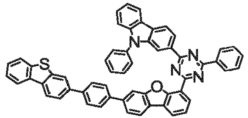 |
| E25 | E26 | E27 |
| 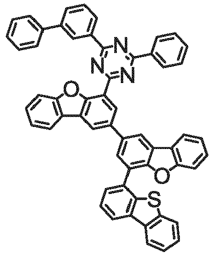 | 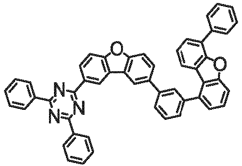 | 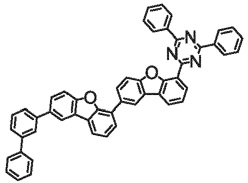 |
| E28 | E29 | E30 |
| 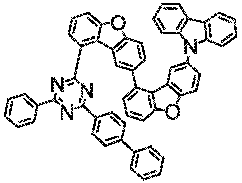 | 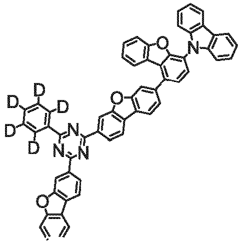 | 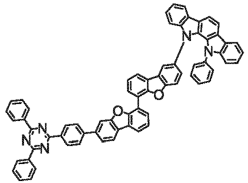 |
| E31 | E32 | E33 |
| 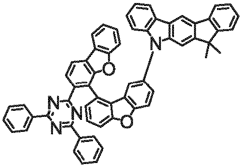 | 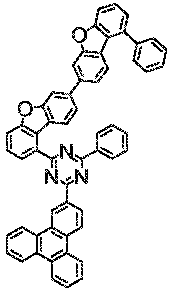 | 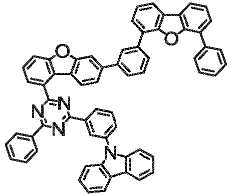 |
| E34 | E35 | E36 |
| 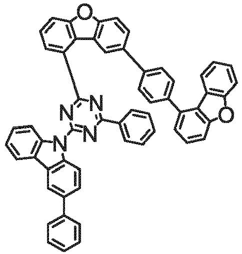 | 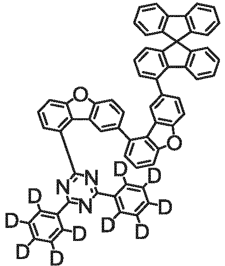 | 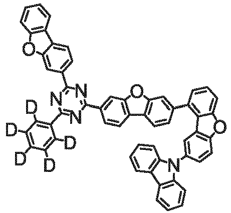 |
| E37 | E38 | E39 |
| 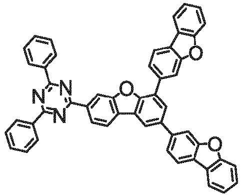 | 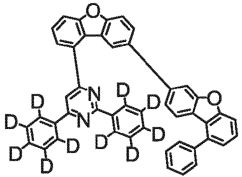 | 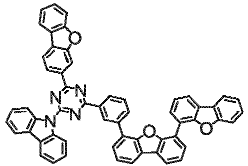 |
| E40 | E41 | E42 |
| 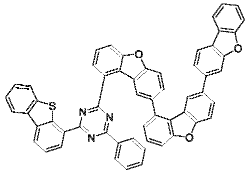 | 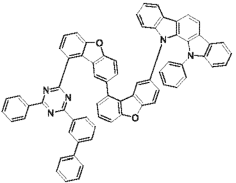 | 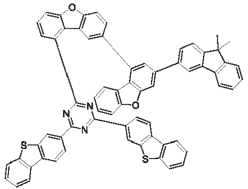 |
| E43 | E44 | E45 |
| 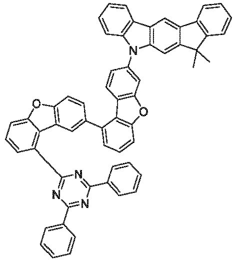 | 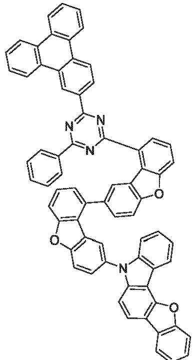 | 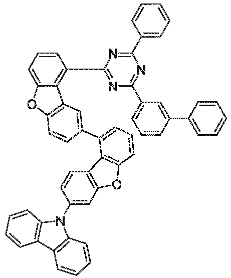 |
| E46 | E47 | E48 |
| 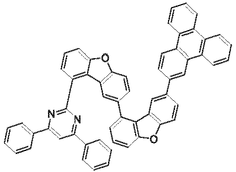 | 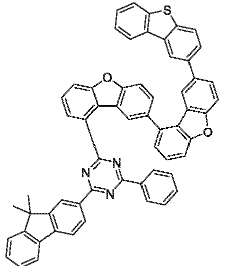 | 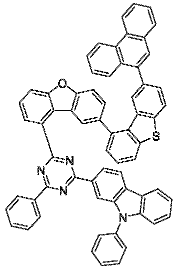 |
| E49 | E50 | E51 |
| 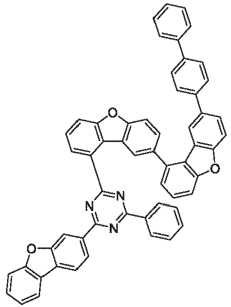 | 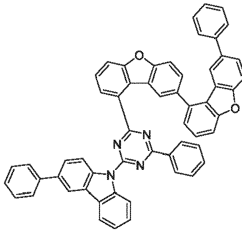 | 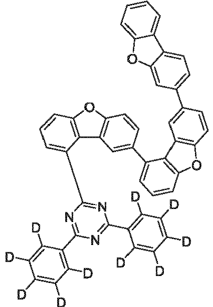 |
| E52 | E53 | E54 |
| 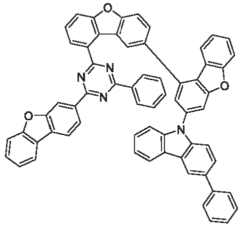 | 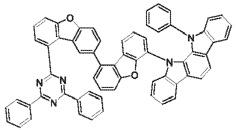 | 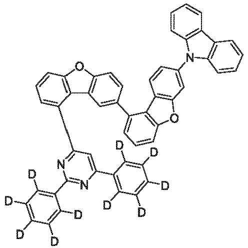 |
| E55 | E56 | E57 |
| 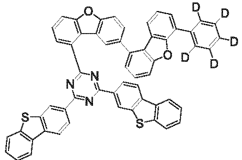 | 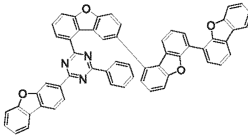 | 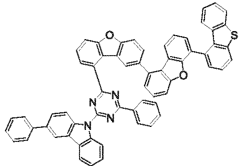 |
| E58 | E59 | E60 |
| 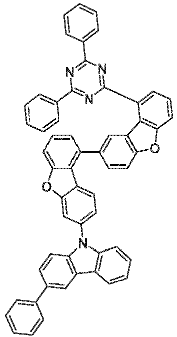 | 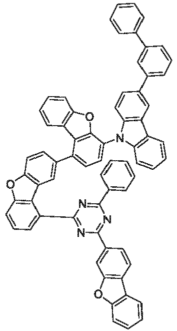 | 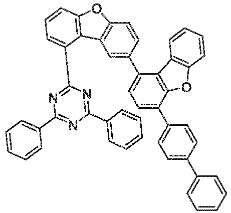 |
| E61 | E62 | E63 |
| 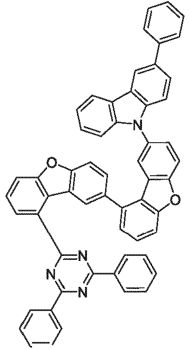 | 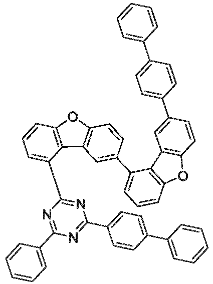 | 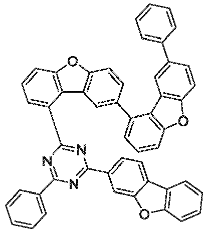 |
| E64 | E65 | E66 |
| 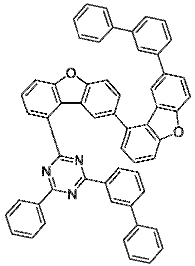 | 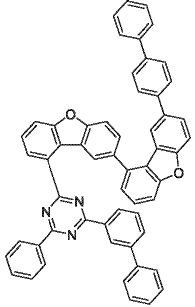 | 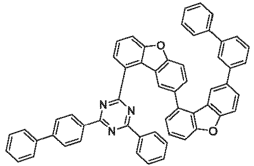 |
| E67 | E68 | E69 |
| 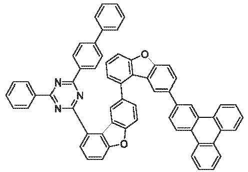 | 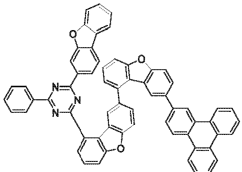 | 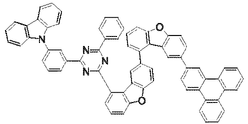 |
| E70 | E71 | E72 |
| 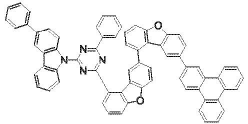 | 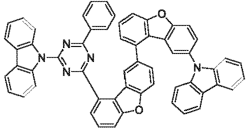 | 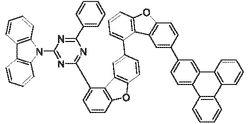 |
| E73 | E74 | E75 |
| 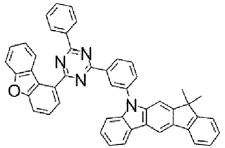 | 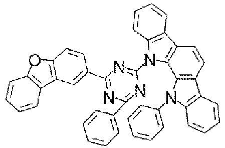 | 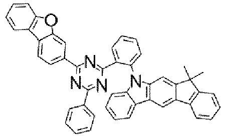 |
| E76 | E77 | E78 |
| 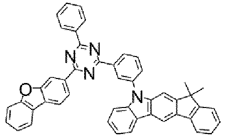 | 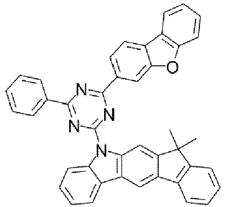 | 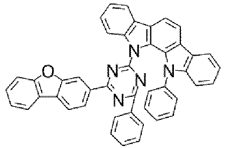 |
| E79 | E80 | E81 |
| 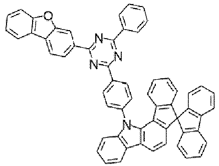 | 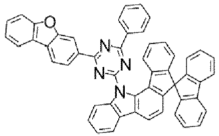 | 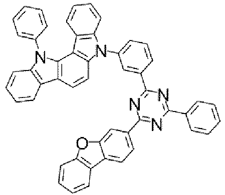 |
| E81 | E82 | E83 |
| 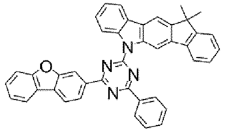 | 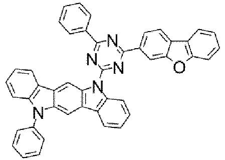 | 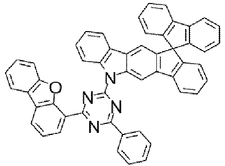 |
| E84 | E85 | E86 |
| 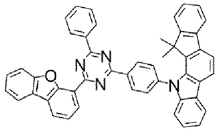 | 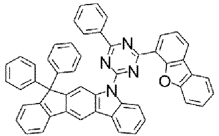 | 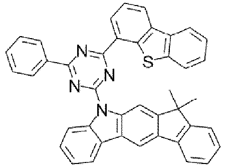 |
| E87 | E88 | E89 |
| 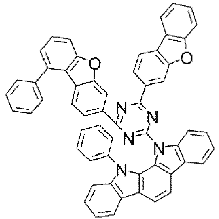 | 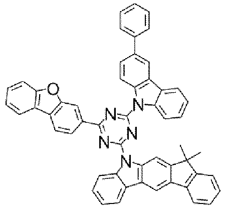 | 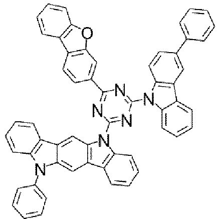 |
| E90 | E91 | E92 |
| 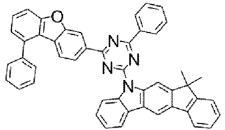 | 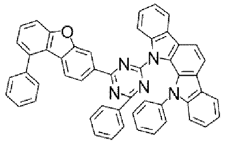 | 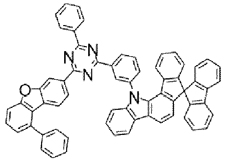 |
| E93 | E94 | E95 |
| 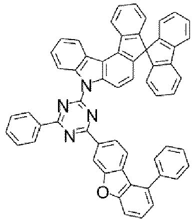 | 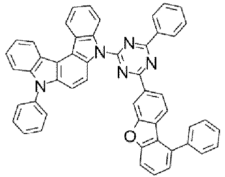 | 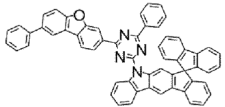 |
| E96 | E97 | E98 |
| 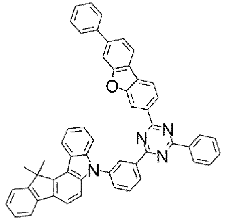 | 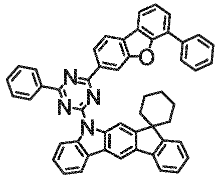 | 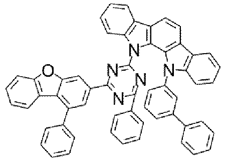 |
| E99 | E100 | E101 |
| 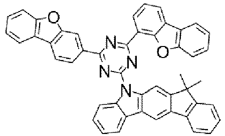 | 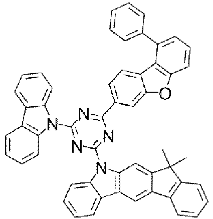 | 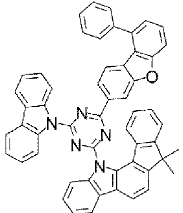 |
| E102 | E103 | E104 |
| 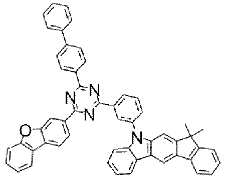 | 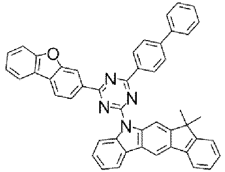 | 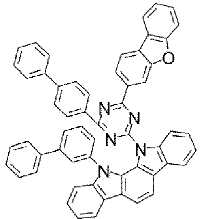 |
| E105 | E106 | E107 |
| 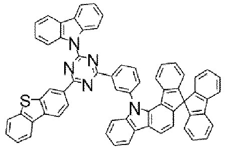 | 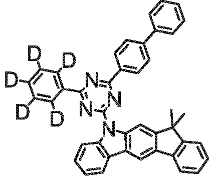 | 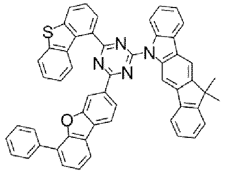 |
| E108 | E109 | E110 |
| 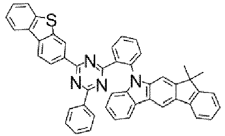 | 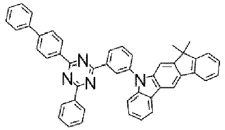 | 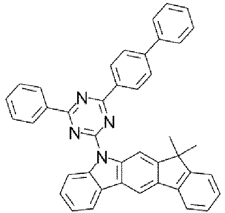 |
| E111 | E112 | E113 |
| 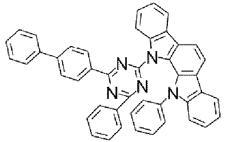 | 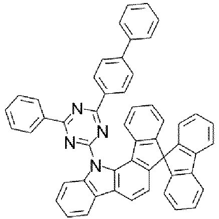 | 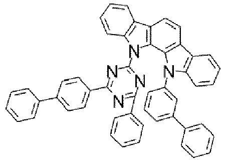 |
| E114 | E115 | E116 |
| 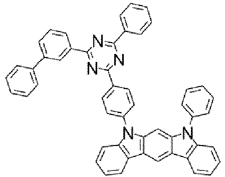 | 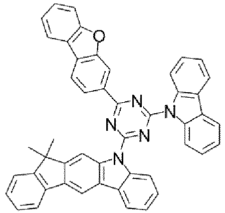 | 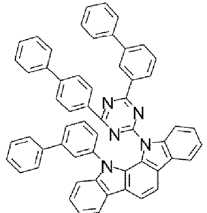 |
| E117 | E118 | E119 |
| 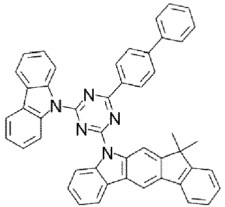 | 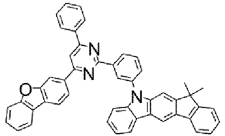 | 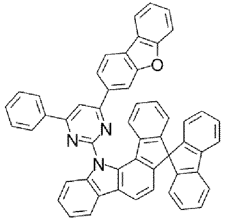 |
| E120 | E121 | E122 |
| 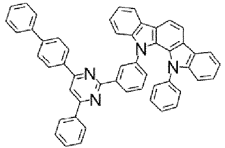 | 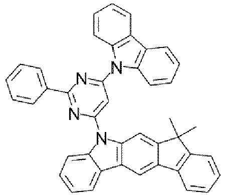 | 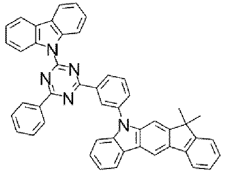 |
| E123 | E124 | E125 |
| 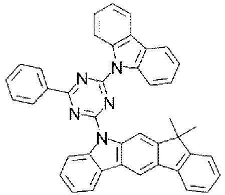 | 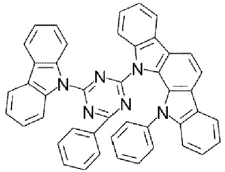 | 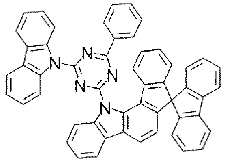 |
| E126 | E127 | E128 |
| 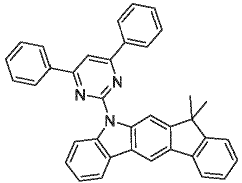 | 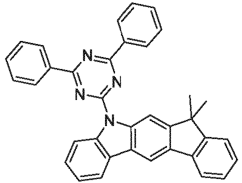 | 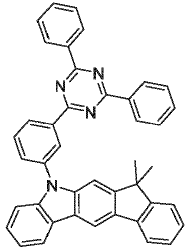 |
| E129 | E130 | E131 |
| 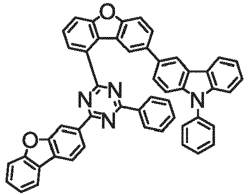 | 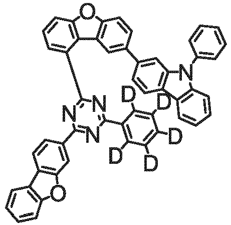 | 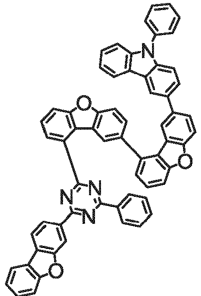 |
| E132 | E133 | E134 |
| 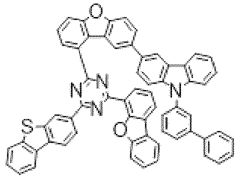 | 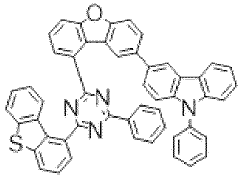 | 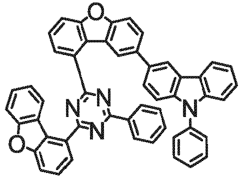 |
| E135 | E136 | E137 |
| 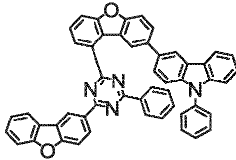 | 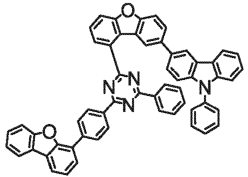 | 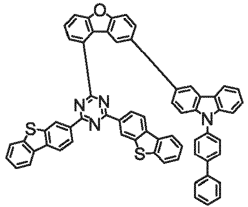 |
| E138 | E139 | E140 |
| 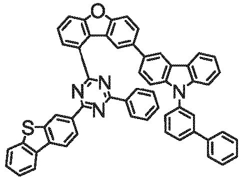 | 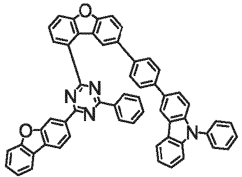 | 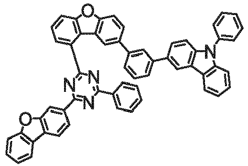 |
| E141 | E142 | E143 |
| 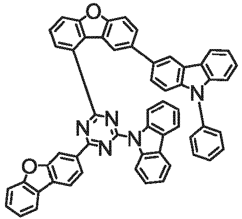 | 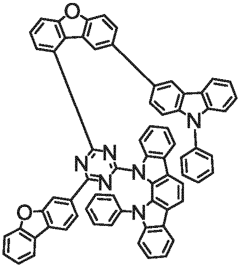 | 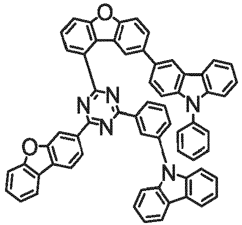 |
| E144 | E145 | E146 |
| 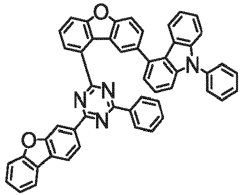 | 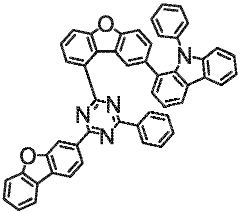 | 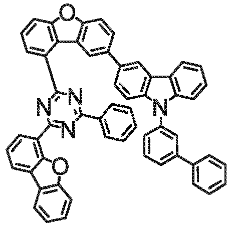 |
| E147 | E148 | E149 |
| 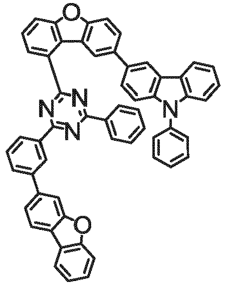 | 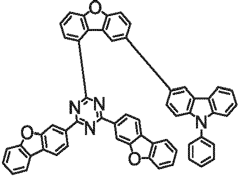 | 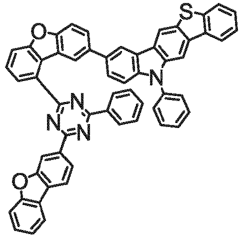 |
| E150 | E151 | E152 |
| 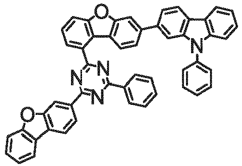 | 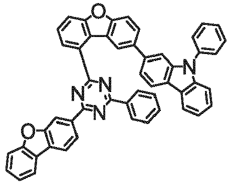 | 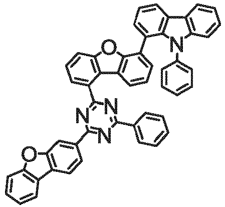 |
| E153 | E154 | E155 |
| 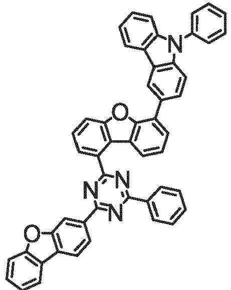 | 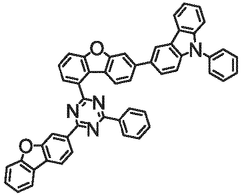 | 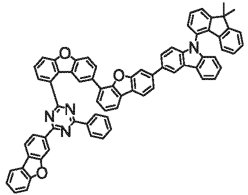 |
| E156 | E157 | E158 |
| 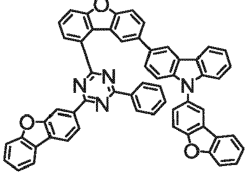 | 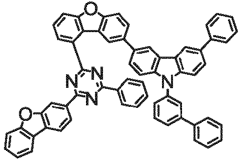 | 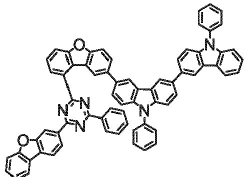 |
| E159 | E160 | E161 |
| 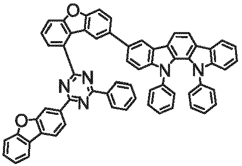 | 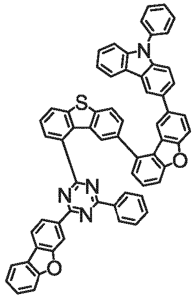 | 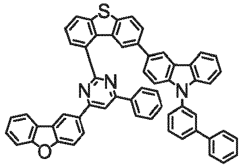 |
| E162 | E163 | E164 |
| 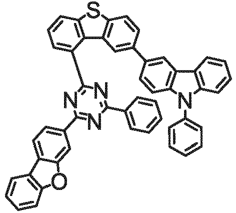 | 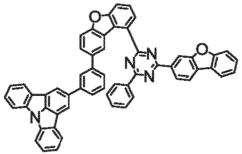 | 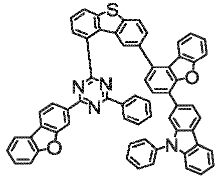 |
| E165 | E166 | E167 |
| 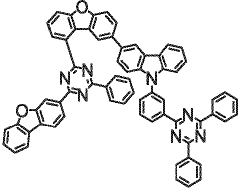 | 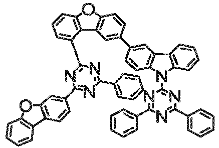 | 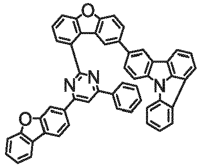 |
| E168 | E169 | E170 |
| 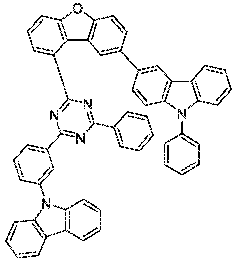 | 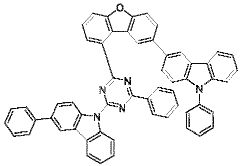 | 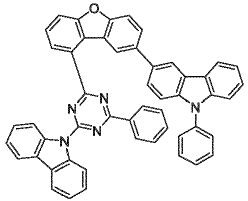 |
| E171 | E172 | E173 |
| 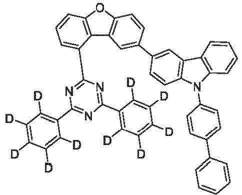 | 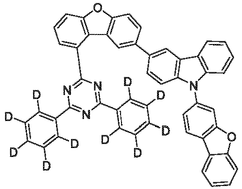 | 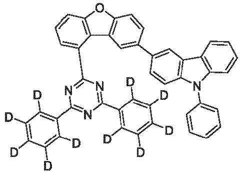 |
| E174 | E175 | E176 |
| 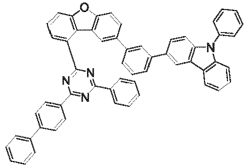 | 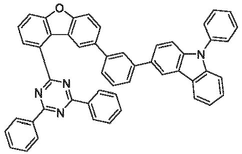 | 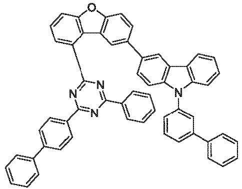 |
| E177 | E178 | E179 |
| 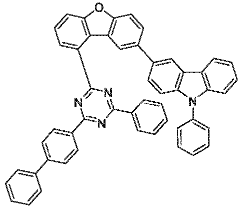 | 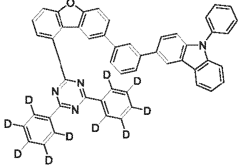 | 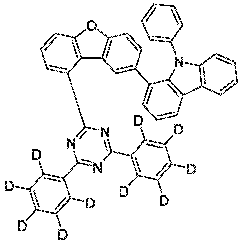 |
| E180 | E181 | E182 |
| 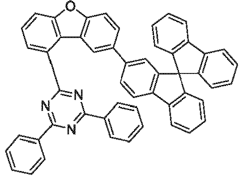 | 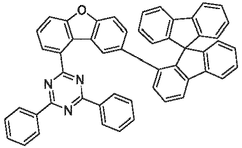 | 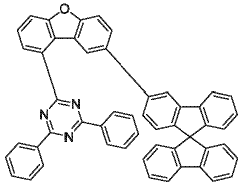 |
| E183 | E184 | E185 |
| 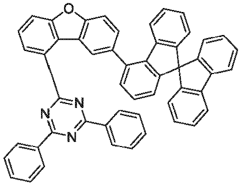 | 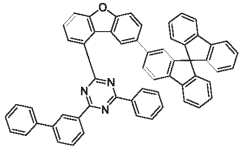 | 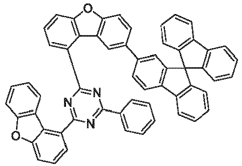 |
| E186 | E187 | E188 |
| 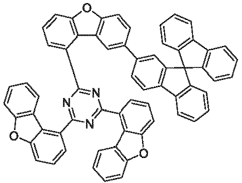 | 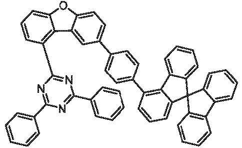 | 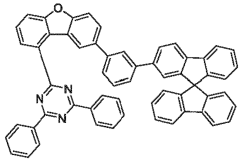 |
| E189 | E190 | E191 |
| 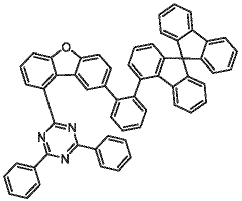 | 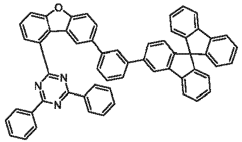 | 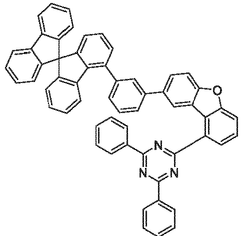 |
| E192 | E193 | E194 |
| 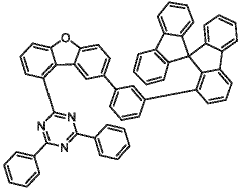 | 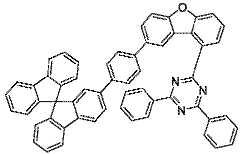 | 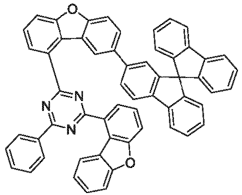 |
| E195 | E196 | E197 |
| 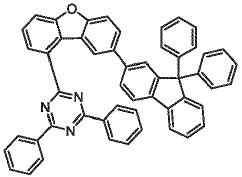 | 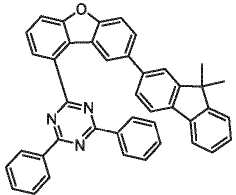 | 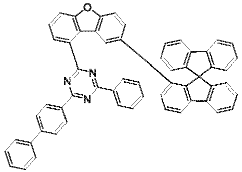 |
| E198 | E199 | E200 |
| 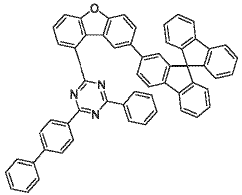 | 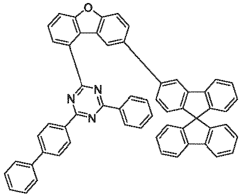 | 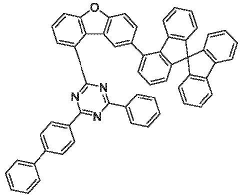 |
| E201 | E202 | E203 |
| 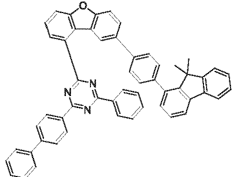 | 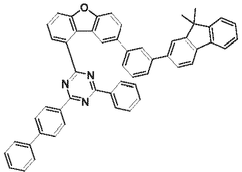 | 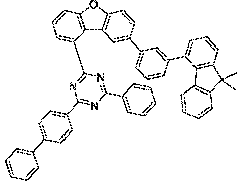 |
| E204 | E205 | E206 |
| 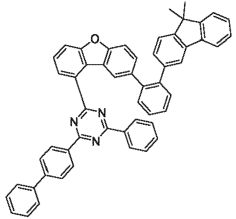 | 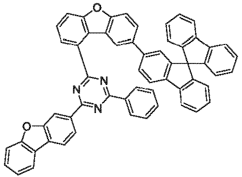 | 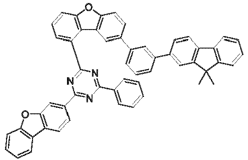 |
| E207 | E208 | E209 |
| 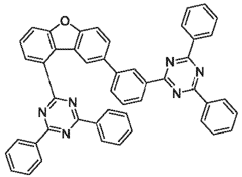 | 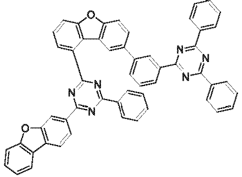 | 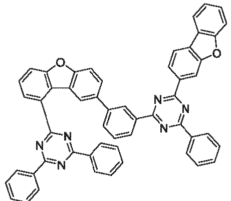 |
| E210 | E211 | E212 |
| 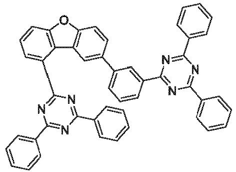 | 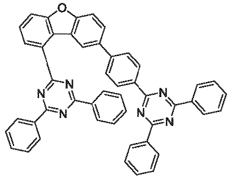 | 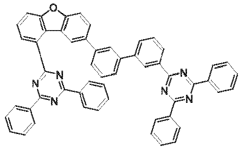 |
| E213 | E214 | E215 |
| 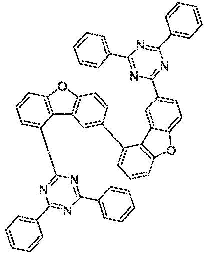 | 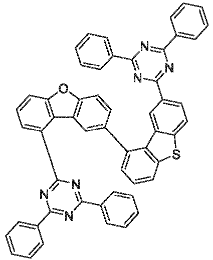 | 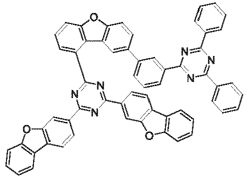 |
| E216 | E217 | E218 |
| 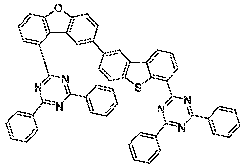 | 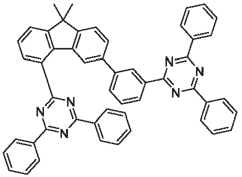 | 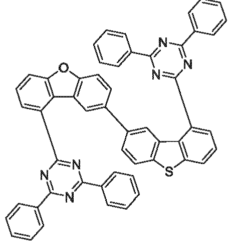 |
| E219 | E220 | E221 |
| 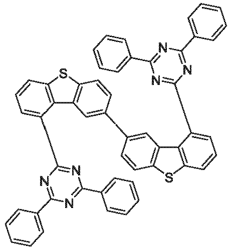 | 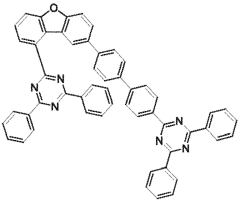 | 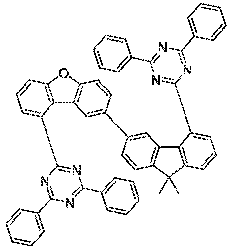 |
| E222 | E223 | E224 |
| 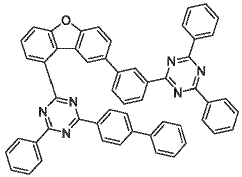 | 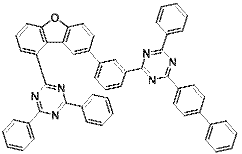 | 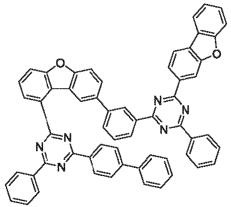 |
| E225 | E226 | E227 |
| 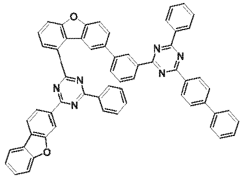 | 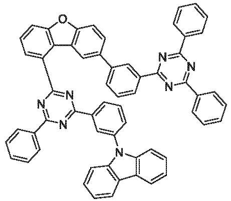 | 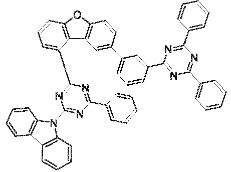 |
| E228 | E229 | E230 |
| 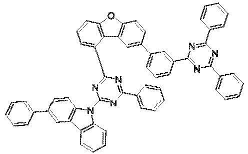 | 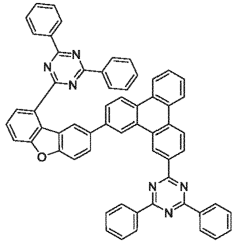 | 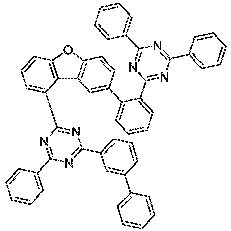 |
| E231 | E232 | E233 |
| 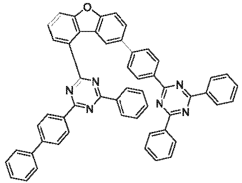 | 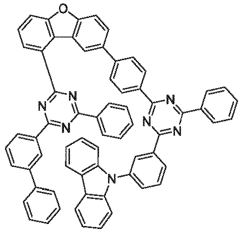 | 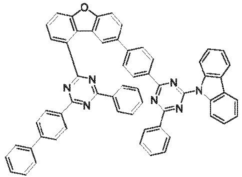 |
| E234 | E235 | E236 |
| 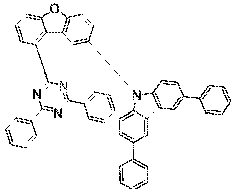 | 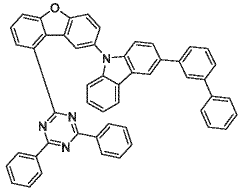 | 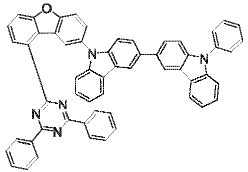 |
| E237 | E238 | E239 |
| 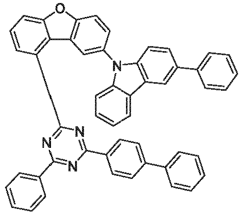 | 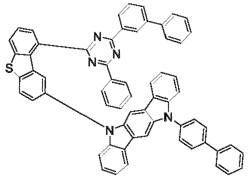 | 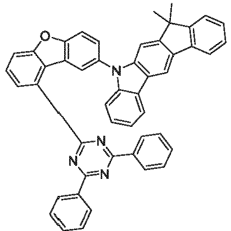 |
| E240 | E241 | E242 |
| 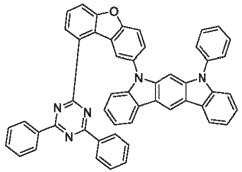 | 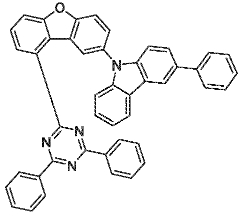 | 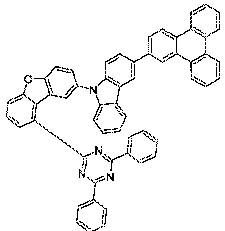 |
| E243 | E244 | E245 |
| 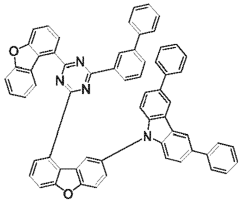 | 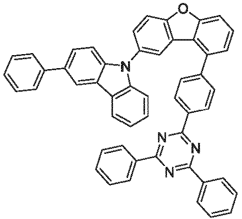 | 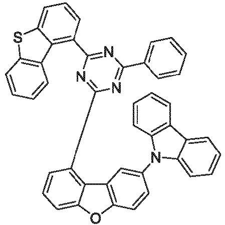 |
| E246 | E247 | E248 |
| 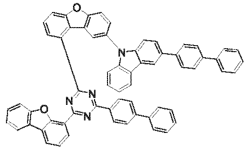 | 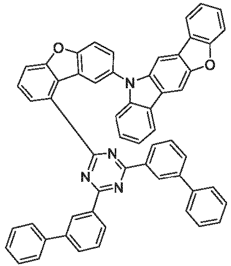 | 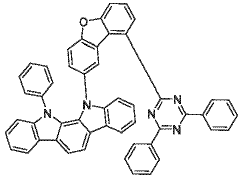 |
| E249 | E250 | E251 |
| 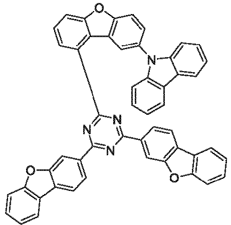 | 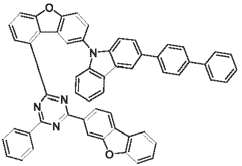 | 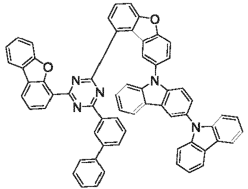 |
| E252 | E253 | E254 |
| 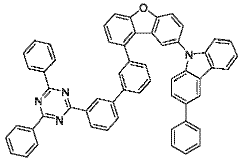 | 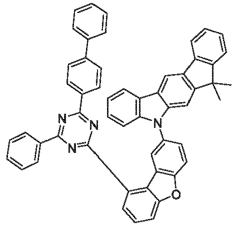 | 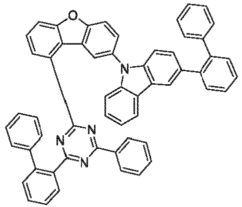 |
| E255 | E256 | E257 |
| 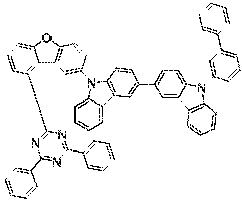 | 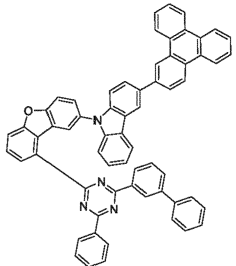 | 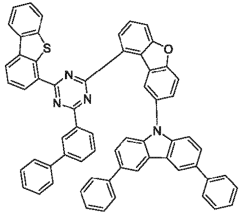 |
| E258 | E259 | E260 |
| 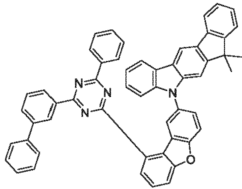 | 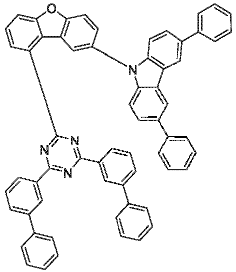 | 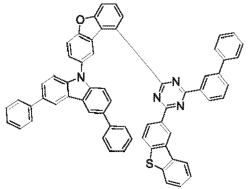 |
| E261 | E262 | E263 |
| 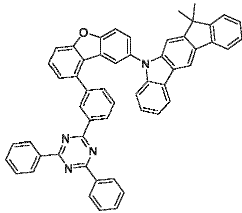 | 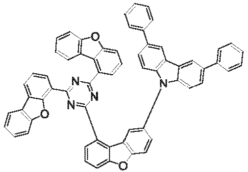 | 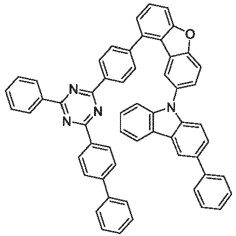 |
| E264 | E265 | E266 |
| 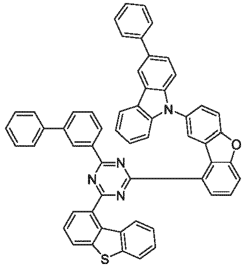 | 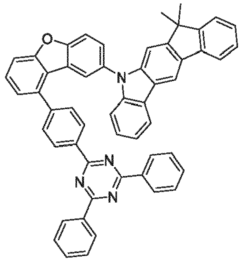 | 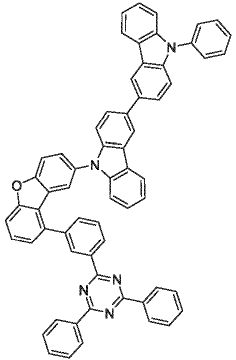 |
| E267 | E268 | E269 |
| 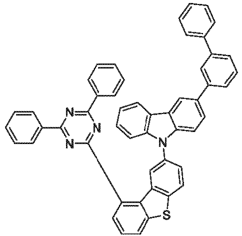 | 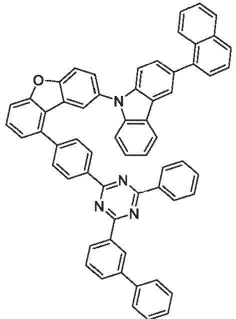 | 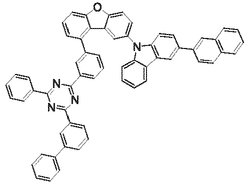 |
| E270 | E271 | E272 |
| 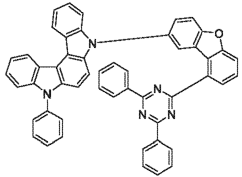 | 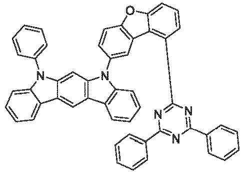 | 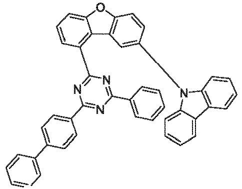 |
| E273 | E274 | E275 |
| 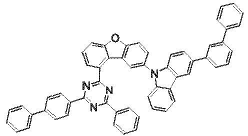 | 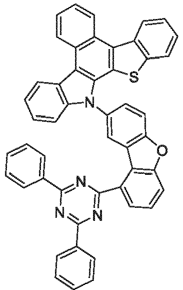 | 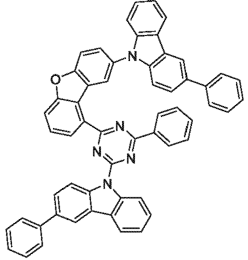 |
| E276 | E277 | E278 |
| 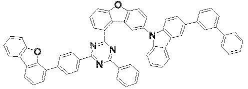 | 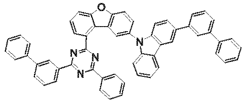 | 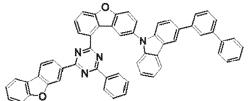 |
| E279 | E280 | E281 |
| 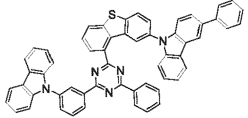 | 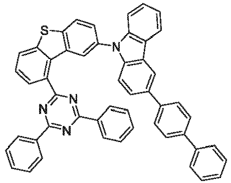 | 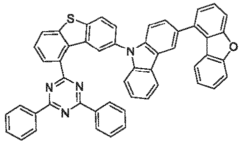 |
| E282 | E283 | E284 |
| 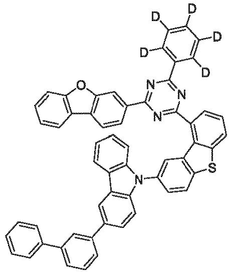 | 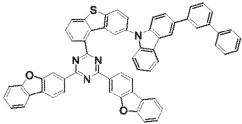 | 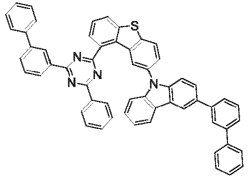 |
| E285 | E286 | E287 |
| 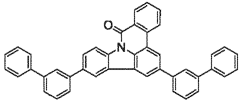 | 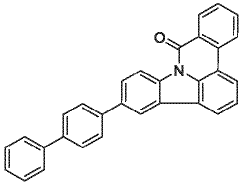 | 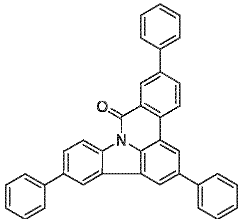 |
| E288 | E289 | E300 |
| 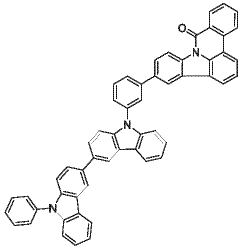 | 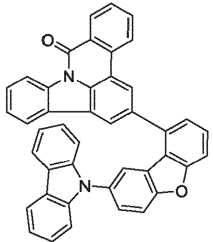 | 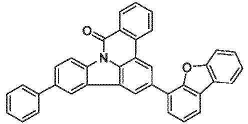 |
| E301 | E302 | E303 |

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich gegenüber dem Stand der Technik dadurch aus, dass sie eine signifikant verbesserte Lebensdauer aufweisen gegenüber vergleichbaren Strukturen, die an dem Phenyl- bzw. Biphenylsubstituenten keine Cyanogruppe aufweisen. Dabei erhält man gleichzeitig eine leichte Verbesserung der Effizienz und der Spannung.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen, die mehrere tautomere, isomere, diastereomere und enantiomere Formen aufweisen können, wird stellvertretend eine Form gezeigt.

### A: Synthese der Liganden L:

### Beispiel L1:

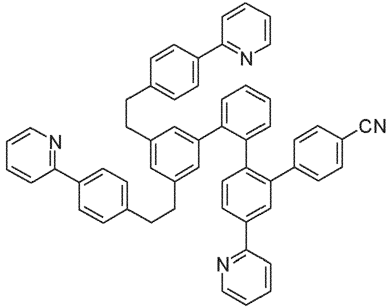

Ein Gemisch aus 81.8 g (100 mmol) 2-(4-{2-[3-(2'-{[Trifluormethansulfonyl]-4-yl}-4'-(pyridin-2-yl)-[1,1'-biphenyl]-2-yl)-5-{2-[4-(pyridin-2-yl)-phenyl]ethyl}-phenyl]ethyl}phenyl)pyridin [2375157-32-5], 16.2 g (110 mmol) 4-Cyanophenylboronsäure [126747-14-6], 53.1 g (250 mmol) Trikaliumphosphat, 800 ml THF und 200 ml Wasser wird unter kräftigem Rühren mit 1.64 g (4 mmol) S-Phos und dann mit 449 mg (2 mmol) Palladium(II)acetat versetzt und 12 h unter Rückfluss erhitzt. Nach Erkalten trennt man die wässrige Phase ab, engt die organische Phase im Vakuum weitgehend ein, nimmt den Rückstand in 500 ml Ethylacetat auf, wäscht die organische Phase zweimal mit je 300 ml Wasser, einmal mit 2%iger, wässriger N-Acetylcystein-Lösung, einmal mit 300 ml gesättigter Kochsalzlösung und trocknet über Magnesiumsulfat. Man filtriert vom Trockenmittel über ein mit Ethylacetat vorgeschlämmtes Kieselgel-Bett ab, wäscht mit Ethylacetat nach, engt das Filtrat zur Trockene ein und kristallisiert den Rückstand aus ca. 200 ml Acetonitril in der Siedehitze um. Ausbeute: 50.2 g (65 mmol), 65 %; Reinheit: ca. 98 %ig nach ¹H-NMR.

Analog können folgende Verbindungen dargestellt werden.

| Bsp. | Edukte | Produkt | Ausbeute |
|---|---|---|---|
| L2 | 2375157-34-7 | 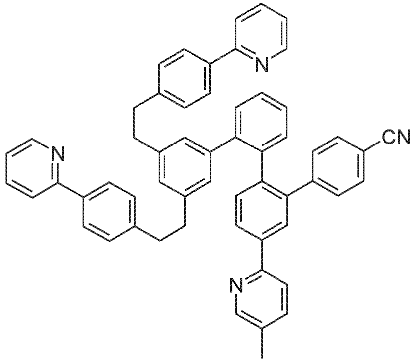 | 70 % |
| | 126747-14-6 | | |
| L3 | 2375157-36-9 | 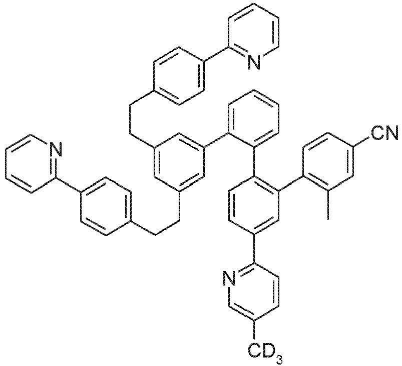 | 67 % |
| | 313546-18-8 | | |
| L4 | 2375157-38-1 | 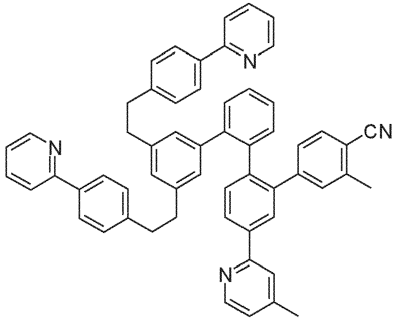 | 63 % |
| | 856255-58-8 | | |
| L5 | 2375157-40-5 | 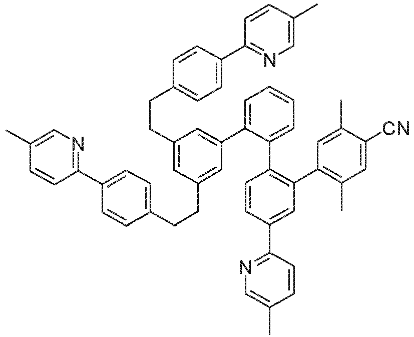 | 69 % |
| | 1384855-53-1 | | |
| L6 | 2375157-32-5 | 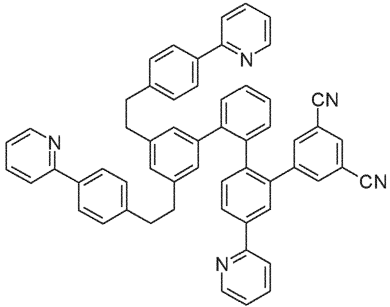 | 55 % |
| | 1212021-54-9 | | |
| L7 | 2375157-36-9 | 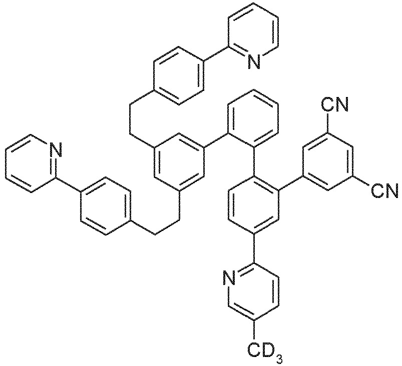 | 58 % |
| | 1212021-54-9 | | |
| L-Ref3 | 2375157-36-9 | 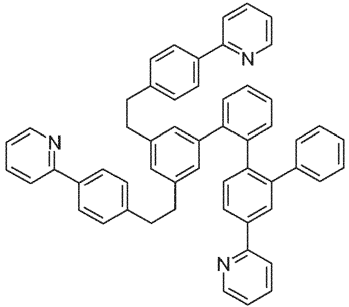 | 72 % |
| | 98-80-6 | | |
| L100 | 2375157-32-5 | 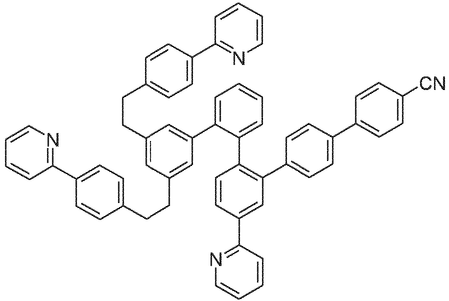 | 76 % |
| | 406482-73-3 | | |
| L101 | 2375157-34-7 | 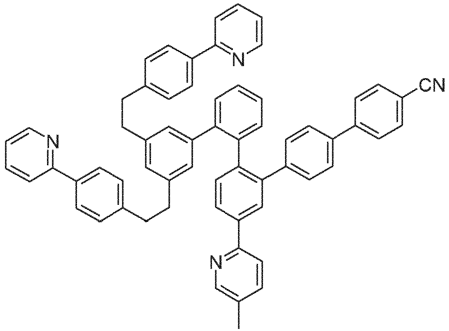 | 73 % |
| | 406482-73-3 | | |
| L102 | 2375157-36-9 | 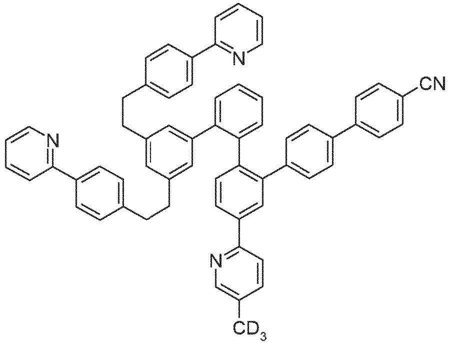 | 75 % |
| | 406482-73-3 | | |
| L103 | 2375157-40-5 | 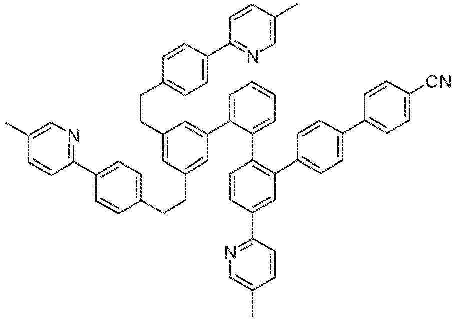 | 70 % |
| | 406482-73-3 | | |
| L104 | 2375157-42-7 | 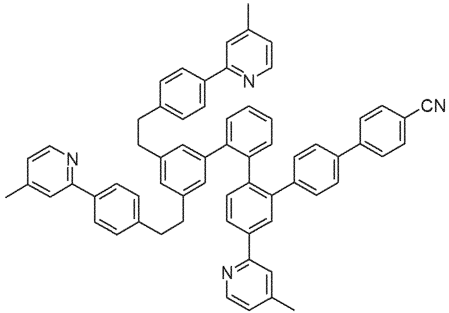 | 68 % |
| | 406482-73-3 | | |
| L105 | 2375157-44-9 | 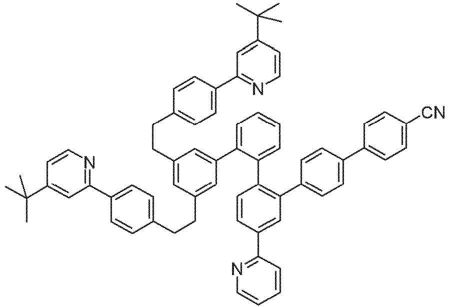 | 63 % |
| | 406482-73-3 | | |
| L106 | 2375157-34-7 | 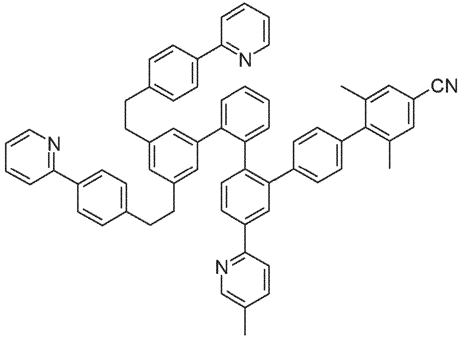 | 68 % |
| | 1800587-08-9 | | |
| L107 | 2375157-34-7 | 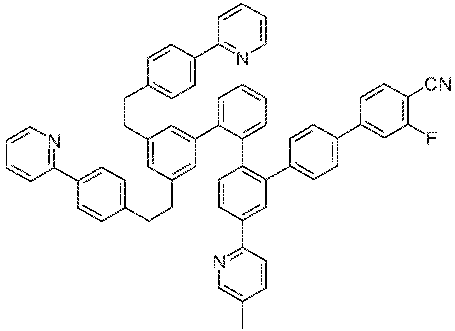 | 65 % |
| | 2380354-21-0 | | |
| L108 | 2375157-34-7 | 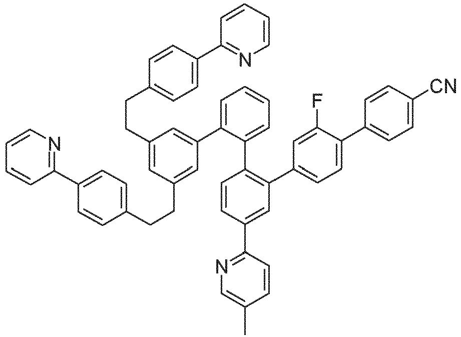 | 67 % |
| | 1615713-15-9 | | |
| L109 | 2375157-42-7 | 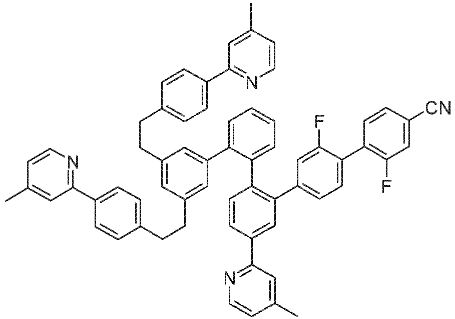 | 60 % |
| | 2291171-92-9 | | |
| L110 | 2375157-40-5 | 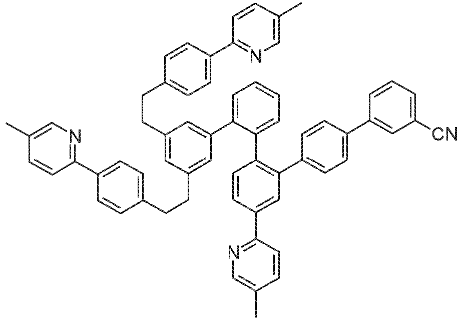 | |
| | 1352715-67-3 | | |
| L111 | 2375157-36-9 | 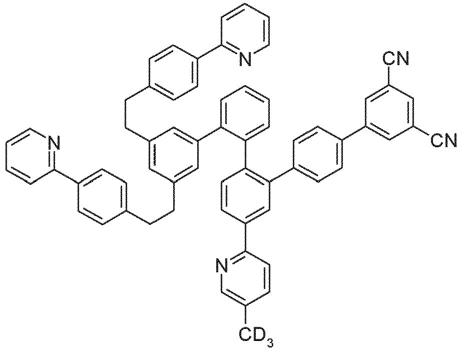 | 68 % |
| | 2242884-56-4 | | |
| L112 | 2375157-44-9 | 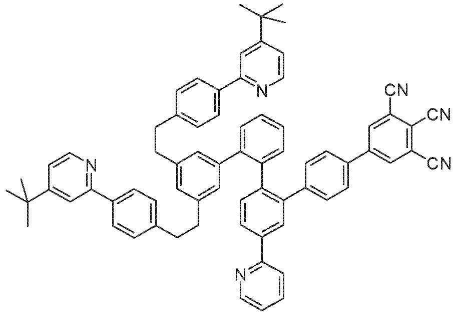 | 61 % |
| | 2242884-55-3 | | |

### C: Darstellung der Metallkomplexe

### Beispiel Ir(L1):

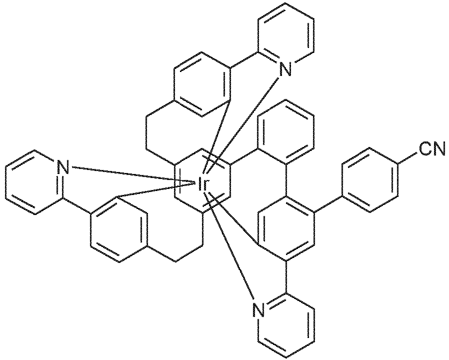

Ein Gemisch aus 7.71 g (10 mmol) des Liganden L1, 4.90 g (10 mmol) Tris-acetylacetonato-iridium(III) [15635-87-7] und 120 g Hydrochinon [123-31-9] werden in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 240-245 °C, gemessen am Pt-100 Thermofühler, der in die aufgeschmolzene, gerührte Reaktionsmischung eintaucht, erhitzt. Während der nächsten 1 h wird das Reaktionsgemisch bei 240-245 °C gehalten, wobei wenig Kondensat abdestilliert und sich im Wasserabscheider sammelt. Nach 1 h lässt man auf ca. 190 °C abkühlen, entfernt die Heizschale und tropft dann 100 ml Ethylenglycol zu. Nach Erkalten auf 100 °C tropft man langsam 400 ml Methanol zu. Die so erhaltene gelbe Suspension wird über eine Umkehrfritte filtriert, der gelbe Feststoff wird dreimal mit 50 ml Methanol gewaschen und dann im Vakuum getrocknet. Der so erhaltene Feststoff wird in 200 ml Dichlormethan gelöst und über 600 g mit Dichlormethan vorgeschlämmtes Kieselgel (Säulendurchmesser ca. 10 cm) unter Luft- und Lichtausschluss filtriert, wobei dunkle Anteile am Start liegen bleiben. Die Kernfraktion wird herausgeschnitten und am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des gelben Produkts durch viermalige kontinuierliche Heißextraktion mit Dichlormethan/i-Propanol 1:1 (vv) und dann viermalige Heißextraktion mit Dichlormethan/Acetonitril (Vorlagemenge jeweils ca. 200 ml, Extraktionshülse: Standard Soxhletthülsen aus Cellulose der Fa. Whatman) unter sorgfältigem Luft- und Lichtausschluss. Über das Verhältnis Dichlormethan (Niedersieder und Gutlöser) : i-Propanol bzw. Acetonitril (Hochsieder und Schlechtlöser) kann der Verlust in die Mutterlauge eingestellt werden. Typischerweise sollte er 3-6 Gew.-% der eingesetzten Menge betragen. Es können zur Heißextraktion auch andere Lösungsmittel wie Toluol, Xylol, Essigester, Butylacetat, etc. verwendet werden. Abschließend wird das Produkt im Hochvakuum bei p ~ 10⁻⁶ mbar und T ~ 330 - 430 °C fraktioniert sublimiert. Ausbeute: 4.91 g (5.1 mmol), 51 %; Reinheit: > 99.9 %ig nach HPLC.

Die Metallkomplexe fallen üblicherweise als 1:1 Mischung der A- und Δ-Isomere/Enantiomere an. Die im Folgenden aufgeführte Abbildungen von Komplexen zeigen üblicherweise nur ein Isomer. Werden Liganden mit drei verschiedenen Teilliganden eingesetzt, bzw. werden chirale Liganden als Racemat eingesetzt, fallen die abgeleiteten Metallkomplexe als Diastereomerenmischung an. Diese können durch fraktionierte Kristallisation oder chromatographisch getrennt werden, z. B. mit einem Säulenautomaten (CombiFlash der Fa. A. Semrau). Werden chirale Liganden enantiomerenrein eingesetzt, fallen die abgeleiteten Metallkomplexe als Diastereomerenmischung an, deren Trennung durch fraktionierte Kristallisation oder Chromatographie zu reinen Enantiomeren führt. Die getrennten Diastereomeren bzw. Enantiomeren können wie oben beschrieben z. B. durch Heißextraktion weiter gereinigt werden.

Analog können folgende Verbindungen dargestellt werden:

| Bsp. | Ligand | Produkt Variante / Extraktionsmittel | Ausbeute |
|---|---|---|---|
| Ir(L2) | L2 | 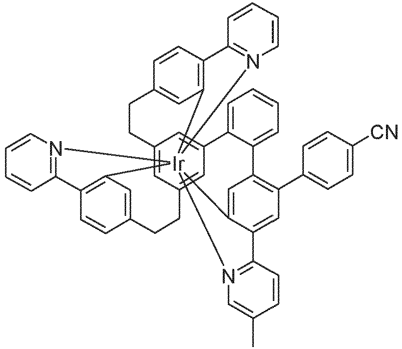 | 55 % |
| Ir(L3) | L3 | 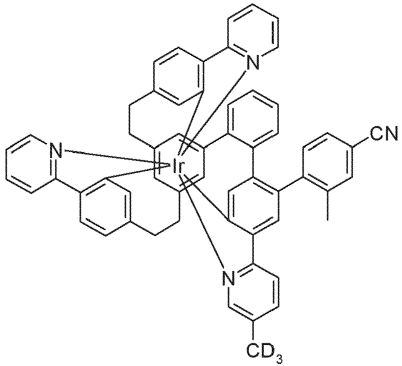 | 53 % |
| Ir(L4) | L4 | 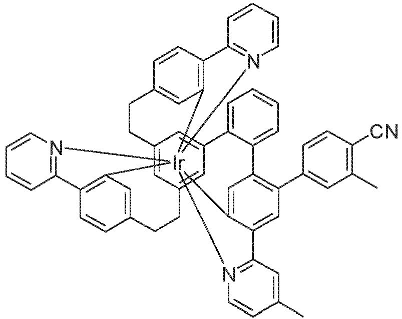 | 64 % |
| Ir(L5) | L5 | 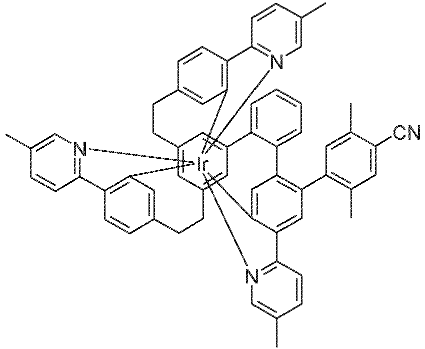 | 65 % |
| Ir(L6) | L6 | 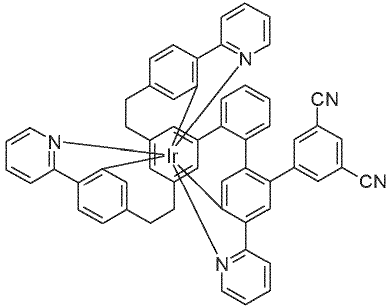 | 57 % |
| Ir(L7) | L7 | 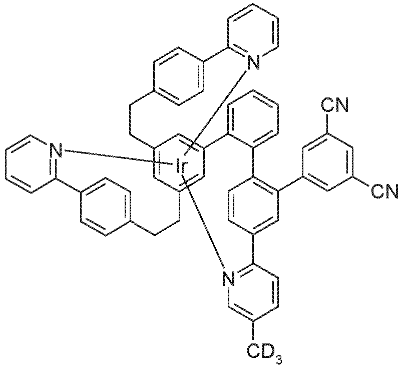 | 53 % |
| Ir(L-Ref3) | L-Ref3 | 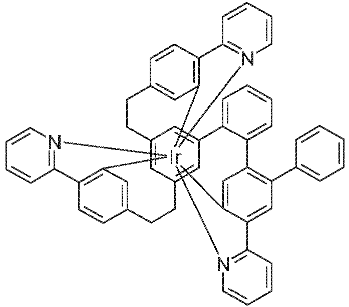 | 78 % |
| Ir(L100) | L100 | 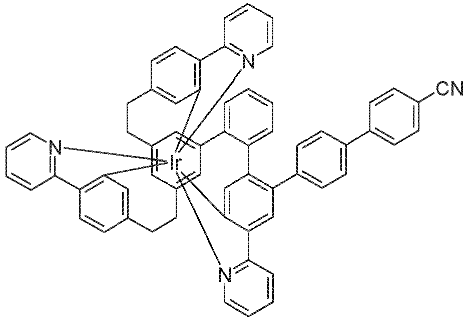 | 57 % |
| Ir(L101) | L101 | 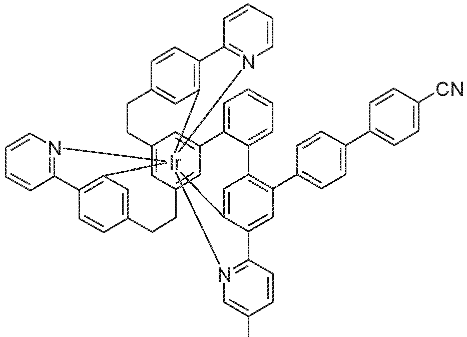 | 53 % |
| Ir(L102) | L102 | 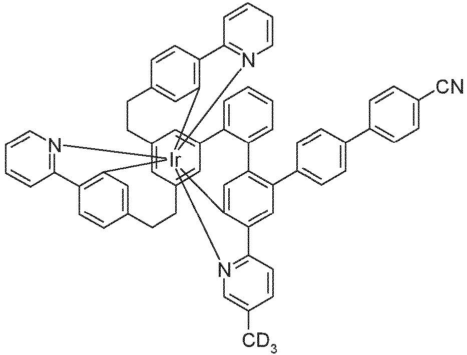 | 56 % |
| Ir(L103) | L103 | 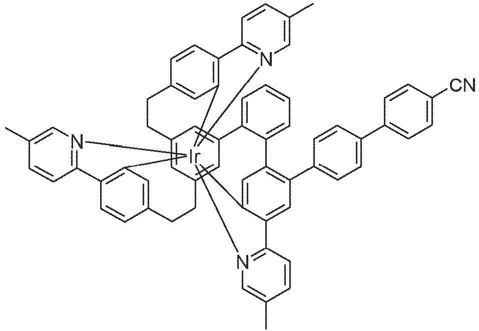 | 59 % |
| Ir(L104) | L104 | 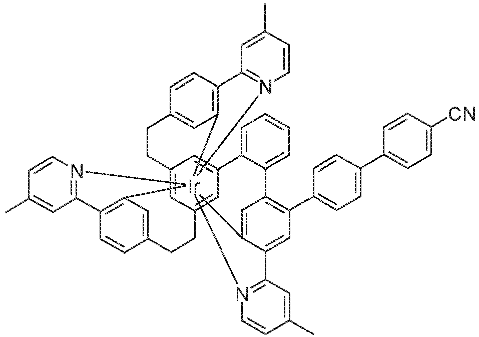 | 61 % |
| Ir(L105) | L105 | 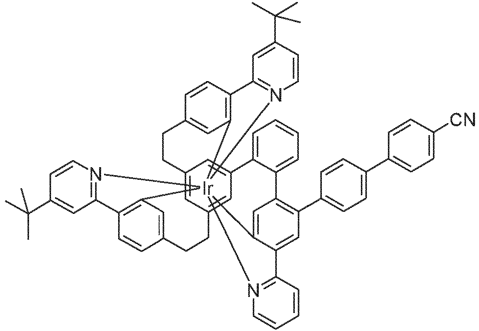 | 56 % |
| Ir(L106) | L106 | 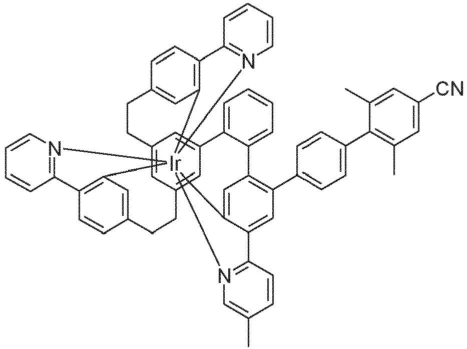 | 60 % |
| Ir(L107) | L107 | 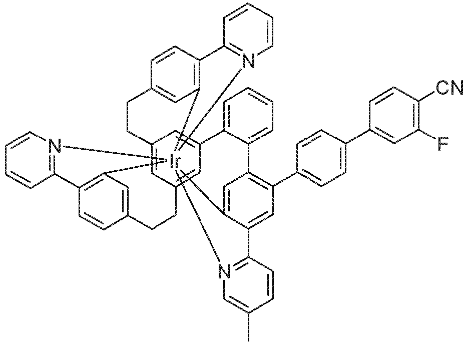 | 64 % |
| Ir(L108) | L108 | 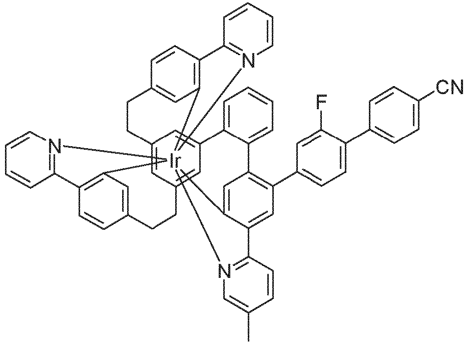 | 57 % |
| Ir(L109) | L109 | 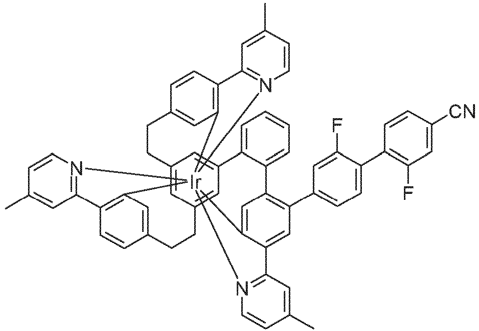 | 61 % |
| Ir(L110) | L110 | 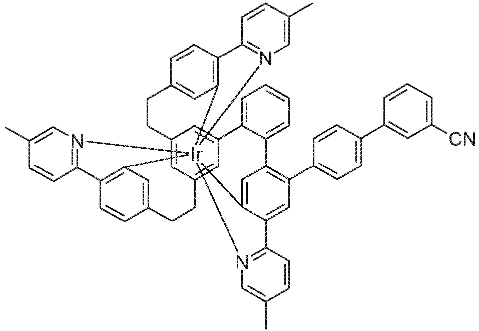 | 60 % |
| Ir(L111) | L111 | 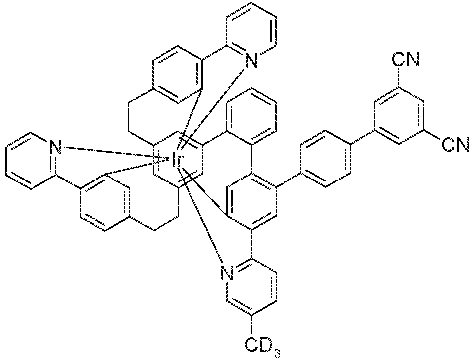 | 55 % |
| Ir(L112) | L112 | 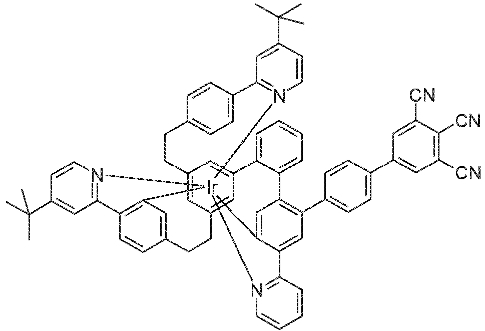 | 49 % |

### B: Funktionalisierung der Metallkomplexe

### A) Deuterierung der Methyl-/Methylengruppen an den Pyridin-Liganden:

1 mmol des sauberen Komplexes (Reinheit > 99.9%) mit x Methyl-/Mehylengruppen und x = 1 - 6 wird durch Erhitzen auf ca. 180 °C in 50 ml DMSO-d6 (Deuterierungsgrad > 99.8 %) gelöst. Die Lösung wird 5 min. bei 180 °C gerühert. Man lässt die Lösung auf 80 °C erkalten und versetzt die Lösung zügig unter gutem Rühren mit einer Mischung von 5 ml Methanol-d1 (Deuterierungsgrad > 99.8 %) und 10 ml DMSO-d6 (Deuterierungsgrad > 99.8 %), in welchem 0.3 mmol Natriumhydrid gelöst wurden. Man rührt die klare gelb-orange Lösung bei 80 °C weitere 30 min. für Komplexe mit Methyl-/Methylengruppen para zum Pyridin-Stickstoff bzw. weitere 6h für Komplexe mit Methyl-/Methylengruppen meta zum Pyridin-Stickstoff nach, kühlt dann mit Hilfe eines Kaltwasserbades ab, versetzt tropfenweise ab ~ 60 °C mit 20 ml 1N DCI in D₂O, lässt auf Raumtemperatur erkalten, rührt 5 h nach, saugt vom Feststoff ab und wäscht diesen dreimal mit je 10 ml H₂O/MeOH (1:1, vv) und dann dreimal mit je 10 ml MeOH und trocknet im Vakuum. Der Feststoff wird in DCM gelöst, die Lösung über Kieselgel filtriert, das Filtrat wird im Vakuum eingeengt, gleichzeitig tropfenweise mit MeOH versetzt und dadaurch zur Kristallisation gebracht. Abschließend wird fraktioniert sublimiert wie unter "C: Darstellung der Metallkomplexe, Variante A" beschrieben. Ausbeute typischerweise 80-90%, Deuterierungsgrad > 95%.

Analog können folgende deuterierte Komplexe dargestellt werden:

| Bsp. | Edukt | Produkt | Ausbeute |
|---|---|---|---|
| Ir(L103-D9) | Ir(L103) | 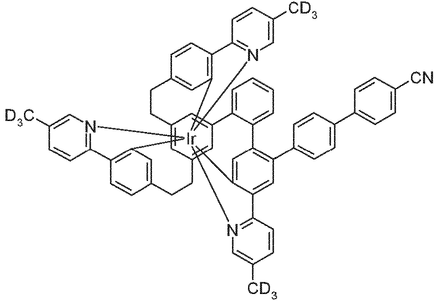 | 78 % |
| Ir(L104-D9) | Ir(L104) | 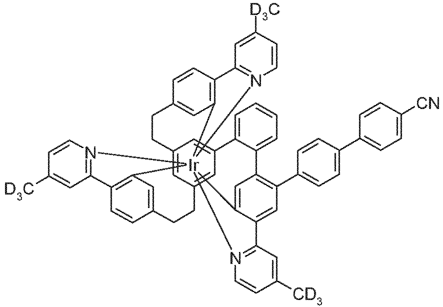 | 85 % |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 15 Minuten bei 250 °C unter Stickstoff ausgeheizt. Die vorgereinigten ITO-Substrate werden einem Zwei-Gas-Plasmaprozess (Sauerstoff gefolgt von Argon) unterzogen, um die ITO-Oberfälche final zu reinigen und die ITO-Austrittsarbeit anzupassen. Diese beschichteten Glasplättchen bilden die Substrate, auf welche die OLEDs aufgebracht werden. Alle Materialien werden durch thermische Vakuumdeposition aufgebracht. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M1:M2:Ir-Emitter (29.5%:58.5:12%) bedeutet hierbei, dass das Material M1 in einem Volumenanteil von 29.5%, M2 in einem Volumenanteil von 58.5% und Ir-Emitter in einem Volumenanteil von 12% in der Schicht vorliegt. Analog besteht auch die Elektronentransportschicht aus einer Mischung zweier Materialien.

Die OLEDs haben prinzipiell folgenden Schichtaufbau: ITO-Substrat / Lochinjektionsschicht 1 (HIL1) bestehend aus HTM1 dotiert mit 5 % NDP-9 (kommerziell erhältlich von der Fa. Novaled), 20 nm / Lochstransportschicht 1 (HTL1) bestehend aus HTM1, 40 nm / Lochtransportschicht 2 (HTL2), 20 nm / Emissionsschicht (EML), s. Tabelle 1 / Lochblockierschicht (HBL), s. Tabelle 1 / Elektronentransportschicht (ETL), s. Tabelle 1 / Elektroneninjektionsschicht (EIL), s. Tabelle 1 / 100 nm dicke Aluminiumschicht als Kathode. Die zur Herstellung der OLEDs verwendeten Materialien sind in Tabelle 3 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Als Lebensdauer LD90 wird die Zeit definiert, nach der die Leuchtdichte bei Betrieb mit einer Starthelligkeit von 10000 cd/m² auf 90% der Startleuchtdichte abgesunken ist. Die OLEDs können initital auch bei anderen Startleuchtdichten betrieben werden. Die Werte für die Lebensdauer können dann mit Hilfe dem Fachmann bekannten Umrechnungsformeln auf eine Angabe für andere Startleuchtdichten umgerechnet werden.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridiumverbindungen gemäß Tabelle 3 verwendet. Die Ergebnisse der OLEDs sind in Tabelle 2 zusammengefasst.

Wie man an den Ergebnissen erkennt, führen die erfindungsgemäßen Verbindungen bei Verwendung als Emitter in einer OLED zu einer leichten Verbesserung von Effizienz und Spannung bei einer gleichzeitigen signifikanten Verbesserung der Lebensdauer, beispielsweise einer Verbesserung der Lebensdauer um 60% im Fall des erfindungsgemäßen Komplexes Ir(L100) im Vergleich zu dem Komplex Ir-Ref.1 gemäß dem Stand der Technik, der die gleiche Struktur wie Ir(L100) aufweist, jedoch keine Cyanogruppe am Biphenylsubstituenten enthält.

**Tabelle 1: Aufbau der OLEDs**

| **Bsp.** | **EML Dicke** | **HBL Dicke** | **ETL Dicke** | **EIL** |
|---|---|---|---|---|
| Ref.D1 | M1:M2:Ir-Ref.1 (29.5%:58.5%:12%) 40 nm | HBL1 5nm | ETM1:ETM2 (50%:50%) 30 nm | ETM2 1 nm |
| Ref.D2 | M1:M2:Ir-Ref.2 (29.5%:58.5%:12%) 40 nm | HBL1 5nm | ETM1:ETM2 (50%:50%) 30 nm | ETM2 1 nm |
| Ref.D3 | M1:M2:Ir(L-Ref3) (29.5%:58.5%:12%) 40 nm | HBL1 5nm | ETM1:ETM2 (50%:50%) 30 nm | ETM2 1 nm |
| D1 | M1:M2:Ir(L1) (29.5%:58.5%:12%) | HBL1 5nm | ETM1:ETM2 (50%:50%) | ETM2 1 nm |
| | 40 nm | | 30 nm | |
| D2 | M1:M2:Ir(L2) (29.5%:58.5%:12%) 40 nm | HBL1 5nm | ETM1:ETM2 (50%:50%) 30 nm | ETM2 1 nm |
| D3 | M1:M2:Ir(L3) (29.5%:58.5%:12%) 40 nm | HBL1 5nm | ETM1:ETM2 (50%:50%) 30 nm | ETM2 1 nm |
| D4 | M1:M2:Ir(L4) (29.5%:58.5%:12%) 40 nm | HBL1 5nm | ETM1:ETM2 (50%:50%) 30 nm | ETM2 1 nm |
| D5 | M1:M2:Ir(L5) (29.5%:58.5%:12%) 40 nm | HBL1 5nm | ETM1:ETM2 (50%:50%) 30 nm | ETM2 1 nm |
| D6 | M1:M2:Ir(L6) (29.5%:58.5%:12%) 40 nm | HBL1 5nm | ETM1:ETM2 (50%:50%) 30 nm | ETM2 1 nm |
| D7 | M1:M2:Ir(L7) (29.5%:58.5%:12%) 40 nm | HBL1 5nm | ETM1:ETM2 (50%:50%) 30 nm | ETM2 1 nm |
| D100 | M1:M2:Ir(L100) (29.5%:58.5%:12%) 40 nm | HBL1 5nm | ETM1:ETM2 (50%:50%) 30 nm | ETM2 1 nm |
| D101 | M1:M2:Ir(L101) (29.5%:58.5%:12%) 40 nm | HBL1 5nm | ETM1:ETM2 (50%:50%) 30 nm | ETM2 1 nm |
| D102 | M1:M2:Ir(L102) (29.5%:58.5%:12%) 40 nm | HBL1 5nm | ETM1:ETM2 (50%:50%) 30 nm | ETM2 1 nm |
| D103 | M1:M2:Ir(L103) (29.5%:58.5%:12%) 40 nm | HBL1 5nm | ETM1:ETM2 (50%:50%) 30 nm | ETM2 1 nm |
| D103-D | M1:M2:Ir(L103-D) (29.5%:58.5%:12%) 40 nm | HBL1 5nm | ETM1:ETM2 (50%:50%) 30 nm | ETM2 1 nm |
| D104 | M1:M2:Ir(L104) (29.5%:58.5%:12%) 40 nm | HBL1 5nm | ETM1:ETM2 (50%:50%) 30 nm | ETM2 1 nm |
| D104-D | M1:M2:Ir(L104-D) (29.5%:58.5%:12%) 40 nm | HBL1 5nm | ETM1:ETM2 (50%:50%) 30 nm | ETM2 1 nm |
| D105 | M1:M2:Ir(L105) (46.0%:46%:8%) 40 nm | HBL1 5nm | ETM1:ETM2 (50%:50%) 30 nm | ETM2 1 nm |
| D106 | M1:M2:Ir(L106) (29.5%:58.5%:12%) 40 nm | HBL1 5nm | ETM1:ETM2 (50%:50%) 30 nm | ETM2 1 nm |
| D107 | M1:M2:Ir(L107) (29.5%:58.5%:12%) 40 nm | HBL1 5nm | ETM1:ETM2 (50%:50%) 30 nm | ETM2 1 nm |
| D108 | M1:M2:Ir(L108) (29.5%:58.5%:12%) 40 nm | HBL1 5nm | ETM1:ETM2 (50%:50%) 30 nm | ETM2 1 nm |
| D109 | M1:M2:Ir(L109) (29.5%:58.5%:12%) 40 nm | HBL1 5nm | ETM1:ETM2 (50%:50%) 30 nm | ETM2 1 nm |
| D110 | M1:M2:Ir(L110) | HBL1 | ETM1:ETM2 | ETM2 |
| | (29.5%:58.5%:12%) 40 nm | 5nm | (50%:50%) 30 nm | 1 nm |
| D110 | M1:M2:Ir(L111) (29.5%:58.5%:12%) 40 nm | HBL1 5nm | ETM1:ETM2 (50%:50%) 30 nm | ETM2 1 nm |

**Tabelle 2: Ergebnisse der Vakuum-prozessierten OLEDs**

| (Eff., EQE, Spannung, CIE bei 1000 cd/m²; Lebensdauer LD90 bei 10000 cd/m²) | | | | | | |
|---|---|---|---|---|---|---|
| **Bsp.** | **Eff. [cd/A]** | **Eff. [lm/W]** | **EQE [%]** | **Spannung [V]** | **CIE [x/y]** | **LD90 [h]** |
| Ref.D1 | 93.2 | 88.8 | 24.8 | 3.30 | 0.363/0.614 | 1040 |
| Ref.D2 | 89.6 | 94.7 | 24.1 | 3.18 | 0.301/0.650 | 790 |
| Ref.D3 | 82.9 | 86.4 | 21.6 | 3.02 | 0.347/0.626 | 650 |
| D1 | 87.1 | 97.9 | 23.6 | 2.80 | 0.350/0.617 | 730 |
| D2 | 90.2 | 103.2 | 23.4 | 2.75 | 0.346/0.623 | 840 |
| D3 | 89.2 | 96.8 | 23.3 | 2.90 | 0.320/0.664 | 710 |
| D4 | 91.2 | 104.4 | 23.5 | 2.74 | 0.348/0.621 | 860 |
| D5 | 90.0 | 101.8 | 23.4 | 2.73 | 0.350/0.620 | 700 |
| D6 | 84.9 | 100.7 | 22.8 | 2.64 | 0.327/0.637 | 630 |
| D7 | 84.4 | 99.7 | 22.7 | 2.66 | 0.324/0.642 | 630 |
| D100 | 95.2 | 91.8 | 25.2 | 3.26 | 0.363/0.614 | 1660 |
| D101 | 96.6 | 96.3 | 25.8 | 3.15 | 0.340/0.627 | 1700 |
| D102 | 96.0 | 96.1 | 25.8 | 3.17 | 0.341/0.624 | 2000 |
| D103 | 90.9 | 101.3 | 24.5 | 2.82 | 0.348/0.621 | 1370 |
| D103-D | 89.4 | 99.8 | 24.5 | 2.85 | 0.346/0.619 | 1580 |
| D104 | 85.5 | 90.6 | 22.8 | 2.96 | 0.339/0.628 | 1230 |
| D104-D | 84.7 | 89.8 | 22.7 | 2.95 | 0.338/0.626 | 1460 |
| D105 | 93.2 | 97.1 | 24.8 | 3.02 | 0.333/0.634 | 1280 |
| D106 | 92.4 | 92.3 | 24.4 | 3.11 | 0.334/0.635 | 1130 |
| D107 | 93.1 | 93.5 | 24.5 | 3.09 | 0.336/0.632 | 1100 |
| D108 | 93.2 | 94.0 | 24.5 | 3.18 | 0.332/0.633 | 1060 |
| D109 | 90.1 | 94.0 | 23.0 | 3.10 | 0.332/0.633 | 1130 |
| D110 | 90.7 | 100.7 | 24.4 | 2.80 | 0.346/0.624 | 1220 |
| D111 | 97.5 | 99.2 | 25.9 | 3.01 | 0.331/0.636 | 2000 |

**Tabelle 3: Strukturformeln der verwendeten Materialien**

| | |
|---|---|
| 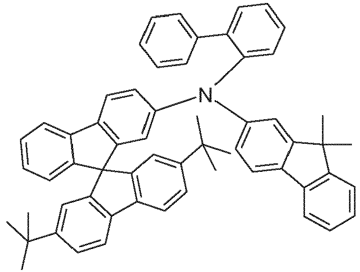 | 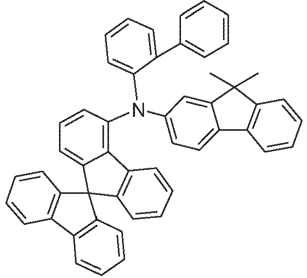 |
| HTM1 [1365840-52-3] | HTM2 [1450933-44-4] |
| 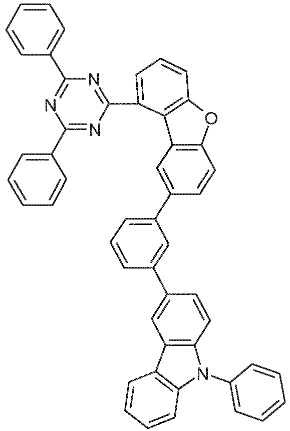 | 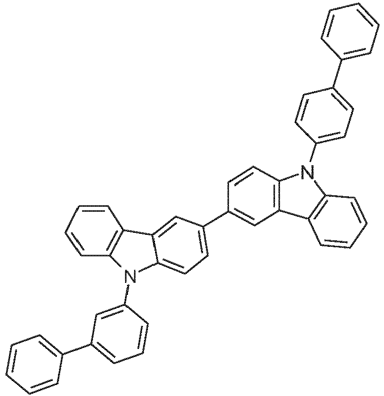 |
| M1 | M2 [1643479-47-3] |
| [1822310-86-0] | |
| 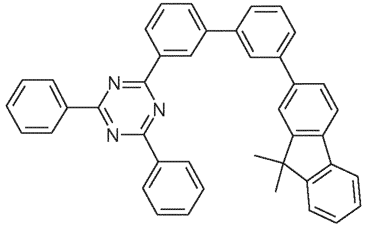 | 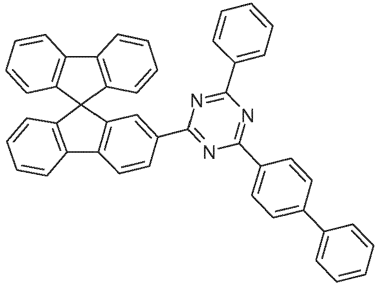 |
| HBL1 [1955543-57-3] | ETM1 [1819335-36-8] |
| 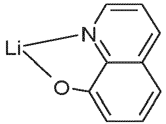 | 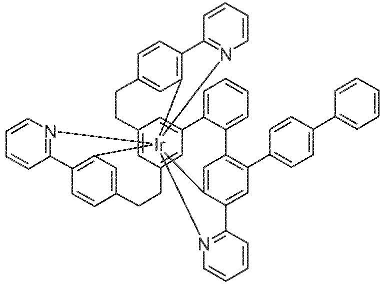 |
| ETM2[25387-93-3] | Ir-Ref.1 [2375153-43-6] |
| 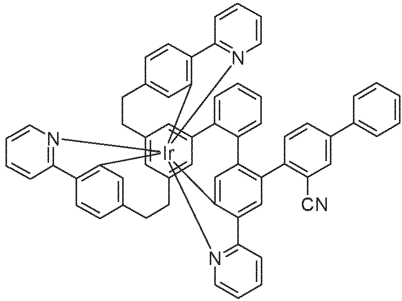 | |
| Ir-Ref.2 WO2019/158453 | |

## Patentansprüche

1. Verbindung der Formel (1),
Ir(L) Formel (1)
wobei der Ligand L eine Struktur der folgenden Formel (2) aufweist: 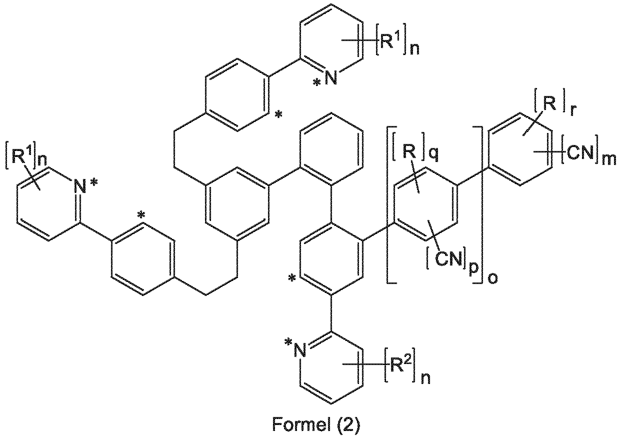
wobei der Ligand L über die mit * gekennzeichneten Positionen an das Iridiumatom koordiniert und wobei die nicht explizit eingezeichneten H-Atome auch durch D ersetzt sein können und wobei für die verwendeten Symbole und Indizes gilt:
R ist gleich oder verschieden bei jedem Auftreten H, D, F, eine lineare Alkylgruppe mit 1 bis 10 C-Atomen oder eine verzweigte oder cyclische Alkylgruppe mit 3 bis 10 C-Atomen, wobei die Alkylgruppe jeweils auch deuteriert sein kann; dabei können zwei benachbarte Reste R miteinander ein Ringsystem bilden;
R¹ ist gleich oder verschieden bei jedem Auftreten H, D, eine lineare Alkylgruppe mit 1 bis 10 C-Atomen oder eine verzweigte oder cyclische Alkylgruppe mit 3 bis 10 C-Atomen, wobei die Alkyl- gruppe jeweils auch deuteriert sein kann; dabei können zwei benachbarte Reste R¹ miteinander ein Ringsystem bilden;
R² ist gleich oder verschieden bei jedem Auftreten H, D, eine lineare Alkylgruppe mit 1 bis 10 C-Atomen, eine verzweigte oder cyclische Alkylgruppe mit 3 bis 10 C-Atomen, wobei die Alkylgruppe jeweils auch deuteriert sein kann, oder eine Phenyl- oder Biphenylgruppe, die jeweils durch ein oder mehrere Alkylgruppen mit 1 bis 10 C-Atomen substituiert sein kann, wobei die Phenyl- bzw. Biphenylgruppe bzw. die Alkylgruppen jeweils auch deuteriert sein können; dabei können zwei benachbarte Reste R² miteinander ein Ringsystem bilden;
m ist 1, 2 oder 3;
n ist bei jedem Auftreten gleich oder verschieden 0, 1, 2 oder 3;
o ist 0 oder 1;
p ist 0, 1 oder 2;
q ist 0, 1 oder 2;
r ist 0, 1 oder 2.

2. Verbindung nach Anspruch 1, **dadurch gekennzeichnet, dass** für m = 1 der Ligand L für eine Struktur der Formel (3a) steht, für m = 2 der Ligand L für eine Struktur der Formel (3b) oder (3c) steht und für m = 3 der Ligand L für eine Struktur der Formel (3d) oder (3e) steht, 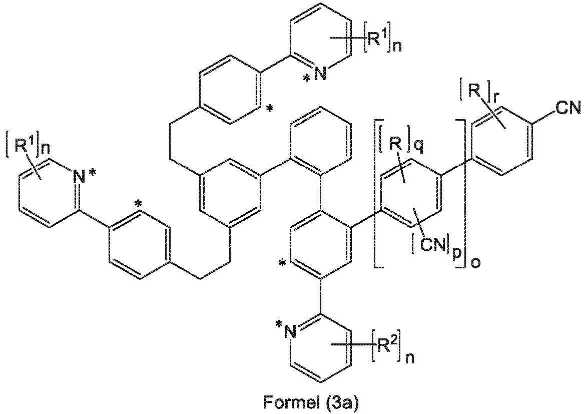 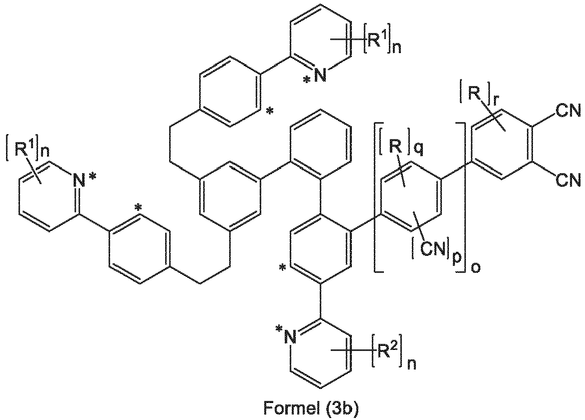 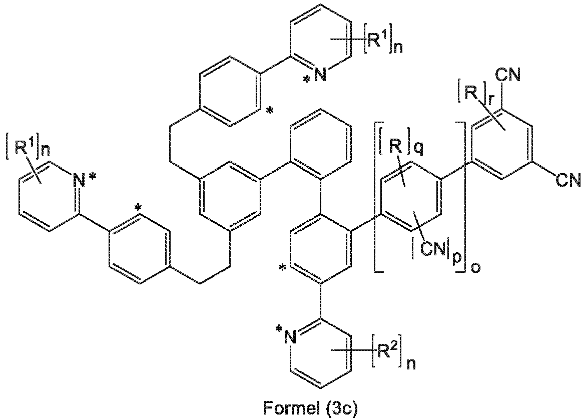 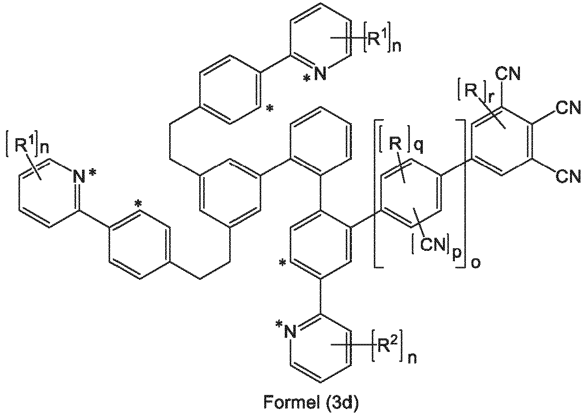 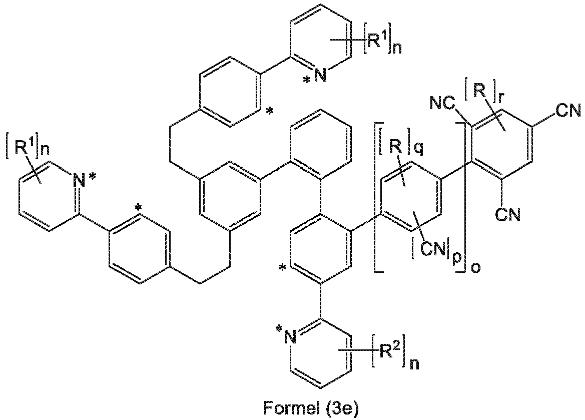 wobei die nicht explizit eingezeichneten H-Atome auch durch D ersetzt sein können und die Symbole und Indizes die in Anspruch 1 genannten Bedeutungen aufweisen.

3. Verbindung nach Anspruch 1 oder 2, **dadurch gekennzeichnet, dass** der Ligand L für o = 1 und p = 1 eine Struktur der Formel (4a) aufweist aund dass der Ligand L für o = 1 und p = 2 eine Struktur der Formel (4b) aufweist, 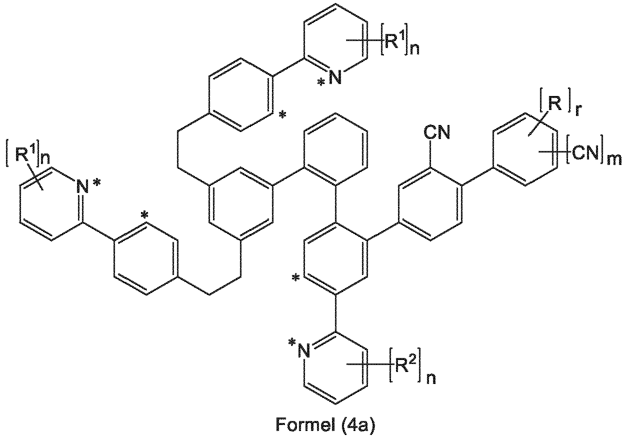 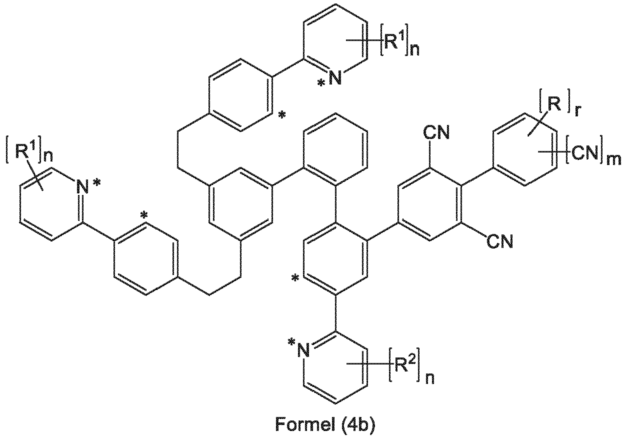 wobei die nicht explizit eingezeichneten H-Atome auch durch D ersetzt sein können und die Symbole und Indizes die in Anspruch 1 genannten Bedeutungen aufweisen.

4. Verbindung nach einem oder mehreren der Ansprüche 1 bis 3,
**dadurch gekennzeichnet, dass** der Ligand L eine Struktur der Formel (7) aufweist, 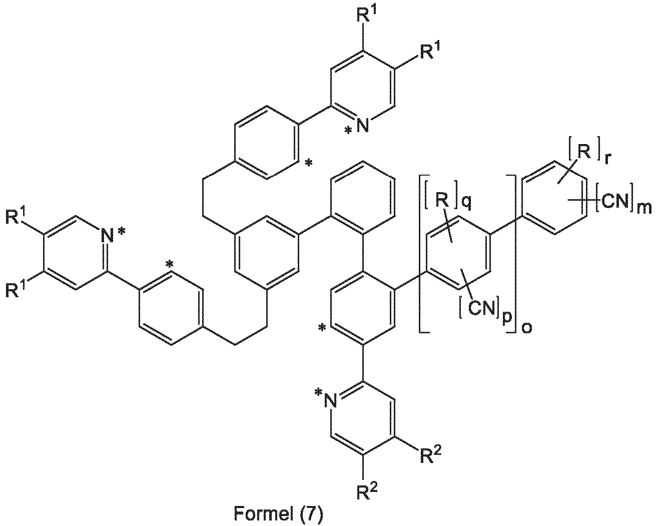
wobei die nicht explizit eingezeichneten H-Atome auch durch D ersetzt sein können und die Symbole und Indizes die in Anspruch 1 genannten Bedeutungen aufweisen.

5. Verbindung nach einem oder mehreren der Ansprüche 1 bis 4, **dadurch gekennzeichnet, dass** für die Substituenten gilt:
R ist gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können;
R¹ ist gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können; dabei können zwei benachbarte Reste R¹ miteinander ein Ringsystem bilden;
R² ist gleich oder verschieden bei jedem Auftreten ausgewählt aus der Gruppe bestehend aus D, einer linearen Alkylgruppe mit 1 bis 6 C-Atomen oder einer verzweigten oder cyclischen Alkylgruppe mit 3 bis 6 C-Atomen, wobei die Alkylgruppen jeweils auch deuteriert sein können, oder eine optional deuterierte Phenylgruppe, die durch ein oder mehrere optional deuterierte Alkylgruppen mit 1 bis 4 C-Atomen substituiert sein kann; dabei können zwei benachbarte Reste R² miteinander ein Ringsystem bilden.

6. Verbindung nach einem oder mehreren der Ansprüche 1 bis 5, **dadurch gekennzeichnet, dass** für die Symbole und Indizes gilt:
R ist gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können;
R¹ ist gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können; dabei können zwei benachbarte Reste R¹ miteinander ein Ringsystem bilden;
R² ist gleich oder verschieden bei jedem Auftreten ausgewählt aus der Gruppe bestehend aus D, einer linearen Alkylgruppe mit 1 bis 4 C-Atomen oder einer verzweigten Alkylgruppe mit 3 oder 4 C-Atomen, wobei die Alkylgruppen jeweils auch deuteriert sein können, oder eine optional deuterierte Phenylgruppe, die durch ein oder mehrere optional deuterierte Alkylgruppen mit 1 bis 4 C-Atomen substituiert sein kann; dabei können zwei benachbarte Reste R² miteinander ein Ringsystem bilden;
m ist 1 oder 2;
n ist bei jedem Auftreten gleich oder verschieden 0, 1 oder 2;
o ist 1; oder o ist 0 oder 1, wenn n am gleichen Liganden = 1 ist und R² für eine Phenylgruppe steht;
p ist 0 oder 1;
q ist 0 oder 1;
r ist 0 oder 1.

7. Verbindung nach einem oder mehreren der Ansprüche 1 bis 6, **dadurch gekennzeichnet, dass** der Ligand L eine Struktur der Formel (8) aufweist, 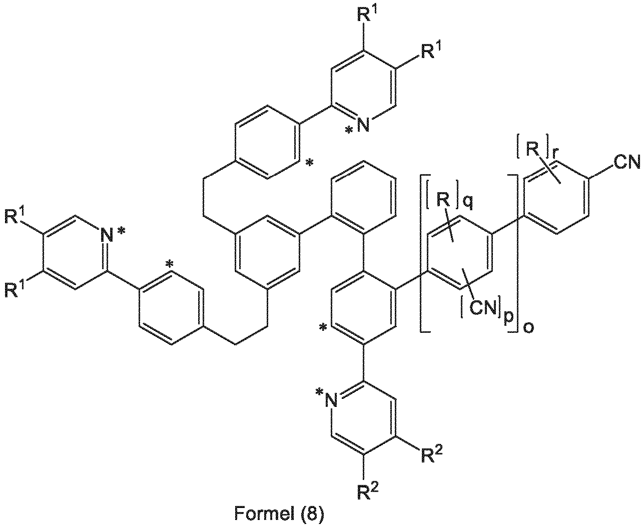 wobei die nicht explizit eingezeichneten H-Atome auch durch D ersetzt sein können, R, R¹, R² und o die in Anspruch 1 genannten Bedeutungen aufweisen, p = 0 oder 1 ist, q = 0 oder 1 ist und r = 0 oder 1 ist.

8. Verbindung nach einem oder mehreren der Ansprüche 1 bis 7, **dadurch gekennzeichnet, dass** der Ligand L eine Struktur der Formel (9) aufweist, 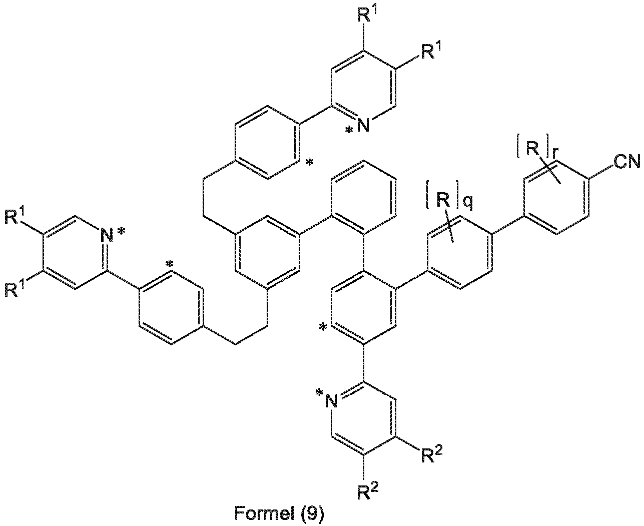 wobei die nicht explizit eingezeichneten H-Atome auch durch D ersetzt sein können, R, R¹ und R² die in Anspruch 1 genannten Bedeutungen aufweisen, q = 0 oder 1 ist und r = 0 oder 1 ist.

9. Verfahren zur Herstellung einer Verbindung nach einem oder mehreren der Ansprüche 1 bis 8 durch Umsetzung des freien Liganden L mit Iridiumalkoholaten der Formel (Ir-1), mit Iridiumketoketonaten der Formel (Ir-2), mit Iridiumhalogeniden der Formel (Ir-3) oder mit Iridiumcarboxylaten der Formel (Ir-4) oder mit Iridiumverbindungen, die sowohl Alkoholat- und/oder Halogenid- und/oder Hydroxywie auch Ketoketonatreste tragen,
Ir(OR)₃ (Ir-1) 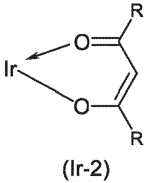
IrHaI₃ (Ir-3)
Ir(OOCR)₃ (Ir-4)
wobei R die in Anspruch 1 angegebenen Bedeutungen hat, Hal = F, Cl, Br oder I ist und die Iridiumedukte auch als die entsprechenden Hydrate vorliegen können.

10. Formulierung, enthaltend mindestens eine Verbindung nach einem oder mehreren der Ansprüche 1 bis 8 und mindestens ein Lösemittel.

11. Verwendung einer Verbindung nach einem oder mehreren der Ansprüche 1 bis 8 in einer elektronischen Vorrichtung.

12. Elektronische Vorrichtung enthaltend mindestens eine Verbindung nach einem oder mehreren der Ansprüche 1 bis 8.

13. Elektronische Vorrichtung nach Anspruch 12, wobei es sich um eine organische Elektrolumineszenzvorrichtung handelt, **dadurch gekennzeichnet, dass** die Verbindung nach einem oder mehreren der Ansprüche 1 bis 8 als emittierende Verbindung in einer oder mehreren emittierenden Schichten eingesetzt wird.

## Claims

1. A compound of the formula (1)
Ir(L) Formula (1)
wherein the ligand L has a structure of the following formula (2): 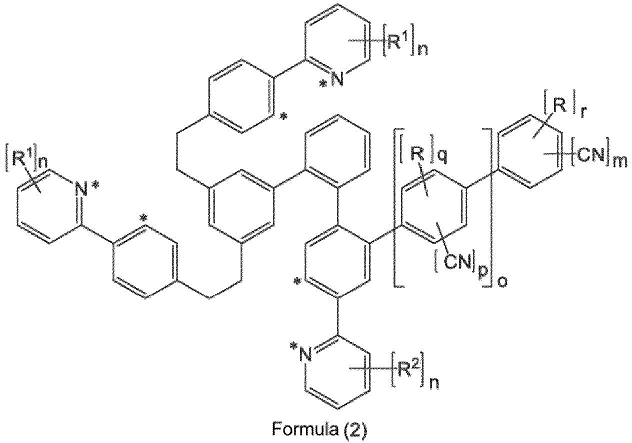
wherein the ligand L coordinates to the iridium atom via the positions identified by * and wherein the hydrogen atoms not explicitly shown may optionally be replaced by D, and wherein the symbols and indices used are as follows:
R is the same or different at each occurrence, and is H, D, F, a linear alkyl group having 1 to 10 carbon atoms or a branched or cyclic alkyl group having 3 to 10 carbon atoms, wherein the alkyl group in each case may optionally be deuterated; and wherein, optionally, two adjacent R radicals together can form a ring system;
R¹ is the same or different at each occurrence, and is H, D, a linear alkyl group having 1 to 10 carbon atoms or a branched or cyclic alkyl group having 3 to 10 carbon atoms, wherein the alkyl group
R² in each case may optionally be deuterated; and wherein, optionally, two adjacent R¹ radicals together can form a ring system; is the same or different at each occurrence, and is H, D, a linear alkyl group having 1 to 10 carbon atoms, a branched or cyclic alkyl group having 3 to 10 carbon atoms, wherein the alkyl group in each case may optionally be deuterated; or a phenyl or biphenyl group, each of which may be substituted by one or more alkyl groups having 1 to 10 carbon atoms, wherein the phenyl or biphenyl group, or the alkyl groups, may each optionally be deuterated; and wherein, optionally, two adjacent R² radicals together can form a ring system;
m is 1, 2 or 3;
n is the same or different at each occurrence, and is 0, 1, 2 or 3;
o is 0 or 1 ;
p is 0, 1 or 2;
q is 0, 1 or 2; and
r is 0, 1 or 2.

2. The compound of claim 1, **characterized in that** when m = 1, the ligand L is a structure of the formula (3a), when m = 2 the ligand L is a structure of the formula (3b) or (3c), and when m = 3 the ligand L is a structure of the formula (3d) or (3e): 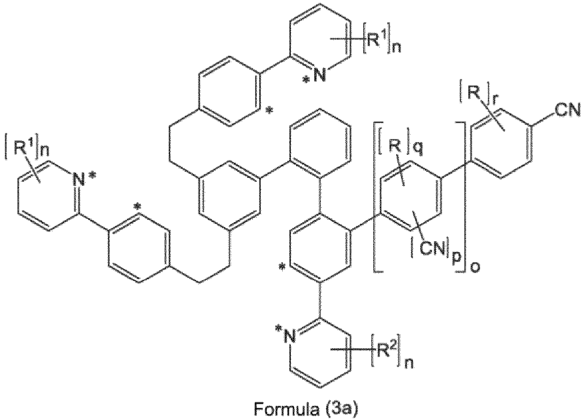 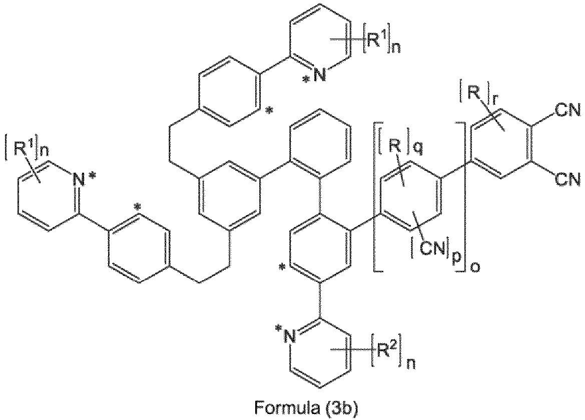 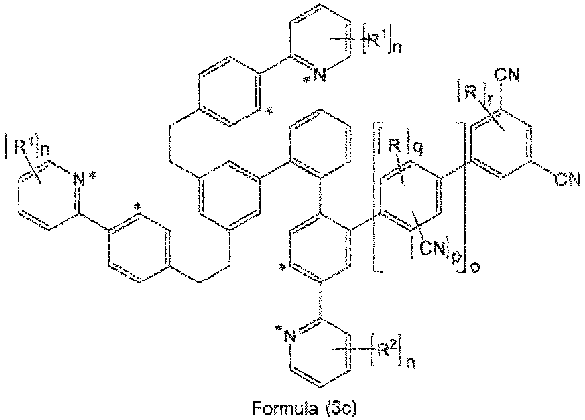 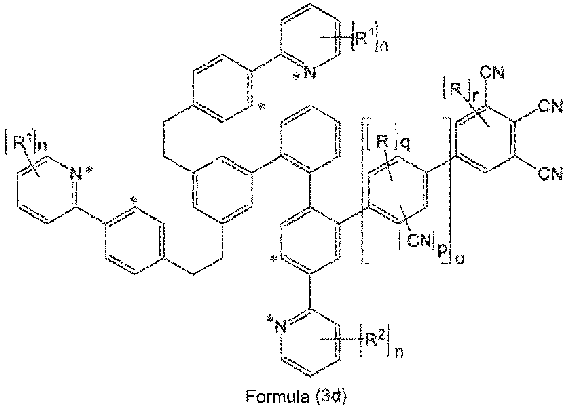 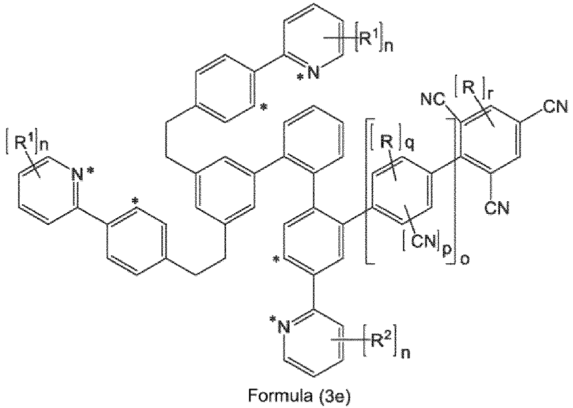 wherein the hydrogen atoms not explicitly shown may optionally be replaced by D, and the symbols and indices have the definitions given in claim 1.

3. The compound of claim 1 or 2, **characterized in that** when o = 1 and p = 1, the ligand L has a structure of the formula (4a); and **in that** when o = 1 and p = 1, the ligand L has a structure of the formula (4b): 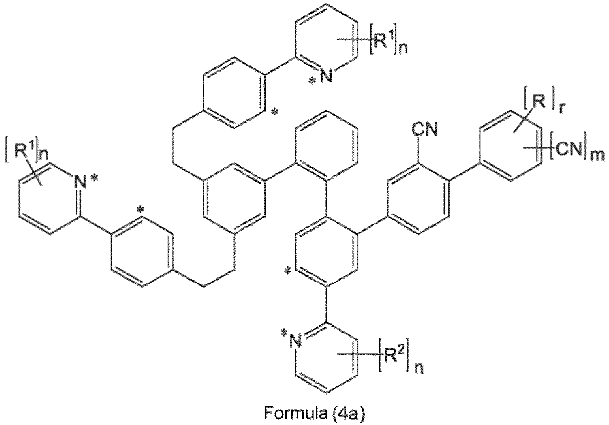 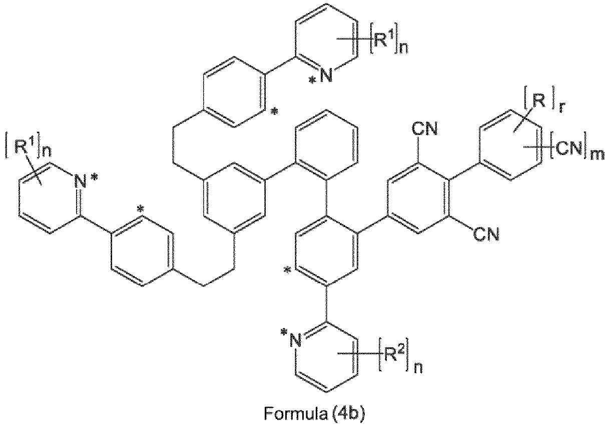 wherein the hydrogen atoms not explicitly shown may optionally be replaced by D, and the symbols and indices have the definitions given in claim 1.

4. The compound of any one or more of claims 1 to 3, **characterized in that** the ligand L has a structure of the formula (7): 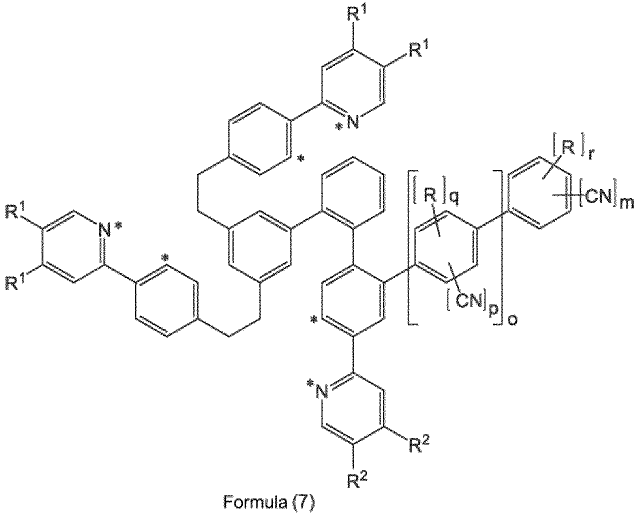 wherein the hydrogen atoms not explicitly shown may optionally be replaced by D, and the symbols and indices have the definitions given in claim 1.

5. The compound of any one or more of claims 1 to 4, **characterized in that** the substituents are as follows:
R is the same or different at each occurrence, and is selected from the group consisting of D, a linear alkyl group having 1 to 6 carbon atoms or a branched or cyclic alkyl group having 3 to 6 carbon atoms, wherein the alkyl groups may each optionally be deuterated;
R¹ is the same or different at each occurrence, and is selected from the group consisting of D, a linear alkyl group having 1 to 6 carbon atoms or a branched or cyclic alkyl group having 3 to 6 carbon atoms, wherein the alkyl groups may each optionally be deuterated; and wherein, optionally, two adjacent R¹ radicals together can form a ring system;
R² is the same or different at each occurrence, and is selected from the group consisting of D, a linear alkyl group having 1 to 6 carbon atoms or a branched or cyclic alkyl group having 3 to 6 carbon atoms, wherein the alkyl groups may each optionally be deuterated; or an optionally deuterated phenyl group which may be substituted by one or more optionally deuterated alkyl groups having 1 to 4 carbon atoms; and wherein, optionally, two adjacent R² radicals together can form a ring system.

6. The compound of any one or more of claims 1 to 5, **characterized in that** the symbols and indices are as follows:
R is the same or different at each occurrence, and is selected from the group consisting of D, a linear alkyl group having 1 to 4 carbon atoms or a branched alkyl group having 3 or 4 carbon atoms, wherein the alkyl groups may each optionally be deuterated;
R¹ is the same or different at each occurrence, and is selected from the group consisting of D, a linear alkyl group having 1 to 4 carbon atoms or a branched alkyl group having 3 or 4 carbon atoms, wherein the alkyl groups may each optionally be deuterated; and wherein, optionally, two adjacent R¹ radicals together can form a ring system;
R² is the same or different at each occurrence, and is selected from the group consisting of D, a linear alkyl group having 1 to 4 carbon atoms or a branched alkyl group having 3 or 4 carbon atoms, wherein the alkyl groups may each optionally be deuterated; or an optionally deuterated phenyl group which may be substituted by one or more optionally deuterated alkyl groups having 1 to 4 carbon atoms; and wherein, optionally, two adjacent R² radicals together can form a ring system;
m is 1 or 2;
n is the same or different at each occurrence, and is 0, 1 or 2;
o is 1; or o is 0 or 1 when n = 1 on the same ligand and R² is a phenyl group;
p is 0 or 1 ;
q is 0 or 1 ;
r is 0 or 1 .

7. The compound of any one or more of claims 1 to 6, **characterized in that** the ligand L has a structure of the formula (8): 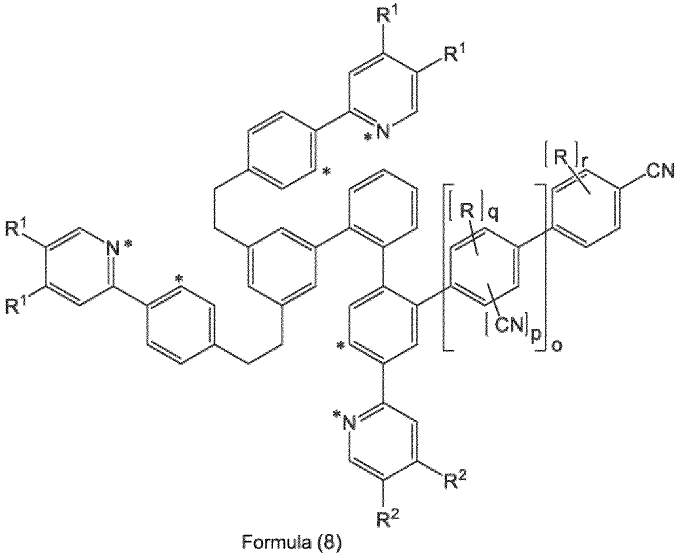 wherein the hydrogen atoms not explicitly shown may optionally be replaced by D, R, R¹, R² and o have the definitions given in claim 1, p = 0 or 1, q = 0 or 1 and r = 0 or 1.

8. The compound of any one or more of claims 1 to 7, **characterized in that** the ligand L has a structure of the formula (9): 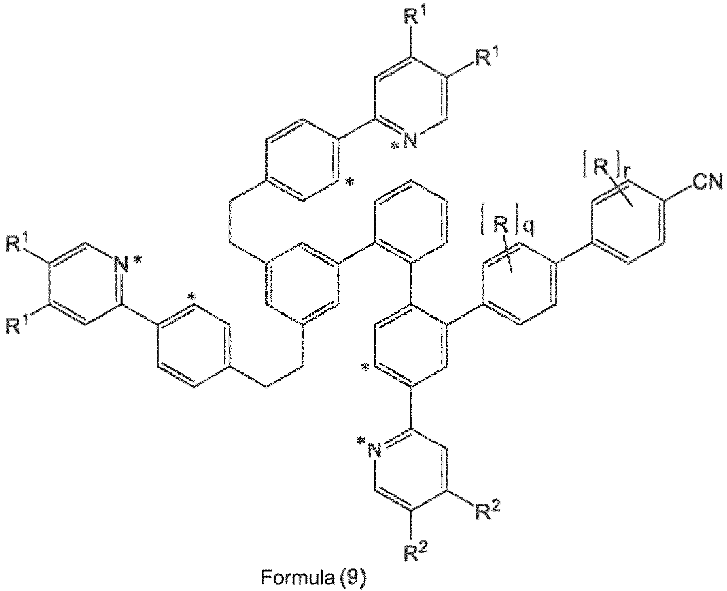 wherein the hydrogen atoms not explicitly shown may optionally be replaced by D, R, R¹ and R² have the definitions given in claim 1, q = 0 or 1 and r = 0 or 1.

9. A process for preparing a compound as claimed in any one or more of claims 1 to 8 by reaction of the free ligand L with iridium alkoxides of the formula (Ir-1), with iridium ketoketonates of the formula (Ir-2), with iridium halides of the formula (Ir-3), or with iridium carboxylates of the formula (Ir-4), or with iridium compounds that bear both alkoxide and/or halide and/or hydroxy and/or ketoketonate radicals,
Ir(OR)₃ (Ir-1) 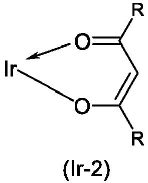
IrHaI₃ (Ir-3)
Ir(OOCR)₃ (Ir-4)
wherein R has the definitions given in claim 1, Hal = F, Cl, Br or I, and the iridium reactants may optionally take the form of the corresponding hydrates.

10. A formulation comprising at least one compound of any one or more of claims 1 to 8 and at least one solvent.

11. A use of a compound of any one or more of claims 1 to 8 in an electronic device.

12. An electronic device comprising at least one compound of any one or more of claims 1 to 8.

13. The electronic device of claim 12 which is an organic electroluminescent device, **characterized in that** the compound of any one or more of claims 1 to 8 is used as an emitting compound in one or more emitting layers.

## Revendications

1. Composé de formule (1)
Ir(L) Formule (1)
dans lequel le ligand L a une structure de formule suivante (2) : 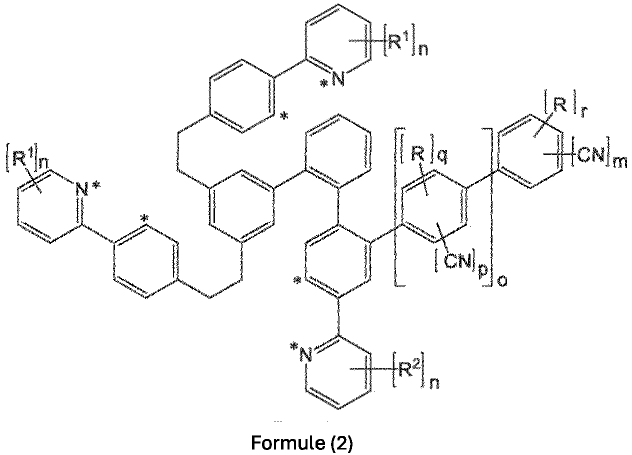
dans lequel le ligand L se coordonne à l'atome d'iridium via les positions identifiées par * et dans lequel les atomes d'hydrogène non explicitement représentés peuvent également être remplacés par D, et dans lequel les symboles et les indices utilisés sont les suivants :
R est identique ou différent à chaque occurrence H, D, F, et est un groupe alkyle linéaire ayant de 1 à 10 atomes de carbone ou un groupe alkyle ramifié ou cyclique ayant de 3 à 10 atomes de carbone, où le groupe alkyle dans chaque cas peut également être deutéré ; et où deux radicaux R adjacents peuvent former ensemble un système cyclique ;
R¹ est identique ou différent à chaque occurrence H, D, et est un groupe alkyle linéaire ayant de 1 à 10 atomes de carbone ou un groupe alkyle ramifié ou cyclique
R² ayant de 3 à 10 atomes de carbone, le groupe alkyle pouvant dans chaque cas être également deutéré ; et dans lequel deux radicaux R¹ adjacents peuvent former ensemble un système cyclique ; est identique ou différent à chaque occurrence H, D, et est un groupe alkyle linéaire ayant de 1 à 10 atomes de carbone, un groupe alkyle ramifié ou cyclique ayant de 3 à 10 atomes de carbone, le groupe alkyle pouvant dans chaque cas être également deutéré ; ou un groupe phényle ou biphényle, chacun pouvant être substitué par un ou plusieurs groupes alkyle ayant de 1 à 10 atomes de carbone, le groupe phényle ou biphényle, ou les groupes alkyle, pouvant chacun être également deutéré ; et dans lequel deux radicaux R² adjacents peuvent former ensemble un système cyclique ;
m est 1, 2 ou 3 ;
n est identique ou différent à chaque occurrence, et vaut 0, 1, 2 ou 3 ;
o est 0 ou 1 ;
p est 0, 1 ou 2 ;
q est 0, 1 ou 2 ; et
r est 0, 1 ou 2.

2. Composé selon la revendication 1, **caractérisé en ce que** lorsque m = 1, le ligand L est une structure de formule (3a), lorsque m = 2, le ligand L est une structure de formule (3b) ou (3c), et lorsque m = 3, le ligand L est une structure de formule (3d) ou (3e) : 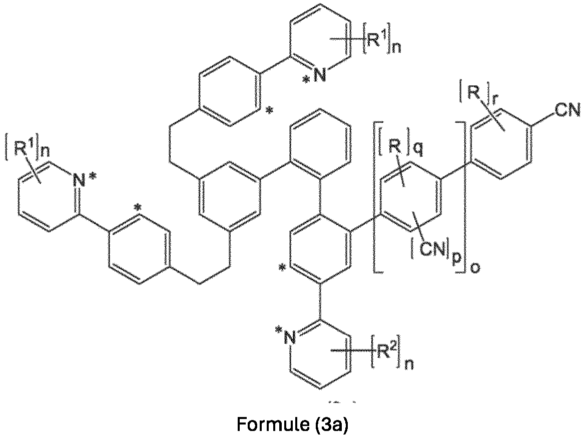 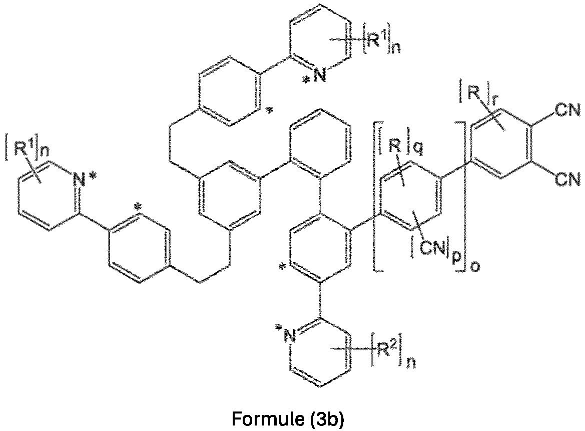 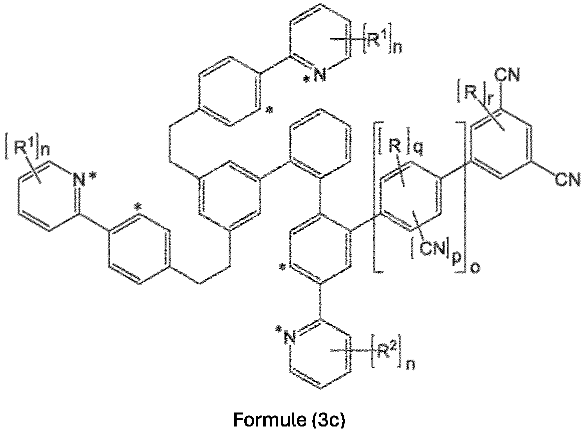 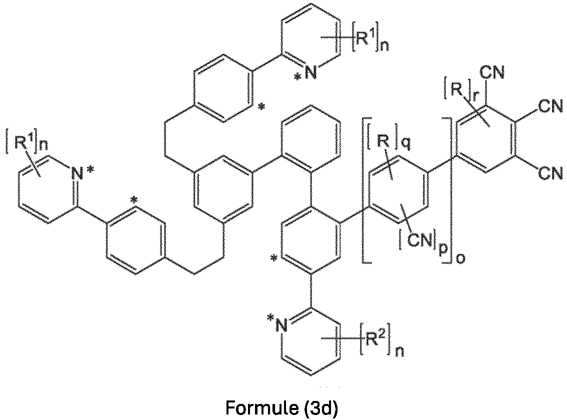 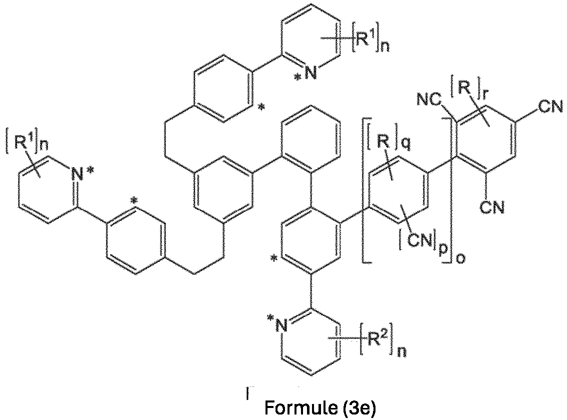 dans lequel les atomes d'hydrogène non explicitement représentés peuvent également être remplacés par D, et les symboles et indices ont les définitions données dans la revendication 1.

3. Composé selon la revendication 1 ou 2, **caractérisé en ce que** lorsque o = 1 et p = 1, le ligand L a une structure de formule (4a) ; et lorsque o = 1 et p = 1, le ligand L a une structure de formule (4b) : 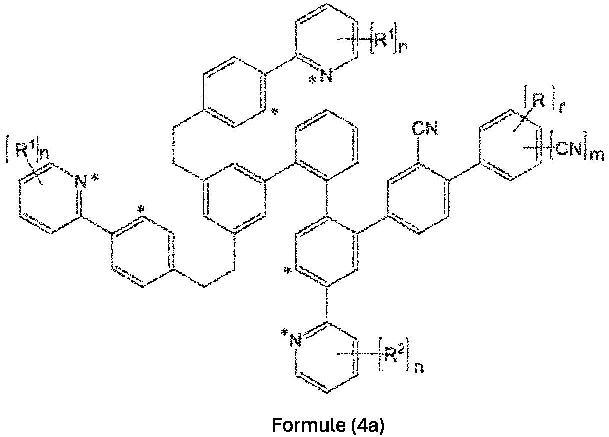 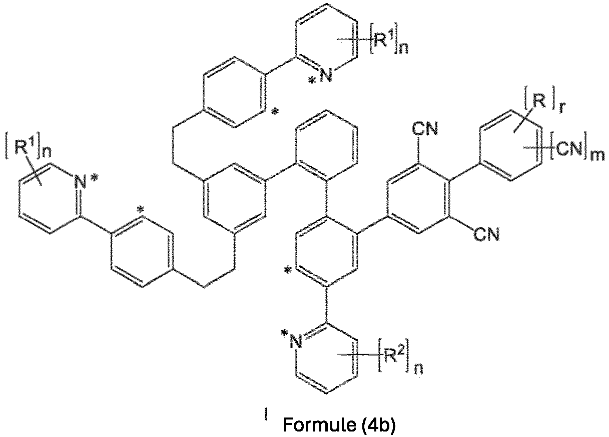 dans laquelle les atomes d'hydrogène non explicitement représentés peuvent également être remplacés par D, et les symboles et indices ont les définitions données dans la revendication 1.

4. Composé selon l'une ou plusieurs des revendications 1 à 3, **caractérisé en ce que** le ligand L a une structure de la formule (7) : 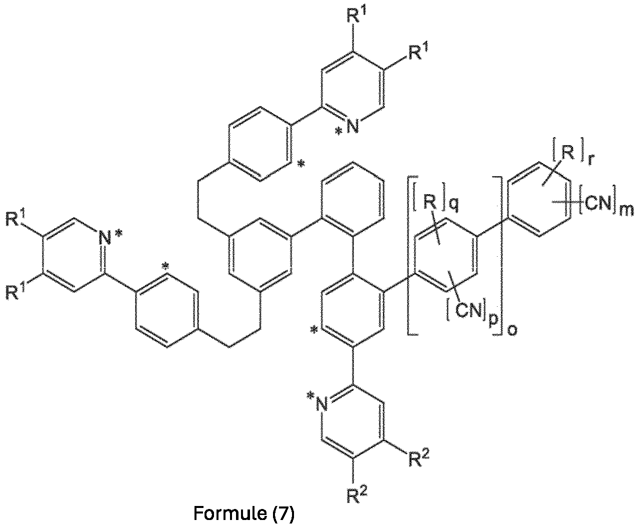 dans laquelle les atomes d'hydrogène non explicitement représentés peuvent également être remplacés par D, et les symboles et indices ont les définitions données dans la revendication 1.

5. Composé selon l'une ou de plusieurs des revendications 1 à 4, **caractérisé en ce que** les substituants sont :
R est identique ou différent à chaque occurrence et est choisi dans le groupe constitué par D, un groupe alkyle linéaire ayant de 1 à 6 atomes de carbone ou un groupe alkyle ramifié ou cyclique ayant de 3 à 6 atomes de carbone, les groupes alkyles pouvant être éventuellement deutérés ;
R¹ est identique ou différent à chaque occurrence et est choisi dans le groupe constitué par D, un groupe alkyle linéaire ayant 1 à 6 atomes de carbone ou un groupe alkyle ramifié ou cyclique ayant 3 à 6 atomes de carbone, les groupes alkyle pouvant être chacun également deutérés ; et dans lequel deux radicaux R¹ adjacents peuvent former ensemble un système cyclique ;
R² est identique ou différent à chaque occurrence et est choisi dans le groupe constitué par D, un groupe alkyle linéaire ayant de 1 à 6 atomes de carbone ou un groupe alkyle ramifié ou cyclique ayant de 3 à 6 atomes de carbone, dans lequel les groupes alkyle peuvent chacun être également deutérés ; ou un groupe phényle éventuellement deutéré qui peut être substitué par un ou plusieurs groupes alkyle éventuellement deutérés ayant de 1 à 4 atomes de carbone ; et dans lequel deux radicaux R² adjacents peuvent former ensemble un système cyclique.

6. Composé selon l'une ou plusieurs des revendications 1 à 5, **caractérisé en ce que** les symboles et les indices ont la signification :
R est identique ou différent à chaque occurrence et est choisi dans le groupe constitué par D, un groupe alkyle linéaire ayant 1 à 4 atomes de carbone ou un groupe alkyle ramifié ayant 3 ou 4 atomes de carbone, les groupes alkyle pouvant être chacun également deutérés ;
R¹ est identique ou différent à chaque occurrence et est choisi dans le groupe constitué par D, un groupe alkyle linéaire ayant 1 à 4 atomes de carbone ou un groupe alkyle ramifié ayant 3 ou 4 atomes de carbone, les groupes alkyle pouvant être chacun également deutérés ; et dans lequel deux radicaux R¹ adjacents peuvent former ensemble un système cyclique ;
R² est identique ou différent à chaque occurrence et est choisi dans le groupe constitué par D, un groupe alkyle linéaire ayant 1 à 4 atomes de carbone ou un groupe alkyle ramifié ayant 3 ou 4 atomes de carbone, dans lequel les groupes alkyles peuvent chacun être également deutérés ; ou un groupe phényle éventuellement deutéré qui peut être substitué par un ou plusieurs groupes alkyles éventuellement deutérés ayant 1 à 4 atomes de carbone ; et dans lequel deux radicaux R² adjacents peuvent former ensemble un système cyclique ;
m est 1 ou 2 ;
n est identique ou différent à chaque occurrence, et vaut 0, 1 ou 2 ;
o est égal à 1 ; ou o est égal à 0 ou 1 lorsque n = 1 sur le même ligand et que R² est un groupe phényle ;
p est 0 ou 1 ;
q est 0 ou 1 ;
r est 0 ou 1.

7. Composé selon l'une ou plusieurs des revendications 1 à 6, **caractérisé en ce que** le ligand L a une structure de formule (8) : 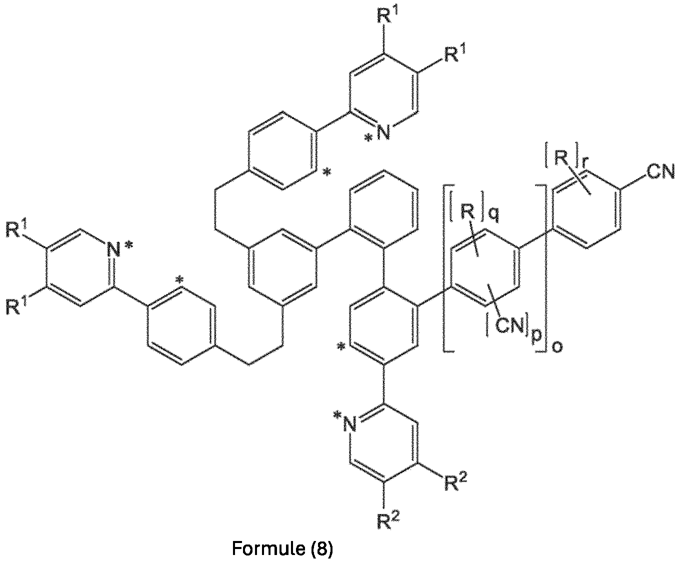 dans laquelle les atomes d'hydrogène non explicitement indiqués peuvent également être remplacés par D, R, R¹, R² et o ont les définitions données dans la revendication 1, p = 0 ou 1, q = 0 ou 1 et r = 0 ou 1.

8. Composé selon l'une ou plusieurs des revendications 1 à 7, **caractérisé en ce que** le ligand L a une structure de formule (9) : 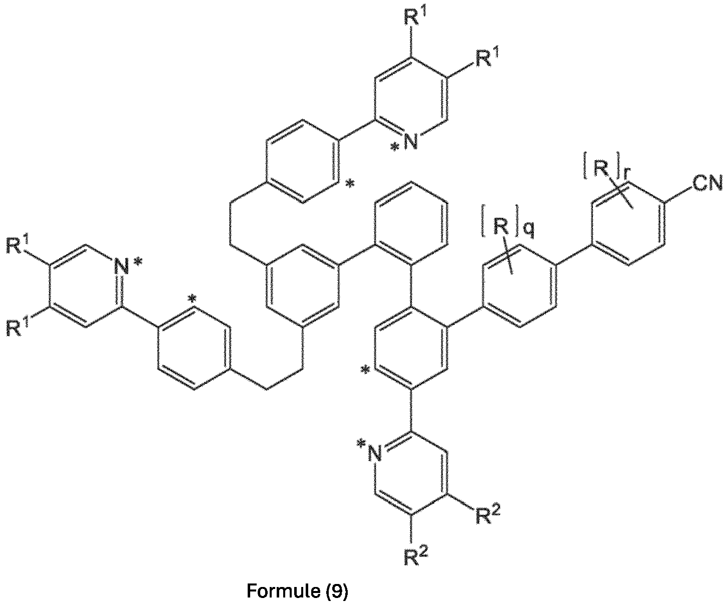 dans laquelle les atomes d'hydrogène non explicitement indiqués peuvent également être remplacés par D, R, R¹ et R² ont les définitions données dans la revendication 1, q = 0 ou 1 et r = 0 ou 1.

9. Procédé de préparation d'un composé selon l'une ou plusieurs des revendications 1 à 8 par réaction du ligand libre L avec des alkoxydes d'iridium de formule (Ir-1), avec des kétokétonates d'iridium de formule (Ir-2), avec des halogénures d'iridium de formule (Ir-3), ou avec des carboxylates d'iridium de formule (Ir-4), ou avec des composés d'iridium qui portent à la fois des radicaux alcoxydes et/ou halogénures et/ou hydroxy et/ou kétokétonates,
Ir(OR)₃ (Ir-1) 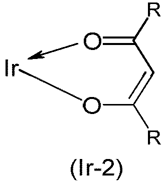
IrHaI₃ (Ir-3)
Ir(OOCR)₃ (Ir-4)
où R a les définitions données dans la revendication 1, Hal = F, CI, Br ou I, et les réactifs d'iridium peuvent prendre la forme des hydrates correspondants.

10. Formulation comprenant au moins un composé selon l'une ou de plusieurs des revendications 1 à 8 et au moins un solvant.

11. Utilisation d'un composé selon l'une ou de plusieurs des revendications 1 à 8 dans un appareil électronique.

12. Dispositif électronique comprenant au moins un composé selon l'une ou plusieurs des revendications 1 à 8.

13. Dispositif électronique selon la revendication 12 qui est un dispositif électroluminescent organique, **caractérisé en ce que** le composé selon l'une ou plusieurs des revendications 1 à 8 est utilisé comme composé émetteur dans une ou plusieurs couches émettrices.
